# EUROPEAN PATENT APPLICATION

(11) **EP 4 770 358 A1**
(43) Date of publication of application: **01.07.2026**
(21) Application number: 25200734.9
(22) Date of filing: 08.09.2025
(51) Int. Cl.: H10H 29/30, H10H 29/855

(54) **LIGHT SOURCE AND DISPLAY DEVICE INCLUDING THE SAME**

(30) Priority: 27.12.2024 KR 20240199328
(71) Applicant: Samsung Electronics Co., Ltd., Suwon-si, Gyeonggi-do 16677 (KR)
(72) Inventor: LEE, Wonho, 16677 Suwon-si (KR); KIM, Juhyun, 16677 Suwon-si (KR); KIM, Donggyu, 16677 Suwon-si (KR); SHON, Byungjoo, 16677 Suwon-si (KR)
(74) Representative: Marks & Clerk LLP

(57) **Abstract**

A light source may include: a first conductivity type base semiconductor layer in the pixel region; and a plurality of lenses respectively on the plurality of pixels. The plurality of lenses may include a first lens facing the first pixel and a second lens facing the second pixel. The first conductivity type base semiconductor layer may include a first optical path guide surface corresponding to the first pixel and facing the first lens. The first conductivity type base semiconductor layer may include a second optical path guide surface corresponding to the second pixel and facing the second lens. The first optical path guide surface and the second optical path guide surface may include non-flat surfaces having different shapes.

## Description

### BACKGROUND

The present disclosure relates to a light device and a display device including the same, and more particularly, to a light source including a plurality of micro light-emitting diodes (LEDs) and a display device including the light source.

Light-emitting diodes (LEDs) convert electrical energy into optical energy and are widely used as light sources for various display devices, such as lighting systems, televisions, mobile phones, personal computers, laptop computers, personal digital assistants (PDAs), digital cameras, camcorders, viewfinders, micro displays, three-dimensional (3D) displays, and virtual reality or augmented reality displays. Recently, micro- or nano-scale subminiature LEDs using group II-VI or group III-V compound semiconductors have been developed, and accordingly, there has been a growing demand for a light-emitting device having a novel structure to improve light extraction efficiency in such subminiature LEDs.

### SUMMARY

The disclosure provides a light source having a structure that may improve light extraction efficiency.

The disclosure also provides a display device including a light source having a structure that may improve light extraction efficiency.

According to an aspect of the disclosure, a light source includes: a pixel region including a plurality of pixels; and a plurality of lenses respectively on the plurality of pixels, wherein each pixel of the plurality of pixels includes: a first conductivity type base semiconductor layer; and a semiconductor light-emitting structure, the semiconductor light-emitting structure including a first conductivity type semiconductor layer, an active layer, and a second conductivity type semiconductor layer sequentially stacked on the first conductivity type base semiconductor layer in a first direction, wherein each lens of the plurality of lenses is apart from the semiconductor light-emitting structure of a corresponding one of the plurality of pixels in the first direction, with the first conductivity type base semiconductor layer of the corresponding pixel therebetween, wherein the plurality of pixels includes a first pixel and a second pixel, and the plurality of lenses includes a first lens facing the first pixel and a second lens facing the second pixel, wherein the first conductivity type base semiconductor layer of the first pixel includes a first optical path guide surface facing the first lens, wherein the first conductivity type base semiconductor layer of the second pixel includes a second optical path guide surface facing the second lens, and wherein the first optical path guide surface and the second optical path guide surface include non-flat surfaces having different shapes.

According to an aspect of the disclosure, a light source includes: a plurality of pixels, each pixel of the plurality of pixels including: a first conductivity type base semiconductor layer; and a semiconductor light-emitting structure including a first conductivity type semiconductor layer, an active layer, and a second conductivity type semiconductor layer, which are sequentially stacked on a main surface of the first conductivity type base semiconductor layer in a first direction that is perpendicular to the main surface of the first conductivity type base semiconductor layer; a plurality of transparent electrode layers, each transparent electrode layer of the plurality of transparent electrode layers being on the second conductivity type semiconductor layer of a corresponding one of the plurality of pixels, and apart from the active layer in the first direction with the second conductivity type semiconductor layer therebetween; a reflective structure on a sidewall of the semiconductor light-emitting structure in each of the plurality of pixels; a plurality of reflective electrode layers in contact with the plurality of transparent electrode layers, each reflective electrode layer of the plurality of reflective electrode layers being apart from the second conductivity type semiconductor layer of a corresponding one of the plurality of pixels in the first direction with the transparent electrode layer therebetween; and a plurality of lenses, each lens of the plurality of lenses facing a rear surface of the first conductivity type base semiconductor layer of a corresponding one of the plurality of pixels, and being configured to emit light emitted by the semiconductor light-emitting structure of a corresponding one of the plurality of pixels, wherein the rear surface is an opposite surface of the main surface of the first conductivity type base semiconductor layer, wherein the plurality of pixels includes a first pixel and a second pixel, and the plurality of lenses includes a first lens facing the first pixel and a second lens facing the second pixel, wherein the first conductivity type base semiconductor layer of the first pixel includes a first optical path guide surface facing the first lens, wherein the first conductivity type base semiconductor layer of the second pixel includes a second optical path guide surface facing the second lens, and wherein the first optical path guide surface and the second optical path guide surface include non-flat surfaces having different shapes.

According to an aspect of the disclosure, a display device includes: a circuit board including a driver circuit; a pixel array on the circuit board, the pixel array including a plurality of pixels; and a plurality of lenses respectively on the plurality of pixels, wherein each of the plurality of pixels includes: a first conductivity type base semiconductor layer; and a semiconductor light-emitting structure including a first conductivity type semiconductor layer, an active layer, and a second conductivity type semiconductor layer, which are sequentially stacked on the first conductivity type base semiconductor layer in a first direction, wherein the semiconductor light-emitting structure is apart from a selected one of the plurality of lenses in the first direction, with the first conductivity type base semiconductor layer therebetween, wherein the plurality of pixels includes a first pixel and a second pixel, and the plurality of lenses includes a first lens facing the first pixel and a second lens facing the second pixel, wherein the first conductivity type base semiconductor layer of the first pixel includes a first optical path guide surface facing the first lens, wherein the first conductivity type base semiconductor layer of the second pixel includes a second optical path guide surface facing the second lens, and wherein the first optical path guide surface and the second optical path guide surface include non-flat surfaces having different shapes.

A method of manufacturing a light source, may include: providing a first conductivity type base semiconductor layer including a plurality of pixels, wherein each of the plurality of pixels may include a semiconductor light-emitting structure including a first conductivity type semiconductor layer, an active layer, and a second conductivity type semiconductor layer sequentially stacked on the first conductivity type base semiconductor layer in a first direction; forming a first optical path guide surface on the first conductivity type base semiconductor layer facing a first pixel of the plurality of pixels, and a second optical path guide surface on the first conductivity type base semiconductor layer facing a second pixel of the plurality of pixels; and forming a plurality of lenses respectively on the plurality of pixels, such that each of the plurality of lenses is apart from the semiconductor light-emitting structure of a corresponding one of the plurality of pixels in the first direction, the plurality of lenses including a first lens facing the first pixel and a second lens facing the second pixel.

The forming the first optical path guide surface and the second optical path guide surface may include etching a surface of the first conductivity type base semiconductor layer.

The forming the plurality of lenses may include depositing transparent resin on the first optical guide path surface and the second optical guide path surface.

The method may further include bonding a circuit board to the first conductivity type base semiconductor layer.

At least some of the above and other features of the invention are set out in the claims.

### BRIEF DESCRIPTION OF THE DRAWINGS

The above and other aspects and features of the present disclosure will become more apparent by describing in detail exemplary embodiments thereof with reference to the attached drawings, in which:
FIG. 1 is a plan view of a light source according to one or more embodiments;
FIG. 2A is a cross-sectional view of light sources according to one or more embodiments;
FIG. 2B is a cross-sectional view of light sources according to one or more embodiments;
FIG. 2C is a cross-sectional view of light sources according to one or more embodiments;
FIG. 2D is a cross-sectional view of light sources according to one or more embodiments;
FIG. 2E is a cross-sectional view of light sources according to one or more embodiments;
FIG. 2F is a cross-sectional view of light sources according to one or more embodiments;
FIG. 2G is a cross-sectional view of light sources according to one or more embodiments;
FIG. 2H is a cross-sectional view of light sources according to one or more embodiments;
FIG. 2I is a cross-sectional view of light sources according to one or more embodiments;
FIG. 2J is a cross-sectional view of light sources according to one or more embodiments;
FIG. 2K is a cross-sectional view of light sources according to one or more embodiments;
FIG. 2L is a cross-sectional view of light sources according to one or more embodiments;
FIG. 2M is a cross-sectional view of light sources according to one or more embodiments;
FIG. 3 is a plan view of a light source according to one or more embodiments;
FIG. 4A is a plan view of a light source according to one or more embodiments;
FIG. 4B is a cross-sectional view of a partial region included in the light source illustrated in FIG. 4A according to one or more embodiments;
FIG. 5A is a plan view of a light source according to one or more embodiments;
FIG. 5B is a cross-sectional view of a partial region included in the light source illustrated in FIG. 5A according to one or more embodiments;
FIG. 6A is a schematic perspective view illustrating examples of shapes of a semiconductor light-emitting structure and a transparent electrode layer of a light source, according to one or more embodiments;
FIG. 6B is a schematic plan view of the semiconductor light-emitting structure illustrated in FIG. 6A according to one or more embodiments;
FIG. 7A is a schematic perspective view illustrating examples of shapes of a semiconductor light-emitting structure and a transparent electrode layer of a light source, according to one or more embodiments;
FIG. 7B is a schematic plan view of the semiconductor light-emitting structure illustrated in FIG. 7A according to one or more embodiments;
FIG. 7C is a plan view of a light source according to one or more embodiments;
FIG. 7D is a plan view of a light source according to one or more embodiments;
FIG. 8 is a partial cross-sectional view of a light source according to one or more embodiments;
FIG. 9 is a partial cross-sectional view of a light source according to one or more embodiments;
FIG. 10 is a partial cross-sectional view of a light source according to one or more embodiments;
FIG. 11 is a schematic perspective view of a display device according to embodiments;
FIG. 12 is an enlarged plan view of a portion denoted by "EX2" in FIG. 11 according to one or more embodiments;
FIG. 13 is a schematic cross-sectional view of components of a portion corresponding to a cross-section taken along line I-I' in FIG. 11 and a portion corresponding to a cross-section taken along line II-II' in FIG. 12 according to one or more embodiments;
FIG. 14 is a cross-sectional view of display devices according to one or more embodiments;
FIG. 15 is a cross-sectional view of display devices according to one or more embodiments;
FIG. 16 is a cross-sectional view of display devices according to one or more embodiments;
FIG. 17 is a cross-sectional view of display devices according to one or more embodiments;
FIG. 18 is a cross-sectional view of display devices according to one or more embodiments;
FIG. 19 is a cross-sectional view of display devices according to one or more embodiments;
FIG. 20 is a cross-sectional view of display devices according to one or more embodiments;
FIG. 21 is a cross-sectional view of display devices according to one or more embodiments;
FIG. 22 is a cross-sectional view of display devices according to one or more embodiments;
FIG. 23 is a cross-sectional view of display devices according to one or more embodiments;
FIG. 24A is a cross-sectional view illustrating a process sequence of a method of manufacturing a display device including a light source, according to one or more embodiments;
FIG. 24B is a cross-sectional view illustrating a process sequence of a method of manufacturing a display device including a light source, according to one or more embodiments;
FIG. 24C is a cross-sectional view illustrating a process sequence of a method of manufacturing a display device including a light source, according to one or more embodiments;
FIG. 24D is a cross-sectional view illustrating a process sequence of a method of manufacturing a display device including a light source, according to one or more embodiments;
FIG. 24E is a cross-sectional view illustrating a process sequence of a method of manufacturing a display device including a light source, according to one or more embodiments;
FIG. 24F is a cross-sectional view illustrating a process sequence of a method of manufacturing a display device including a light source, according to one or more embodiments;
FIG. 24G is a cross-sectional view illustrating a process sequence of a method of manufacturing a display device including a light source, according to one or more embodiments;
FIG. 24H is a cross-sectional view illustrating a process sequence of a method of manufacturing a display device including a light source, according to one or more embodiments;
FIG. 25A is a cross-sectional view specifically illustrating a process sequence of an example of a process of forming a plurality of optical path guide surfaces on a first conductivity type base semiconductor layer in a method of manufacturing a display device, according to one or more embodiments;
FIG. 25B is a cross-sectional view specifically illustrating a process sequence of an example of a process of forming a plurality of optical path guide surfaces on a first conductivity type base semiconductor layer in a method of manufacturing a display device, according to one or more embodiments;
FIG. 25C is a cross-sectional view specifically illustrating a process sequence of an example of a process of forming a plurality of optical path guide surfaces on a first conductivity type base semiconductor layer in a method of manufacturing a display device, according to one or more embodiments;
FIG. 25D is a cross-sectional view specifically illustrating a process sequence of an example of a process of forming a plurality of optical path guide surfaces on a first conductivity type base semiconductor layer in a method of manufacturing a display device, according to one or more embodiments;
FIG. 25E is a cross-sectional view specifically illustrating a process sequence of an example of a process of forming a plurality of optical path guide surfaces on a first conductivity type base semiconductor layer in a method of manufacturing a display device, according to one or more embodiments;
FIG. 25F is a cross-sectional view specifically illustrating a process sequence of an example of a process of forming a plurality of optical path guide surfaces on a first conductivity type base semiconductor layer in a method of manufacturing a display device, according to one or more embodiments;
FIG. 26A is a cross-sectional view illustrating a process sequence of a method of manufacturing a display device, according to one or more embodiments;
FIG. 26B is a cross-sectional view illustrating a process sequence of a method of manufacturing a display device, according to one or more embodiments;
FIG. 26C is a cross-sectional view illustrating a process sequence of a method of manufacturing a display device, according to one or more embodiments;
FIG. 26D is a cross-sectional view illustrating a process sequence of a method of manufacturing a display device, according to one or more embodiments;
FIG. 26E is a cross-sectional view illustrating a process sequence of a method of manufacturing a display device, according to one or more embodiments;
FIG. 26F is a cross-sectional view illustrating a process sequence of a method of manufacturing a display device, according to one or more embodiments;
FIG. 27A is a cross-sectional view illustrating a process sequence of a method of manufacturing a display device, according to one or more embodiments;
FIG. 27B is a cross-sectional view illustrating a process sequence of a method of manufacturing a display device, according to one or more embodiments;
FIG. 27C is a cross-sectional view illustrating a process sequence of a method of manufacturing a display device, according to one or more embodiments;
FIG. 28 is a block diagram illustrating an example of an electronic device including a light source or a display device, according to embodiments;
FIG. 29 is a diagram illustrating an example of an electronic device including a light source or a display device, according to one or more embodiments;
FIG. 30 is a diagram illustrating an example of an electronic device including a light source or a display device, according to one or more embodiments;
FIG. 31 is a diagram illustrating an example of an electronic device including a light source or a display device, according to one or more embodiments;
FIG. 32 is a diagram illustrating an example of an electronic device including a light source or a display device, according to one or more embodiments; and
FIG. 33 is a diagram illustrating an example of an electronic device including a light source or a display device, according to one or more embodiments.

### DETAILED DESCRIPTION

Hereinafter, embodiments will be described in detail with reference to the accompanying drawings. Like reference numerals refer to like elements throughout the present specification, and thus, any redundant description will be omitted.

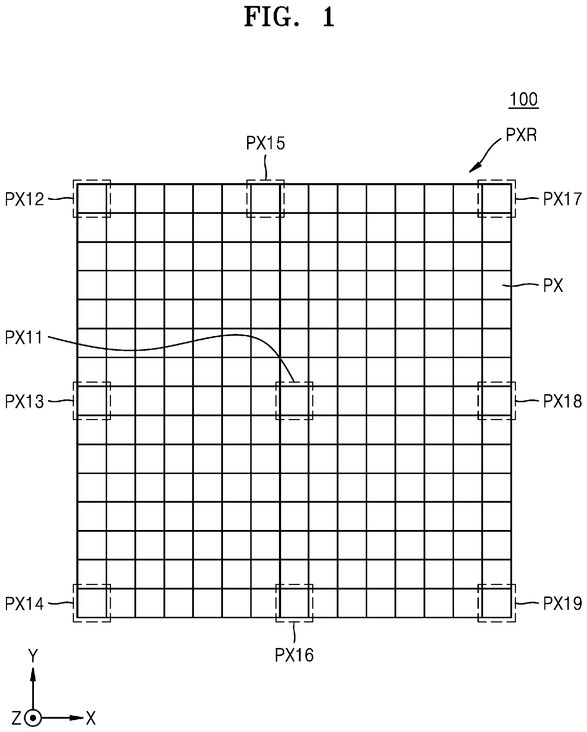

FIG. 1 is a plan view of a light source 100 according to one or more embodiments. The light source 100 may be or form part of a display device.

Referring to FIG. 1, the light source 100 may include a pixel region PXR including a plurality of pixels PX. Each of the plurality of pixels PX may be configured to emit light having a specific wavelength, for example, light having a specific color. In one or more embodiments, the plurality of pixels PX may be configured to emit light having the same color. In one or more embodiments, the plurality of pixels PX may respectively be configured to emit light having the same color selected from red (R) light, green (G) light, and blue (B) light. In other one or more embodiments, some of the plurality of pixels PX may be configured to emit red (R) light, some others of the plurality of pixels PX may be configured to emit green (G) light, and still others of the plurality of pixels PX may be configured to emit blue (B) light. In still other one or more embodiments, some others of the plurality of pixels PX may be configured to emit light having a color other than red (R), green (G), and blue (B), for example, yellow light. In the pixel region PXR of FIG. 1, the plurality of pixels PX are illustrated in the form of a pixel array of a 15X15 arrangement in a first lateral direction (X direction) and a second lateral direction (Y direction), without being limited thereto. In the pixel region PXR, the plurality of pixels PX may include a proper number of pixels PX in the first lateral direction (X direction) and the second lateral direction (Y direction), for example, a plurality of pixels PX having a 1,024 X 768 arrangement.

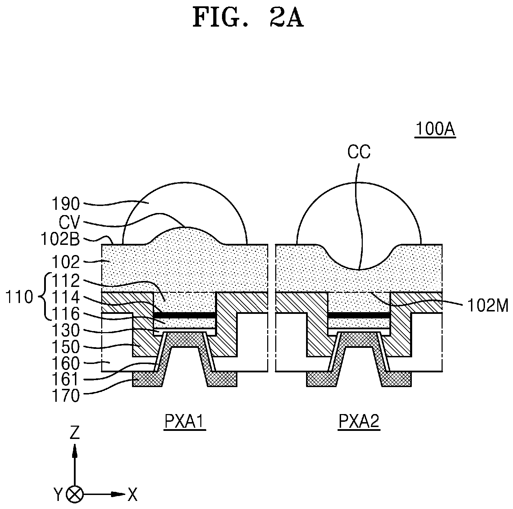

FIGS. 2A to 2M are respectively cross-sectional views of light sources 100A, 100B, 100C, 100D, 100E, 100F, 100G, 100H, 100I, 100J, 100K, 100L, and 100M according to one or more embodiments. The light sources 100A, 100B, 100C, 100D, 100E, 100F, 100G, 100H, 100I, 100J, 100K, 100L, and 100M may have the same plane structure as the light source 100 illustrated in FIG. 1. FIGS. 2A to 2M respectively illustrate examples of various cross-sectional configurations in a first lateral direction (X direction) of some pixels PX selected from the plurality of pixels PX illustrated in FIG. 1. In FIGS. 2A to 2M, the same reference numerals are used to denote the same elements, and thus any redundant description will be omitted.

Referring to FIG. 2A, in the light source 100A, the plurality of pixels PX (refer to FIG. 1) may include a first pixel PXA1 and a second pixel PXA2. The first pixel PXA1 and the second pixel PXA2 may be respectively different pixels selected from the plurality of pixels PX included in the pixel region PXR illustrated in FIG. 1. In one or more embodiments, the first pixel PXA1 and the second pixel PXA2 may be respectively different pixels selected from the pixel PX11 located in a center portion of the pixel region PXR illustrated in FIG. 1 and the pixels PX12, PX13, PX14, PX15, PX16, PX17, PX18, and PX19 located in an edge portion of the pixel region PXR illustrated in FIG. 1. In one or more embodiments, the first pixel PXA1 may be the pixel PX11 located in the center portion of the pixel region PXR, and the second pixel PXA2 may be any one pixel selected from the pixels PX12, PX13, PX14, PX15, PX16, PX17, PX18, and PX19 in the edge portion of the pixel region PXR. In another embodiment, the first pixel PXA1 and the second pixel PXA2 may be different pixels selected from the pixels PX12, PX13, PX14, PX15, PX16, PX17, PX18, and PX19 located in the edge portion of the pixel region PXR, and the first pixel PXA1 and the second pixel PXA2 may be apart (e.g., spaced apart) from each other in the first lateral direction (X direction) or a second lateral direction (Y direction).

Referring to FIG. 2A, each of the first pixel PXA1 and the second pixel PXA2 may include a first conductivity type base semiconductor layer 102 (e.g., a base semiconductor layer having a first conductivity type) and a semiconductor light-emitting structure 110 arranged on a main surface 102M of the first conductivity type base semiconductor layer 102. The semiconductor light-emitting structure 110 may include a first conductivity type semiconductor layer 112 (e.g., a semiconductor layer of the first conductivity type), an active layer 114, and a second conductivity type semiconductor layer 116 (e.g., a semiconductor layer of a second conductivity type), which are sequentially stacked on the main surface 102M in a vertical direction (Z direction) perpendicular to the main surface 102M of the first conductivity type base semiconductor layer 102. The first conductivity type may be n-type and the second conductivity type may be p-type. As used herein, the vertical direction (Z direction) may be referred to as a first direction. The vertical direction may define a height direction, such that relative vertical levels may be defined along the vertical direction. For instance, a higher vertical level may be located further along the vertical direction than a lower vertical level. While the terms "vertical", "lateral", "higher", "lower", etc. are used herein, it will be appreciated that these are defined relative to the structure of the device, and need not limit the device to a particular orientation in use.

The semiconductor light-emitting structure 110 may be a micro light-emitting diode (LED). In one or more embodiments, the semiconductor light-emitting structure 110 may include a micro LED generating light having a color selected from red, green, and blue. The term "micro LED" as used herein refers to a LED having a width of 100 µm or less in a lateral direction (e.g., X direction) perpendicular to the first direction (Z direction). For example, the width of the semiconductor light-emitting structure 110 in the lateral direction (e.g., X direction) may be about 100 µm or less, about 50 µm or less, about 20 µm or less, about 10 µm or less, about 6 µm or less, about 5 µm or less, about 4 µm or less, or about 2 µm or less, without being limited thereto.

The semiconductor light-emitting structure 110 may be configured to emit light having a wavelength (λ) selected within a range from about 400 nm to about 700 nm.

In one or more embodiments, the semiconductor light-emitting structure 110 may be configured to emit light having a first wavelength selected within a range from about 580 nm to about 700 nm. The light having the first wavelength may be red light. As used herein, the wavelength range of red light refers to a wavelength range of about 580 nm or more and less than about 700 nm, for example, a wavelength range from about 610 nm to about 650 nm or a wavelength range from about 620 nm to about 640 nm, and there may be at least one emission spectrum peak in the wavelength range of red light.

In other one or more embodiments, the semiconductor light-emitting structure 110 may be configured to emit light having a second wavelength selected within a range from about 490 nm to about 580 nm. The light having the second wavelength may be green light. As used herein, the wavelength range of green light refers to a wavelength range of about 490 nm or more and less than about 580 nm, for example, a wavelength range from about 510 nm to about 550 nm or a wavelength range from about 520 nm to about 540 nm, and there may be at least one emission spectrum peak in the wavelength range of green light.

In still other one or more embodiments, the semiconductor light-emitting structure 110 may be configured to emit light having a third wavelength selected within a range from about 400 nm to about 490 nm. The light having the third wavelength may be blue light. As used herein, the wavelength range of blue light refers to a wavelength range of about 400 nm or more and less than about 490 nm, for example, a wavelength range from about 440 nm to about 480 nm or a wavelength range from about 450 nm to about 470 nm, and there may be at least one emission spectrum peak in the wavelength range of blue light.

Each of the first conductivity type base semiconductor layer 102, the first conductivity type semiconductor layer 112, the active layer 114, and the second conductivity type semiconductor layer 116 may include an epitaxial nitride semiconductor layer. The first conductivity type base semiconductor layer 102 and the first conductivity type semiconductor layer 112 may include a nitride semiconductor layer doped with the same type of dopant (e.g., an n-type dopant), and an average doping concentration of the first conductivity type base semiconductor layer 102 may be higher than an average doping concentration of the first conductivity type semiconductor layer 112. Each of the first conductivity type semiconductor layer 112 and the second conductivity type semiconductor layer 116 may include a single layer or include multiple layers including a plurality of layers having different doping concentrations of dopant, compositions of constituent components, etc., from each other. The first conductivity type base semiconductor layer 102 may be apart (e.g., spaced apart) from the active layer 114 in the first direction (Z direction) with the first conductivity type semiconductor layer 112 therebetween.

The first conductivity type base semiconductor layer 102 may have a thickness of about 10 nm to about 6000 nm in the first direction (Z direction). The first conductivity type semiconductor layer 112 may have a thickness of about 10 nm to about 500 nm in the first direction (Z direction).

In the semiconductor light-emitting structure 110, the first conductivity type semiconductor layer 112 may be integrally connected to the first conductivity type base semiconductor layer 102. In one or more embodiments, the first conductivity type base semiconductor layer 102 and the first conductivity type semiconductor layer 112 may include the same material. In one or more embodiments, the first conductivity type base semiconductor layer 102 may include n-type gallium nitride (n-GaN). The first conductivity type semiconductor layer 112 may include an n-type superlattice structure layer. For example, the first conductivity type semiconductor layer 112 may include an InGaN/GaN superlattice structure layer. In this case, the first conductivity type semiconductor layer 112 may have a superlattice structure in which an InGaN film and a GaN film are alternately stacked. In the first conductivity type semiconductor layer 112, the superlattice structure may include a pair structure of an InGaN film and a GaN film in about 10 cycles to about 50 cycles, for example, about 15 cycles to about 20 cycles, without being limited thereto.

In other one or more embodiments, the first conductivity type semiconductor layer 112 may include a nitride semiconductor layer having a composition of InₓAl_{y}Ga_{1-x-y}N(0≤x<1, 0≤y<1, 0≤x+y<1). In still other one or more embodiments, the first conductivity type semiconductor layer 112 may include an n-type gallium nitride (n-GaN) doped with silicon (Si), germanium (Ge), or carbon (C). In still other one or more embodiments, the first conductivity type semiconductor layer 112 may include a semiconductor layer including aluminum indium gallium phosphide (AlInGaP) or aluminum indium gallium arsenide (AlInGaAs).

In the semiconductor light-emitting structure 110, the active layer 114 may emit light having certain energy by recombination of electrons and holes. The active layer 114 may have a single-quantum well or multi-quantum well structure in which a quantum barrier layer and a quantum well layer are arranged alternately. In one or more embodiments, the active layer 114 may have a single- or multi-quantum well structure including a pair structure of one quantum barrier layer and one quantum well layer in 1 to 15 cycles. Having said this, embodiments are not limited thereto, and the number of cycles of layers may be varied.

In one or more embodiments, the active layer 114 may include a quantum barrier layer and a quantum well layer including a compound semiconductor of III-V group elements. For example, the active layer 114 may include a pair structure selected from InGaN/GaN, InGaN/InGaN, InGaN/AlGaN, and InGaN/InAlGaN, without being limited thereto.

In one or more embodiments, the quantum well layer and the quantum barrier layer may respectively include InₓAl_{y}Ga_{1-x-y}N layers (0≤x≤1, 0≤y≤1, 0≤x+y≤1) having different compositions from each other. For example, the quantum well layer may include an undoped InₓGa₁₋ₓN layer (0<x<1), and the quantum barrier layer may include an undoped GaN layer or a GaN layer doped with silicon (Si).

In one or more embodiments, when the quantum barrier layer included in the active layer 114 is an InₓGa₁₋ₓN layer (0<x<1), the bandgap energy at the active layer 114 may be controlled according to a content ratio of indium (In) in the quantum well layer, thereby controlling an emission wavelength band. When the quantum well layer included in the active layer 114 is an InₓGa₁₋ₓN layer (0<x<1), a value of x, which represents a content ratio of indium (In) in the quantum well layer, may be selected within a range from about 0.15 to about 0.35. For example, when the semiconductor light-emitting structure 110 is configured to emit red light, the x value in the InₓGa₁₋ₓN layer (0<x<1) constituting the quantum well layer included in the active layer 114 may be selected within a range from about 0.3 to about 0.35, when the semiconductor light-emitting structure 110 is configured to emit green light, the x value in the InₓGa₁₋ₓN layer (0<x<1) constituting the quantum well layer included in the active layer 114 may be selected within a range from about 0.25 to about 0.3, and when the semiconductor light-emitting structure 110 is configured to emit blue light, the x value in the InₓGa₁₋ₓN layer (0<x<1) constituting the quantum well layer included in the active layer 114 may be selected within a range from about 0.15 to about 0.2, without being limited thereto.

In the first direction (Z direction), a thickness of the active layer 114 may be less than 300 nm. The active layer 114 may include a surface in contact with the first conductivity type semiconductor layer 112 and a surface in contact with the second conductivity type semiconductor layer 116, and in the active layer 114, a minimum distance from the surface in contact with the first conductivity type semiconductor layer 112 to the surface in contact with the second conductivity type semiconductor layer 116 may be less than 300 nm.

In one or more embodiments, the active layer 114 may include a multi-quantum well layer including a pair structure of one quantum barrier layer and one quantum well layer in 8 to 12 cycles, wherein the multi-quantum well layer may include a surface in contact with the first conductivity type semiconductor layer 112 and a surface in contact with the second conductivity type semiconductor layer 116, and in the first direction (Z direction), the multi-quantum well layer may have a thickness less than 300 nm. Having said this, embodiments are not limited thereto, and the number of cycles of layers may be varied.

In one or more embodiments, the thickness of the active layer 114 may be less than 300 nm, less than 200 nm, less than 100 nm, less than 50 nm, less than 40 nm, less than 20 nm, less than 10 nm, less than 5 nm, or less than 3 nm. For example, the thickness of the active layer 114 may be selected within a range from about 2 nm to about 10 nm, without being limited thereto.

In one or more embodiments, the thickness of the active layer 114 in the first direction (Z direction) may be determined according to a wavelength (λ) of light emitted from the semiconductor light-emitting structure 110. In this case, the thickness of the active layer 114 in the first direction (Z direction) may be less than 0.4λ. In one or more embodiments, when the semiconductor light-emitting structure 110 is configured to emit red light having a first wavelength (λ₁) selected within a range from about 580 nm to about 700 nm, the thickness of the active layer 114 may be less than 0.4λ₁. In another embodiment, when the semiconductor light-emitting structure 110 is configured to emit green light having a second wavelength (λ₂) selected within a range from about 490 nm to about 580 nm, the thickness of the active layer 114 in the first direction (Z direction) may be less than 0.4λ₂. In still another embodiment, when the semiconductor light-emitting structure 110 is configured to emit blue light having a third wavelength (λ₃) selected within a range from about 400 nm to about 490 nm, the thickness of the active layer 114 in the first direction (Z direction) may be less than 0.4λ₃.

In the semiconductor light-emitting structure 110, the second conductivity type semiconductor layer 116 may include a nitride semiconductor layer doped with a p-type dopant. In one or more embodiments, the second conductivity type semiconductor layer 116 may include a nitride semiconductor layer having a composition of InₓAl_{y}Ga_{1-x-yN}(0≤x<1, 0≤y<1, 0≤x+y<1). For example, the second conductivity type semiconductor layer 116 may include a p-type gallium nitride (p-GaN) doped with magnesium (Mg) or zinc (Zn). However, the disclosure is not limited thereto. In other one or more embodiments, the second conductivity type semiconductor layer 116 may include a semiconductor layer including aluminum indium gallium phosphide (AlInGaP) or aluminum indium gallium arsenide (AlInGaAs).

In the light source 100A, the second conductivity type semiconductor layer 116 each of the plurality of pixels PX including the first pixel PXA1 and the second pixel PXA2 may be covered by a transparent electrode layer 130. The transparent electrode layer 130 may be apart (e.g., spaced apart) from the active layer 114 in the first lateral direction (Z direction) with the second conductivity type semiconductor layer 116 therebetween.

A sidewall of each of the first conductivity type semiconductor layer 112, the active layer 114, and the second conductivity type semiconductor layer 116 included in the semiconductor light-emitting structure 110 and a sidewall of the transparent electrode layer 130 may be covered by a reflective structure 150. In a plan view (X-Y plane), the semiconductor light-emitting structure 110 and the transparent electrode layer 130 may be surrounded by the reflective structure 150. The reflective structure 150 may reflect light traveling from the inside of the semiconductor light-emitting structure 110 to a sidewall of the semiconductor light-emitting structure 110 to adjust light distribution.

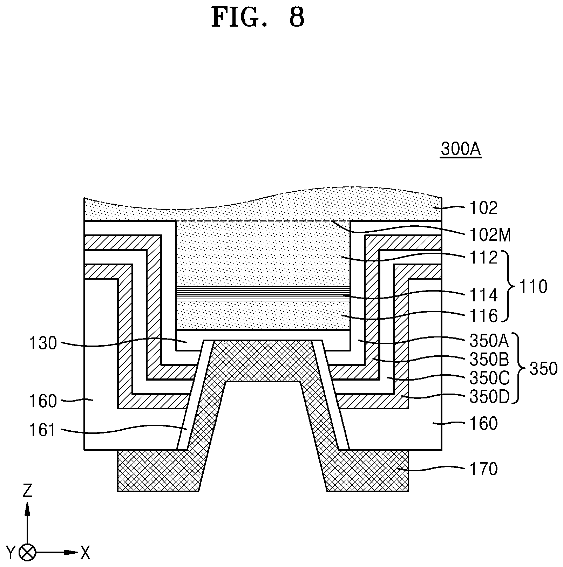

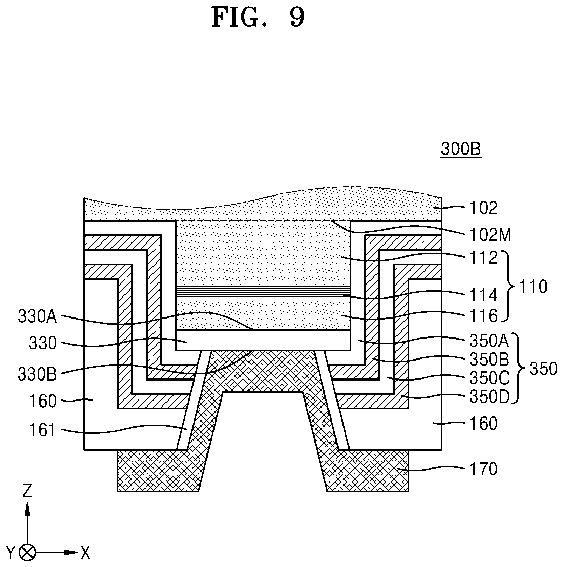

In one or more embodiments, the reflective structure 150 may include silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), gold (Au), titanium (Ti), titanium nitride (TiN), tantalum (Ta), tantalum nitride (TaN), tungsten (W), or a combination thereof. For example, the reflective structure 150 may have a multilayered structure in which a TiN film, an Al film, and a Ti film are sequentially stacked on the sidewall of the semiconductor light-emitting structure 110, without being limited thereto. In other one or more embodiments, the reflective structure 150 may include a distributed Bragg Reflector (DBR). Specific examples of the DBR are described below with reference to FIGS. 8 and 9.

The transparent electrode layer 130 may be in contact with the second conductivity type semiconductor layer 116 and be apart (e.g., spaced apart) from the active layer 114 in the first direction (Z direction) with the second conductivity type semiconductor layer 116 therebetween. The second conductivity type semiconductor layer 116 may have a surface in contact with the active layer 114 and a surface in contact with the transparent electrode layer 130, and the surface of the second conductivity type semiconductor layer 116 in contact with the active layer 114 and the surface of the second conductivity type semiconductor layer 116 in contact with the transparent electrode layer 130 may be opposite surfaces in the first direction (Z direction).

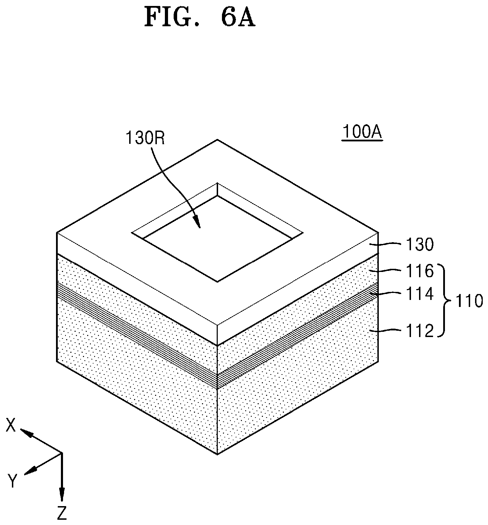

A reflective electrode layer 170 may be arranged on the transparent electrode layer 130. The reflective electrode layer 170 may be in contact with the transparent electrode layer 130 and be apart (e.g., spaced apart) from the second conductivity type semiconductor layer 116 in the first direction (Z direction) with the transparent electrode layer 130 therebetween. As described below with reference to FIG. 6A, a local recess 130R may be formed in a surface of the transparent electrode layer 130, which is opposite to (e.g., facing and/or in contact with) the reflective electrode layer 170. A portion of the reflective electrode layer 170 may be accommodated in the local recess 130R of the transparent electrode layer 130. FIG. 2A illustrates a structure in which a width of a portion of the reflective electrode layer 170 in contact with the transparent electrode layer 130 is less than a width of the semiconductor light-emitting structure 110 in a lateral direction (e.g., X direction). However, the disclosure is not limited thereto. For example, in the lateral direction (e.g., X direction), a width of a portion of the reflective electrode layer 170 in contact with the transparent electrode layer 130 may be equal to or greater than a width of the semiconductor light-emitting structure 110.

The reflective electrode layer 170 may include silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), gold (Au), titanium (Ti), titanium nitride (TiN), tantalum (Ta), tantalum nitride (TaN), tungsten (W), or a combination thereof. For example, the reflective electrode layer 170 may have a multilayered structure in which a TiN film, an Al film, and a Ti film are sequentially stacked, without being limited thereto. An insulating spacer 161 may be between the reflective electrode layer 170 and the reflective structure 150. The insulating spacer 161 may include silicon oxide, without being limited thereto.

The semiconductor light-emitting structure 110 may have a cylindrical shape having a center axis extending in the first direction (Z direction). The semiconductor light-emitting structure 110 may have a width less than 100 µm in a second direction (e.g., X direction) perpendicular to the first direction (Z direction). In one or more embodiments, a width of the semiconductor light-emitting structure 110 in the second direction (e.g., X direction) may be about 100 nm to about 10 µm or about 500 nm to about 1,500 µm.

The transparent electrode layer 130 may have substantially the same width as the semiconductor light-emitting structure 110 in the second direction (e.g., X direction). In the first direction (Z direction), the transparent electrode layer 130 may have a variable thickness. A thickness of a portion of the transparent electrode layer 130 in contact with the reflective electrode layer 170 may be less than thicknesses of other portions of the transparent electrode layer 130 in the first direction (Z direction). In one or more embodiments, a maximum thickness of the transparent electrode layer 130 in the first direction (Z direction) (e.g., in portion(s) not in contact with the reflective electrode layer 170) may be about 50 nm to about 150 nm, and the portion of the transparent electrode layer 130 in contact with the reflective electrode layer 170 may have a thickness of about 30 nm to about 70 nm, without being limited thereto.

The transparent electrode layer 130 may include a transparent conductive material. In one or more embodiments, the transparent electrode layer 130 may include indium tin oxide (ITO), zinc-doped indium tin oxide (ZITO), zinc indium oxide (ZIO), gallium indium oxide (GIO), zinc tin oxide (ZTO), fluorine-doped tin oxide (FTO), aluminum-doped zinc oxide (AZO), gallium-doped zinc oxide (GZO), In₄Sn₃O₁₂, zinc magnesium oxide (Zn₍₁₋ₓ₎MgₓO, 0≤x≤1), or a combination thereof.

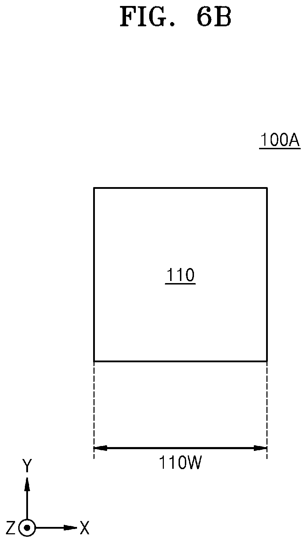

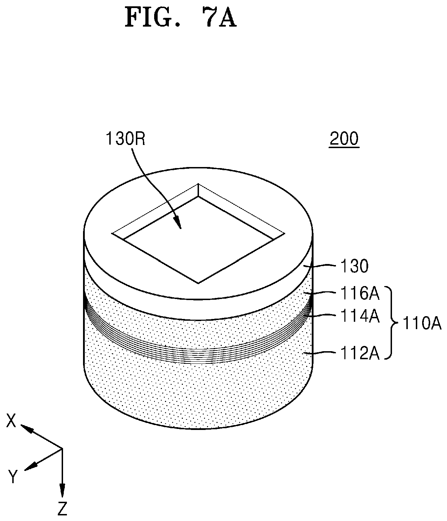

In a plan view (X-Y plane), the semiconductor light-emitting structure 110 may have various plane shapes. For example, the plane shape of the semiconductor light-emitting structure 110 may be a circular shape, an elliptical shape, or a polygonal shape. The polygonal shape may be a tetragonal shape, a hexagonal shape, or an octagonal shape, without being limited thereto. In a plan view (X-Y plane in FIG. 1), a planar shape of the transparent electrode layer 130 may be identical to or similar to a planar shape of the semiconductor light-emitting structure 110. The semiconductor light-emitting structure 110 and the transparent electrode layer 130 may form a cylindrical shape. Specific examples of the plane shape of the semiconductor light-emitting structure 110 are described below with reference to FIGS. 6A, 6B, and 7A to 7D.

The light source 100A may include an insulating layer 160 covering the reflective structure 150. In one or more embodiments, the insulating layer 160 may include silicon oxide, silicon nitride, or a combination thereof. For example, the insulating layer 160 may include tetraethyl ortho silicate (TEOS), undoped silicate glass (USG), phosphosilicate glass (PSG), borosilicate glass (BSG), borophosphosilicate glass (BPSG), fluoride silicate glass (FSG), spin on glass SOG), polysilazane, or a combination thereof.

The reflective electrode layer 170 may partially cover the insulating layer 160 and be in contact with the transparent electrode layer 130 by passing through the reflective structure 150 in the first direction (Z direction). The reflective electrode layer 170 may include portions in contact with the insulating layer 160 and portions in contact with the reflective structure 150.

The light source 100A may further include a plurality of lenses 190. As used herein, the lens 190 may be also referred to as a microlens. A microlens may have a width (e.g. diameter) of 100 µm or less in a lateral direction (e.g., X direction) perpendicular to the first direction (Z direction). Each of the plurality of lenses 190 may be arranged on the first conductivity type base semiconductor layer 102 of a corresponding one of the plurality of pixels PX. Each of the plurality of lenses 190 may be apart (e.g., spaced apart) from the semiconductor light-emitting structure 110 in the first direction (Z direction) with the first conductivity type base semiconductor layer 102 therebetween.

The plurality of lenses 190 may extract light emitted from the semiconductor light-emitting structure 110. In each of the plurality of pixels PX including the first pixel PXA1 and the second pixel PXA2, the first conductivity type base semiconductor layer 102 may have a main surface 102M in contact with the first conductivity type semiconductor layer 112 and a rear surface 102B that is an opposite surface of the main surface 102M, and the lens 190 may be in contact with an emission surface, which is a portion of the rear surface 102B of the first conductivity type base semiconductor layer 102. Each of the plurality of lenses 190 may be arranged to overlap the semiconductor light-emitting structure 110 (e.g., a corresponding semiconductor light-emitting structure 110) in the first direction (Z direction). In one or more embodiments, each of the plurality of lenses 190 may include a spherical microlens or an aspherical microlens. In one or more embodiments, each of the plurality of lenses 190 may include a graded-refractive index layer formed in a multi-layer structure in which the refractive index gradually decreases in a light travel direction (e.g., away from the semiconductor light-emitting structure 110). The graded-refractive index layer may be formed by using an oblique deposition method, a sputtering method, an evaporation method, etc. The graded-refractive index layer may have a refractive index gradually decreasing in a direction towards a light output surface. The refractive index may be measured at the wavelength of the light emitted from the semiconductor light-emitting structure 110 (e.g., at a visible range of the electromagnetic spectrum (e.g., having a wavelength from about 400 nm to about 700 nm)). In one or more embodiments, each of the plurality of lenses 190 may include TiO₂, SiC, GaN, GaP, SiN, SiON, ZrO₂, ITO, AlN, Al₂O₃, MgO, SiO₂, CaF₂, MgF₂, or a combination thereof. In other one or more embodiments, each of the plurality of lenses 190 may include a transparent resin. For example, each of the plurality of lenses 190 may include an acryl resin such as polymethyl methacrylate (PMMA), polyethylene terephthalate (PET), poly carbonate (PC), cycloolefin copolymer (COC), a polyethylene naphthalate (PEN) resin, or a combination thereof. However, a constituent material of the plurality of lenses 190 is not limited to the examples described above. Lenses 190 may be formed by depositing a transparent resin on the first conductivity type base semiconductor layer 102.

As illustrated in FIG. 2A, in one or more embodiments, the first conductivity type base semiconductor layer 102 included in the first pixel PXA1 selected from the plurality of pixels PX may have a first optical path guide surface CV facing one lens 190 (referred to as a first lens) selected from the plurality of lenses 190, and the first conductivity type base semiconductor layer 102 included in the second pixel PXA2 selected from the plurality of pixels PX may have a second optical path guide surface CC facing another lens 190 (referred to as a second lens) selected from the plurality of lenses 190. The first optical path guide surface CV and the second optical path guide surface CC may include non-flat surfaces having different shapes.

FIG. 2A illustrates a configuration in which the first optical path guide surface CV of the first pixel PXA1 includes a convex portion that is convex toward a first lens 190 and the second optical path guide surface CC of the second pixel PXA2 includes a concave portion that is concave toward a second lens 190. The terms "convex toward" and "concave toward" may refer to a surface that is facing in a particular direction. For instance, a portion that is "convex toward" a first lens 190 may be convex from the perspective of a surface facing toward the first lens 190. In this case, the surface may protrude toward the first lens 190. Similarly, a portion that is "concave toward" a second lens 190 may be concave from the perspective of a surface facing toward the second lens 190. In this case, the surface may be recessed away from the second lens 190.

In the first lens 190 overlapping the first optical path guide surface CV of the first pixel PXA1 in the first direction (Z direction), a first surface facing the first optical path guide surface CV may include a first non-flat surface corresponding to a shape of the first optical path guide surface CV, and the first non-flat surface of the first lens 190 may include a concave surface in contact with the first optical path guide surface CV.

In the second lens 190 overlapping the second optical path guide surface CC of the second pixel PXA2 in the first direction (Z direction), a second surface facing the second optical path guide surface CC may include a second non-flat surface corresponding to a shape of the second optical path guide surface CC. The second non-flat surface may have a different shape from the first non-flat surface. The second non-flat surface of the second lens 190 may have a convex surface in contact with the second optical path guide surface CC.

In the first pixel PXA1, a maximum protrusion length (hereinafter, a maximum length) in the first direction (Z direction) of the first optical path guide surface CV protruding from the rear surface 102B of the first conductivity type base semiconductor layer 102 may be variously selected depending on emission characteristics required for the first pixel PXA1. In the second pixel PXA2, a maximum recess length (hereinafter, a maximum length) in the first direction (Z direction) of the second optical path guide surface CC that is recessed from the rear surface 102B of the first conductivity type base semiconductor layer 102 may be variously selected depending on emission characteristics required for the second pixel PXA2. For example, when the first pixel PXA1 is configured to emit blue light, while blue light is passing through the first optical path guide surface CV, an optical path may be focused toward an optical path direction passing through the center of the first optical path guide surface CV. Thus, a focal length of the blue light may be controlled to a desired position. In the second pixel PXA2, while red light, green light, or blue light is passing through the second optical path guide surface CC, an optical path may be moved toward an optical path direction passing through the center of the second optical path guide surface CC or toward a direction away from the optical path direction passing through the center of the second optical path guide surface CC. Accordingly, a focal length of red light, green light, or blue light may be controlled to a desired position. For example, by using the first optical path guide surface CV and the second optical path guide surface CC, a focal length of light emitted by the first pixel PXA1 through the first lens 190 and a focal length of light emitted by the second pixel PXA2 through the second lens 190 may be controlled to be the same as or similar to each other. In addition, because the range of control over refractive indices and lens shapes is greater than when a lens is arranged on a flat plane surface, light extraction may be improved.

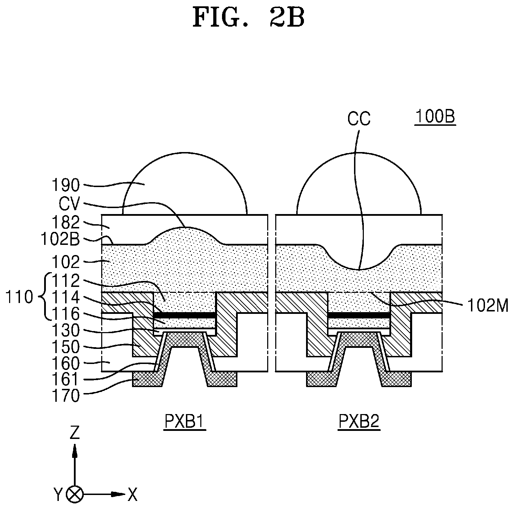

Referring to FIG. 2B, the light source 100B may have substantially the same configuration as the light source 100A described with reference to FIG. 2A. However, in the light source 100B, the plurality of pixels PX (refer to FIG. 1) may include a first pixel PXB1 and a second pixel PXB2. Detailed configurations of the first pixel PXB1 and the second pixel PXB2 are substantially the same as those of the first pixel PXA1 and the second pixel PXA2 described with reference to FIG. 2A.

The light source 100B may further include a transparent layer 182, which is between a first optical path guide surface CV of a first conductivity type base semiconductor layer 102 included in the first pixel PXB1 and a lens 190 (referred to as a first lens) facing the first optical path guide surface CV and is between a second optical path guide surface CC of the first conductivity type base semiconductor layer 102 included in the second pixel PXB2 and a lens 190 (referred to as a second lens) facing the second optical path guide surface CC. A portion of the transparent layer 182 between the first optical path guide surface CV and the lens 190 facing the first optical path guide surface CV may be referred to as a first transparent layer, and a portion of the transparent layer 182 between the second optical path guide surface CC and the lens 190 facing the second optical path guide surface CC may be referred to as a second transparent layer.

The transparent layer 182 may have a flat surface facing a plurality of lenses 190. The transparent layer 182 may have a variable thickness in a first direction (Z direction) according to a position. For example, of the transparent layer 182, the first transparent layer, which overlaps a semiconductor light-emitting structure 110 of the first pixel PXB1 in the first direction (Z direction), may have a smaller thickness in a portion in contact with the first optical path guide surface CV than thicknesses of other portions. In addition, of the transparent layer 182, the second transparent layer, which overlaps a semiconductor light-emitting structure 110 of the second pixel PXB2 in the first direction (Z direction), may have a greater thickness in a portion in contact with the second optical path guide surface CC than thicknesses of other portions.

The transparent layer 182 may include an insulating film or a conductive film. For example, the transparent layer 182 may include silicon oxide, silicon nitride, ITO, or a combination thereof, without being limited thereto.

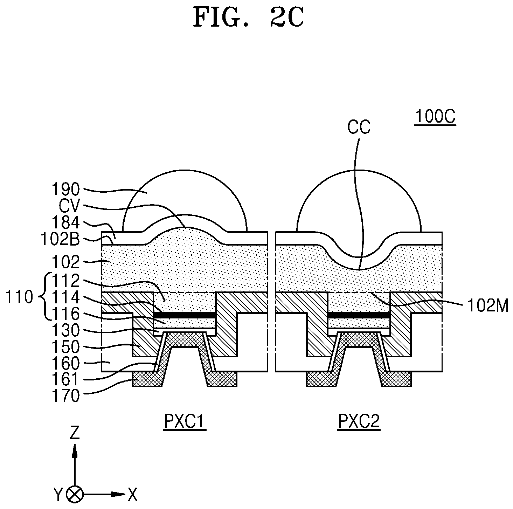

Referring to FIG. 2C, the light source 100C may have substantially the same configuration as the light source 100A described with reference to FIG. 2A. However, in the light source 100C, the plurality of pixels PX (refer to FIG. 1) may include a first pixel PXC1 and a second pixel PXC2. Detailed configurations of the first pixel PXC1 and the second pixel PXC2 are substantially and respectively the same as those of the first pixel PXA1 and the second pixel PXA2 described with reference to FIG. 2A.

The light source 100C may further include a transparent layer 184, which is between a first optical path guide surface CV of a first conductivity type base semiconductor layer 102 included in the first pixel PXC1 and a lens 190 (referred to as a first lens) facing the first optical path guide surface CV and is between a second optical path guide surface CC of the first conductivity type base semiconductor layer 102 included in the second pixel PXC2 and a lens 190 (referred to as a second lens) facing the second optical path guide surface CC. A portion of the transparent layer 184 between the first optical path guide surface CV and the lens 190 facing the first optical path guide surface CV may be referred to as a first transparent layer, and a portion between the second optical path guide surface CC and the lens 190 facing the second optical path guide surface CC may be referred to as a second transparent layer.

The transparent layer 184 may include a liner-shaped layer conformally covering a rear surface 102B of the first conductivity type base semiconductor layer 102. A portion of the transparent layer 184, which covers the first optical path guide surface CV, may have substantially the same thickness as a portion of the transparent layer 184, which covers the second optical path guide surface CC. The transparent layer 182 may include an insulating film or a conductive film. For example, the transparent layer 184 may include silicon oxide, silicon nitride, ITO, or a combination thereof, without being limited thereto.

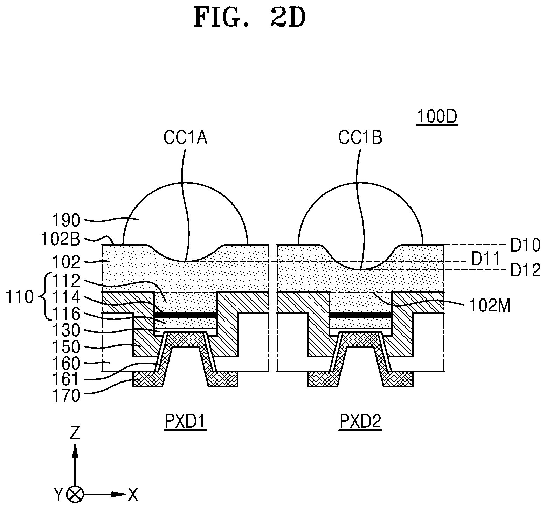

Referring to FIG. 2D, the light source 100D may have substantially the same configuration as the light source 100A described with reference to FIG. 2A. However, in the light source 100D, the plurality of pixels PX (refer to FIG. 1) may include a first pixel PXD1 and a second pixel PXD2. Detailed configurations of the first pixel PXD1 and the second pixel PXD2 are substantially and respectively the same as those of the first pixel PXA1 and the second pixel PXA2 described with reference to FIG. 2A.

The first pixel PXD1 may include a first optical path guide surface CC1A formed at a rear surface 102B of the first conductivity type base semiconductor layer 102, and the second pixel PXD2 may include a second optical path guide surface CC1B formed at the rear surface 102B of the first conductivity type base semiconductor layer 102. The first optical path guide surface CC1A of the first pixel PXD1 may include a first concave portion that is concave toward a lens 190 (referred to as a first lens) corresponding thereto. The second optical path guide surface CC1B of the second pixel PXD2 may include a second concave portion that is concave toward a lens 190 (referred to as a second lens) corresponding thereto. A first maximum length of the first concave portion in a first direction (Z direction) may be different from a second maximum length of the second concave portion in the first direction (Z direction).

The first optical path guide surface CC1A and the second optical path guide surface CC1B may have substantially the same configuration as the second optical path guide surface CC described with reference to FIG. 2A. However, a vertical level D11 of a lowermost surface of the first optical path guide surface CC1A may be closer to a vertical level D10 of a flat portion of the rear surface 102B of the first conductivity type base semiconductor layer 102 than a vertical level D12 of a lowermost surface of the second optical path guide surface CC1B. Accordingly, a first maximum length in the first direction (Z direction) of the first concave portion that provides the first optical path guide surface CC1A of the first pixel PXD1 may be less than a second maximum length in the first direction (Z direction) of the second concave portion that provides the second optical path guide surface CC1B of the second pixel PXD2.

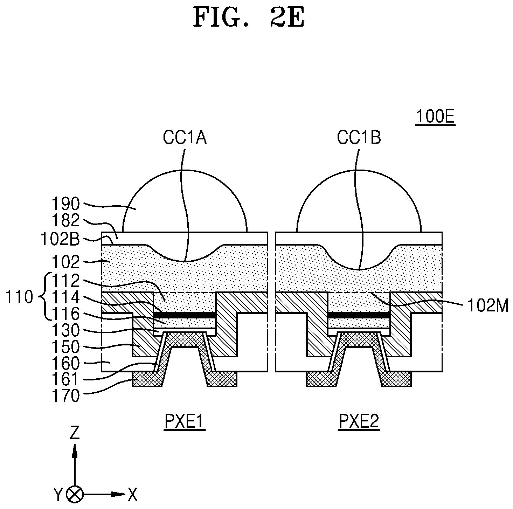

Referring to FIG. 2E, the light source 100E may have substantially the same configuration as the light source 100D described with reference to FIG. 2D. However, in the light source 100E, the plurality of pixels PX (refer to FIG. 1) may include a first pixel PXE1 and a second pixel PXE2. Detailed configurations of the first pixel PXE1 and the second pixel PXE2 are substantially and respectively the same as those of the first pixel PXD1 and the second pixel PXD2 described with reference to FIG. 2D.

The light source 100E may further include a transparent layer 182, which is between a first optical path guide surface CC1A of a first conductivity type base semiconductor layer 102 included in the first pixel PXE1 and a lens 190 (referred to as a first lens) facing the first optical path guide surface CC1A and is between a second optical path guide surface CC1B of the first conductivity type base semiconductor layer 102 included in the second pixel PXE2 and a lens 190 (referred to as a second lens) facing the second optical path guide surface CC1B. A detailed configuration of the transparent layer 182 is the same as described above with reference to FIG. 2B.

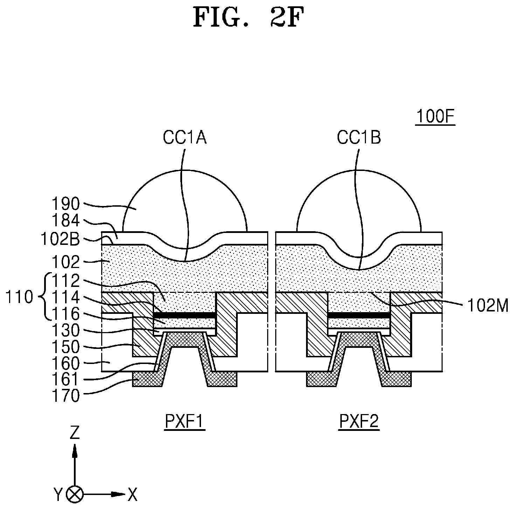

Referring to FIG. 2F, the light source 100F may have substantially the same configuration as the light source 100D described with reference to FIG. 2D. However, in the light source 100F, the plurality of pixels PX (refer to FIG. 1) may include a first pixel PXF1 and a second pixel PXF2. Detailed configurations of the first pixel PXF1 and the second pixel PXF2 are substantially and respectively the same as those of the first pixel PXD1 and the second pixel PXD2 described with reference to FIG. 2D.

The light source 100F may further include a transparent layer 184, which is between a first optical path guide surface CC1A of a first conductivity type base semiconductor layer 102 included in the first pixel PXF1 and a lens 190(referred to as a first lens) facing the first optical path guide surface CC1A and is between a second optical path guide surface CC1B of the first conductivity type base semiconductor layer 102 included in the second pixel PXF2 and a lens 190 (referred to as a second lens) facing the second optical path guide surface CC1B. A detailed configuration of the transparent layer 184 is the same as the transparent layer 182 described above with reference to FIG. 2C.

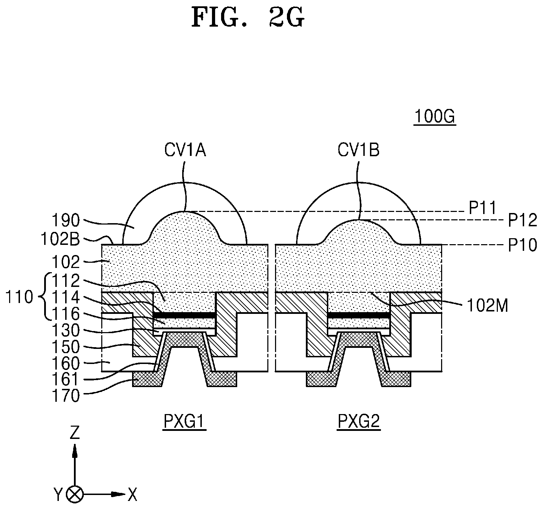

Referring to FIG. 2G, the light source 100G may have substantially the same configuration as the light source 100A described with reference to FIG. 2A. However, in the light source 100G, the plurality of pixels PX (refer to FIG. 1) may include a first pixel PXG1 and a second pixel PXG2. Detailed configurations of the first pixel PXG1 and the second pixel PXG2 are substantially and respectively the same as those of the first pixel PXA1 and the second pixel PXA2 described with reference to FIG. 2A. However, the first pixel PXG1 may include a first optical path guide surface CV1A formed at a rear surface 102B of a first conductivity type base semiconductor layer 102, and the second pixel PXG2 may include a second optical path guide surface CV1B formed at the rear surface 102B of the first conductivity type base semiconductor layer 102. The first optical path guide surface CV1A of the first pixel PXG1 may include a first convex portion that is convex toward a lens 190 (referred to as a first lens) corresponding thereto. The second optical path guide surface CV1B of the second pixel PXG2 may include a second convex portion that is convex toward a lens 190 (referred to as a second lens) corresponding thereto. A first maximum length of the first convex portion in a first direction (Z direction) may be different from a second maximum length of the second convex portion in the first direction (Z direction).

The first optical path guide surface CV1A and the second optical path guide surface CV1B may have substantially the same configuration as the first optical path guide surface CV described with reference to FIG. 2A. However, a vertical level P11 of an uppermost surface of the first optical path guide surface CV1A may be farther from a vertical level P10 of a flat portion of the rear surface 102B of the first conductivity type base semiconductor layer 102 than a vertical level P12 of an uppermost surface of the second optical path guide surface CV1B. Accordingly, a first maximum length in the first direction (Z direction) of the first convex portion that provides the first optical path guide surface CV1A of the first pixel PXG1 may be greater than a second maximum length in the first direction (Z direction) of the second convex portion that provides the second optical path guide surface CV1B of the second pixel PXG2.

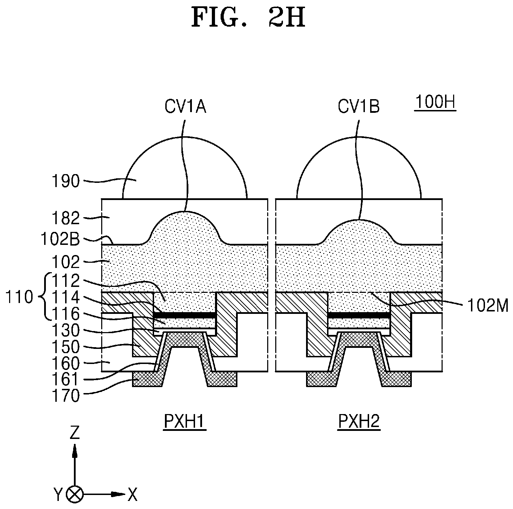

Referring to FIG. 2H, the light source 100H may have substantially the same configuration as the light source 100G described with reference to FIG. 2G. However, in the light source 100H, the plurality of pixels PX (refer to FIG. 1) may include a first pixel PXH1 and a second pixel PXH2. Detailed configurations of the first pixel PXH1 and the second pixel PXH2 are substantially and respectively the same as those of the first pixel PXG1 and the second pixel PXG2 described with reference to FIG. 2G.

The light source 100H may further include a transparent layer 182, which is between a first optical path guide surface CV1A of a first conductivity type base semiconductor layer 102 included in the first pixel PXH1 and a lens 190 (referred to as a first lens) facing the first optical path guide surface CV1A and is between a second optical path guide surface CV1B of the first conductivity type base semiconductor layer 102 included in the second pixel PXH2 and a lens 190 (referred to as a second lens) facing the second optical path guide surface CV1B. A detailed configuration of the transparent layer 182 is the same as described above with reference to FIG. 2B.

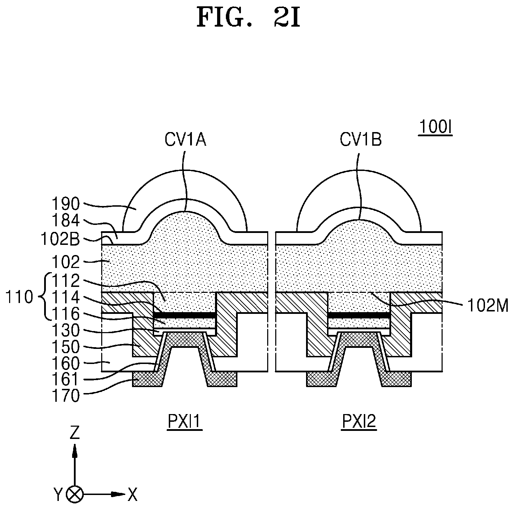

Referring to FIG. 2I, the light source 100I may have substantially the same configuration as the light source 100G described with reference to FIG. 2G. However, in the light source 100I, the plurality of pixels PX (refer to FIG. 1) may include a first pixel PXI1 and a second pixel PXI2. Detailed configurations of the first pixel PXI1 and the second pixel PXI2 are substantially and respectively the same as those of the first pixel PXG1 and the second pixel PXG2 described with reference to FIG. 2G.

The light source 100I may further include a transparent layer 184, which is between a first optical path guide surface CV1A of a first conductivity type base semiconductor layer 102 included in the first pixel PXI1 and a lens 190 (referred to as a first lens) facing the first optical path guide surface CV1A and is between a second optical path guide surface CV1B of the first conductivity type base semiconductor layer 102 included in the second pixel PXI2 and a lens 190 (referred to as a second lens) facing the second optical path guide surface CV1B. A detailed configuration of the transparent layer 184 is the same as described above with reference to FIG. 2C.

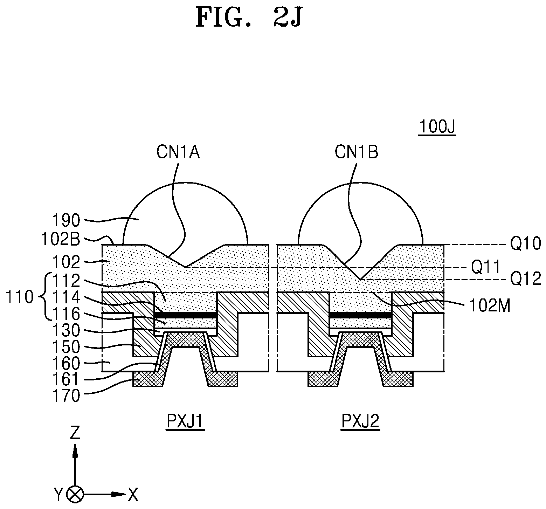

Referring to FIG. 2J, the light source 100J may have substantially the same configuration as the light source 100A described with reference to FIG. 2A. However, in the light source 100J, the plurality of pixels PX (refer to FIG. 1) may include a first pixel PXJ1 and a second pixel PXJ2. Detailed configurations of the first pixel PXJ1 and the second pixel PXJ2 are substantially and respectively the same as those of the first pixel PXA1 and the second pixel PXA2 described with reference to FIG. 2A. However, the first pixel PXJ1 may include a first optical path guide surface CN1A formed at a rear surface 102B of a first conductivity type base semiconductor layer 102, and the second pixel PXJ2 may include a second optical path guide surface CN1B formed at the rear surface 102B of the first conductivity type base semiconductor layer 102. The first optical path guide surface CN1A of the first pixel PXJ1 may include a first concave portion that is concave toward a lens 190 (referred to as a first lens) corresponding thereto. The second optical path guide surface CN1B of the second pixel PXJ2 may include a second concave portion that is concave toward a lens 190 (referred to as a second lens) corresponding thereto. A first maximum length of the first concave portion in a first direction (Z direction) may be different from a second maximum length of the second concave portion in the first direction (Z direction).

The first optical path guide surface CN1A and the second optical path guide surface CN1B may have substantially the same configuration as the second optical path guide surface CC described with reference to FIG. 2A. However, each of the first concave portion providing the first optical path guide surface CN1A and the second concave portion providing the second optical path guide surface CN1B may have a substantially V-shaped cross-sectional shape. In addition, a vertical level Q11 of a lowermost surface of the first optical path guide surface CN1A may be closer to a vertical level Q10 of a flat portion of the rear surface 102B of the first conductivity type base semiconductor layer 102 than a vertical level Q12 of a lowermost surface of the second optical path guide surface CN1B. Accordingly, a first maximum length in the first direction (Z direction) of the first concave portion that provides the first optical path guide surface CN1A of the first pixel PXJ1 may be less than a second maximum length in the first direction (Z direction) of the second concave portion that provides the second optical path guide surface CN1B of the second pixel PXJ2.

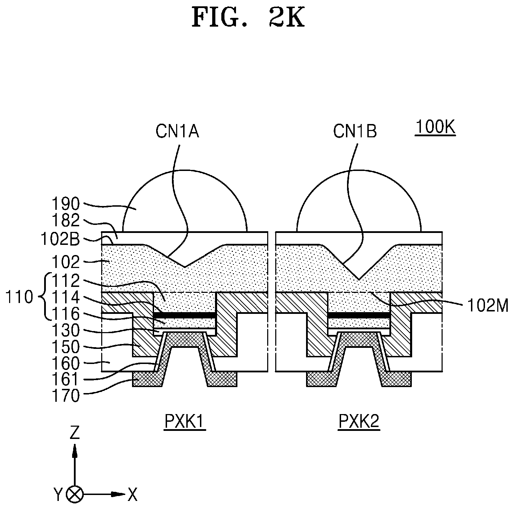

Referring to FIG. 2K, the light source 100K may have substantially the same configuration as the light source 100J described with reference to FIG. 2J. However, in the light source 100K, the plurality of pixels PX (refer to FIG. 1) may include a first pixel PXK1 and a second pixel PXK2. Detailed configurations of the first pixel PXK1 and the second pixel PXK2 are substantially and respectively the same as those of the first pixel PXJ1 and the second pixel PXJ2 described with reference to FIG. 2J.

The light source 100K may further include a transparent layer 182, which is between a first optical path guide surface CN1A of a first conductivity type base semiconductor layer 102 included in the first pixel PXK1 and a lens 190 (referred to as a first lens) facing the first optical path guide surface CN1A and is between a second optical path guide surface CN1B of the first conductivity type base semiconductor layer 102 included in the second pixel PXK2 and a lens 190 (referred to as a second lens) facing the second optical path guide surface CN1B. A detailed configuration of the transparent layer 182 is the same as described above with reference to FIG. 2B.

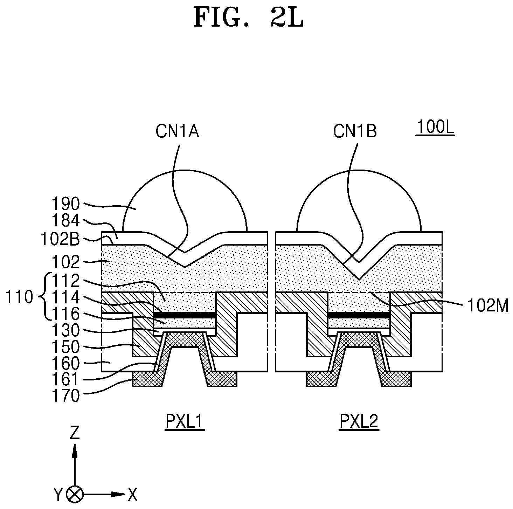

Referring to FIG. 2L, the light source 100L may have substantially the same configuration as the light source 100J described with reference to FIG. 2J. However, in the light source 100L, the plurality of pixels PX (refer to FIG. 1) may include a first pixel PXL1 and a second pixel PXL2. Detailed configurations of the first pixel PXL1 and the second pixel PXL2 are substantially and respectively the same as those of the first pixel PXJ1 and the second pixel PXJ2 described with reference to FIG. 2J.

The light source 100L may further include a transparent layer 184, which is between a first optical path guide surface CN1A of a first conductivity type base semiconductor layer 102 included in the first pixel PXL1 and a lens 190 (referred to as a first lens) facing the first optical path guide surface CN1A and is between a second optical path guide surface CN1B of the first conductivity type base semiconductor layer 102 included in the second pixel PXL2 and a lens 190 (referred to as a second lens) facing the second optical path guide surface CN1B. A detailed configuration of the transparent layer 184 is the same as described above with reference to FIG. 2C.

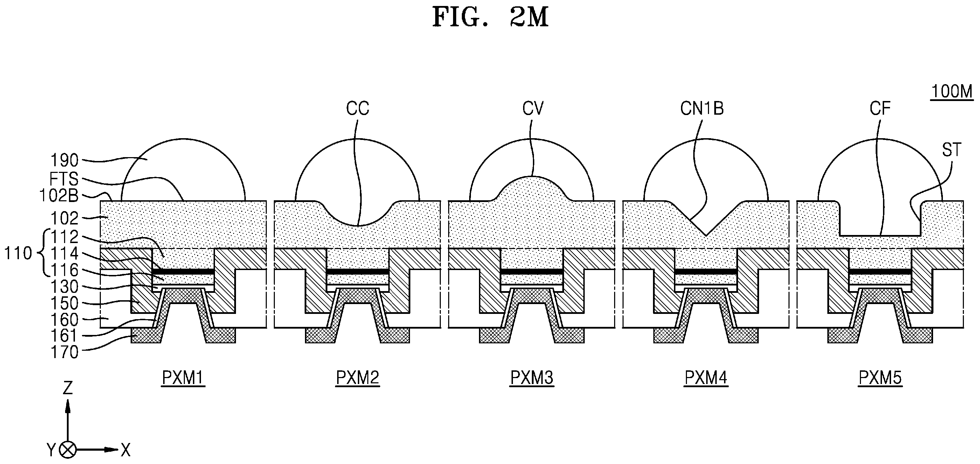

Referring to FIG. 2M, in the light source 100M, the plurality of pixels PX (refer to FIG. 1) may include at least two pixels selected from a first pixel PXM1, a second pixel PXM2, a third pixel PXM3, a fourth pixel PXM4, and a fifth pixel PXM5.

The first pixel PXM1, the second pixel PXM2, the third pixel PXM3, the fourth pixel PXM4, and the fifth pixel PXM5 may be respectively different pixels selected from the pixel PX11 located in the center portion of the pixel region PXR illustrated in FIG. 1 and the pixels PX12, PX13, PX14, PX15, PX16, PX17, PX18, and PX19 located in the edge portion of the pixel region PXR illustrated in FIG. 1. Detailed configurations of the first pixel PXM1, the second pixel PXM2, the third pixel PXM3, the fourth pixel PXM4, and the fifth pixel PXM5 are substantially the same as those of the first pixel PXA1 and the second pixel PXA2 described with reference to FIG. 2A. However, in each of the first pixel PXM1, the second pixel PXM2, the third pixel PXM3, the fourth pixel PXM4, and the fifth pixel PXM5, a portion of a rear surface 102B of a first conductivity type base semiconductor layer 102, which faces a lens 190 corresponding thereto, may have a different shape.

In the first pixel PXM1, the rear surface 102B of the first conductivity type base semiconductor layer 102 may have a generally flat shape without steps. In the first pixel PXM1, an interface between the rear surface 102B of the first conductivity type base semiconductor layer 102 and the lens 190 may extend flat along one plane that is substantially parallel with an X-Y plane. Of the rear surface 102B of the first conductivity type base semiconductor layer 102, at least a portion of a flat surface facing the lens 190 may provide an optical path guide surface FTS.

The second pixel PXM2 may have the same configuration as the second pixel PXA2 described with reference to FIG. 2A. The third pixel PXM3 may have the same configuration as the first pixel PXA1 described with reference to FIG. 2A. The fourth pixel PXM4 may have the same configuration as the second pixel PXA2 described with reference to FIG. 2J. The fifth pixel PXM5 may include a first optical path guide surface CF formed at the rear surface 102B of the first conductivity type base semiconductor layer 102. The optical path guide surface CF may include a concave portion that is concave toward the lens 190 corresponding thereto, and a step portion ST may be formed by the concave portion on the rear surface 102B of the first conductivity type base semiconductor layer 102. The concave portion of the optical path guide surface CF may include a bottom surface facing the lens 190 corresponding thereto, and the bottom surface may extend flat without steps along one plane, which is substantially parallel with the X-Y plane, in a region defined by the step portion ST. Accordingly, a concave or convex portion may be formed by a plurality of flat surfaces (e.g. a V-shape, a step shape, etc.).

In one or more embodiments, in each of the first pixel PXM1, the second pixel PXM2, the third pixel PXM3, the fourth pixel PXM4, and the fifth pixel PXM5, the transparent layer 182 described with reference to FIG. 2B, the transparent layer 184 described with reference to FIG. 2C, or a transparent layer having one of various structures that are obtained by variously modifying and changing the transparent layer 182 or 184 within the scope of the disclosure may be between the rear surface 102B of the first conductivity type base semiconductor layer 102 and the lens 190. In one or more embodiments, each of the light sources 100A, 100B, 100C, 100D, 100E, 100F, 100G, 100H, 100I, 100J, 100K, and 100L described above with reference to FIGS. 2A to 2L may further include at least one pixel of the first pixel PXM1, the second pixel PXM2, the third pixel PXM3, the fourth pixel PXM4, and the fifth pixel PXM5 with reference to FIG. 2M.

The light sources 100A, 100B, 100C, 100D, 100E, 100F, 100G, 100H, 100I, 100J, 100K, 100L, and 100M described above with reference to FIGS. 2A to 2M may each include the plurality of pixels PX and a plurality of lenses 190 respectively arranged on the plurality of pixels PX. In at least two pixels PX selected from the plurality of pixels PX, optical path guide surfaces of the first conductivity type base semiconductor layer 102, which face the lenses 190 corresponding thereto, may include non-flat surfaces having different shapes. Accordingly, in the light sources 100A, 100B, 100C, 100D, 100E, 100F, 100G, 100H, 100I, 100J, 100K, 100L, and 100M according to the one or more embodiments, when the plurality of pixels PX included in a single chip are configured to emit light having the same color, respective optical path guide surfaces of the plurality of pixels PX may be implemented in various shapes so as to minimize a deviation of focal length according to a position of each of the plurality of pixels PX. In addition, when the plurality of pixels PX included in a single chip are configured to emit light having a plurality of colors (e.g. which includes red light, green light, and/or blue light), an optical path may be controlled such that a focal length of light emitted by each of the plurality of pixels PX is controlled to a desired position. As described above, by controlling a focal length of each of red light, green light, and blue light to a desired position, the focal lengths of red light, green light, and blue light emitted by the plurality of pixels PX through the lens 190 may be controlled to be substantially the same as or similar to each other. According to the light sources 100A, 100B, 100C, 100D, 100E, 100F, 100G, 100H, 100I, 100J, 100K, 100L, and 100M according to the one or more embodiments, by implementing respective optical path guide surfaces of the plurality of pixels PX in various shapes, light extraction efficiency of the light sources 100A, 100B, 100C, 100D, 100E, 100F, 100G, 100H, 100I, 100J, 100K, 100L, and 100M may be maximized. Therefore, according to the disclosure, a light source having a structure better optimized to a micro-sized chip while maximizing light extraction efficiency may be provided, and when the light sources 100A, 100B, 100C, 100D, 100E, 100F, 100G, 100H, 100I, 100J, 100K, 100L, and 100M according to the one or more embodiments are employed in a display device, the performance of the display device may improve.

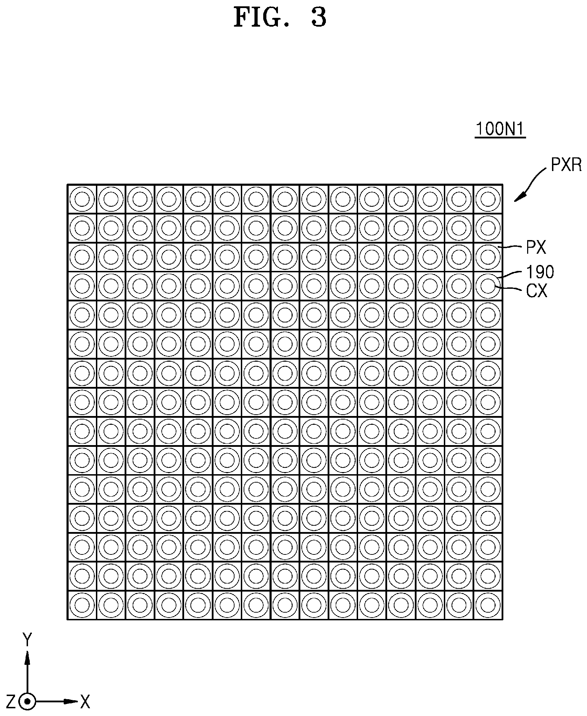

FIG. 3 is a plan view of a light source 100N1 according to one or more embodiments. In FIG. 3, the same reference numerals are used to denote the same elements as in FIGS. 1 and 2A to 2M, and thus any redundant description will be omitted.

Referring to FIG. 3, the light source 100N1 may include a pixel region PXR including a plurality of pixels PX. The plurality of pixels PX may include pixels having various structures described with reference to FIGS. 2A to 2M or at least two pixels having different structures selected from among pixels having various structures that are modified and changed within the scope of the disclosure. Each of the plurality of pixels PX may include an optical guide light-emitting structure CX. The optical guide light-emitting structure CX may represent a combined structure of the semiconductor light-emitting structure 110 described with reference to FIGS. 2A to 2M and various optical path guide surfaces arranged to overlap the semiconductor light-emitting structure 110 in a first direction (Z direction). A plurality of optical guide light-emitting structures CX included in the plurality of pixels PX may include at least two optical path guide surfaces having different structures selected from the first optical path guide surfaces CV, CC1A, CV1A, and CN1A, the second optical path guide surfaces CC, CC1B, CV1B, and CN1B, and the optical path guide surfaces FTS and CF, which are illustrated in FIGS. 2A to 2M, and optical path guide surfaces having structures that are variously modified and changed within the scope of the disclosure.

As shown in FIG. 3, in an X-Y plan view, a center axis of the optical guide light-emitting structure CX of each of the plurality of pixels PX included in the light source 100N1 and a center axis of the lens 190 corresponding thereto may be aligned with each other in the same line.

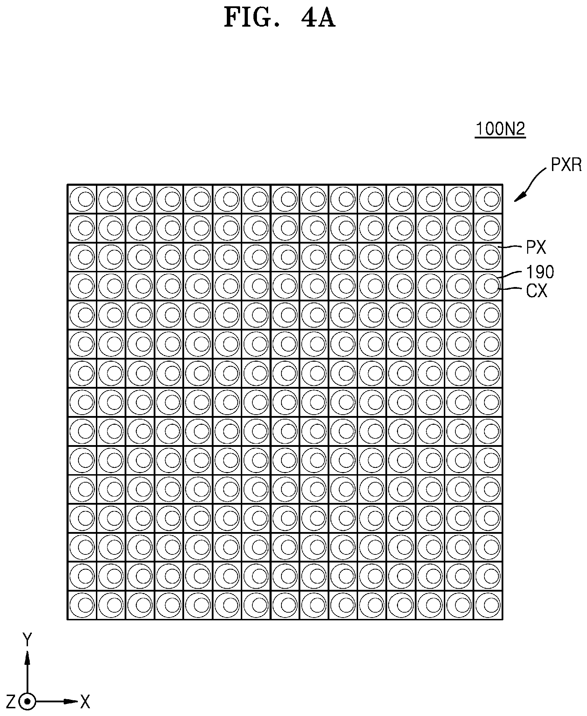

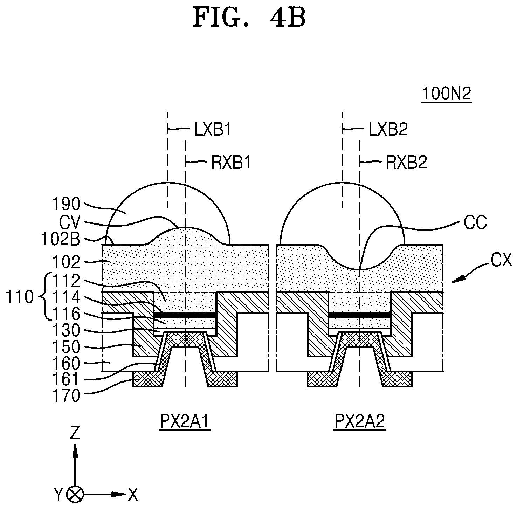

FIG. 4A is a plan view of a light source according to one or more embodiments. FIG. 4B is a cross-sectional view of a partial region included in the light source illustrated in FIG. 4A. In FIGS. 4A to 4B, the same reference numerals are used to denote the same elements as in FIGS. 1 to 3, and thus any redundant description will be omitted.

Referring to FIGS. 4A and 4B, a light source 100N2 may include a pixel region PXR including a plurality of pixels PX. In the light source 100N2, the plurality of pixels PX may include pixels having various structures described with reference to FIGS. 2A to 2M or at least two pixels having different structures selected from among pixels having various structures that are modified and changed within the scope of the disclosure. For example, in the light source 100N2, the plurality of pixels PX may include a first pixel PX2A1 and a second pixel PX2A2, which are illustrated in FIG. 4B. The first pixel PX2A1 and the second pixel PX2A2 may substantially and respectively have the same configurations as those of the first pixel PXA1 and the second pixel PXA2 described with reference to FIG. 2A.

In an X-Y plan view, a center axis of an optical guide light-emitting structure CX of each of the plurality of pixels PX included in the light source 100N2 and a center axis of a lens 190 corresponding thereto may be misaligned from each other in a lateral direction (e.g., X direction). FIGS. 4A and 4B illustrate a structure in which center axes LXB 1 and LXB2 of lenses 190 corresponding to the first pixel PX2A1 and the second pixel PX2A2 are misaligned in a -X direction from center axes RXB1 and RXB2 of the optical guide light-emitting structures CX of the first pixel PXA1 and the second pixel PXA2. As illustrated in FIG. 4B, a center axis in a first direction (Z direction) of each of first and second optical path guide surfaces CV and CC included in the optical guide light-emitting structure CX may be misaligned in a lateral direction (e.g., -X direction) from a center axis in the first direction (Z direction) of a lens 190 corresponding thereto.

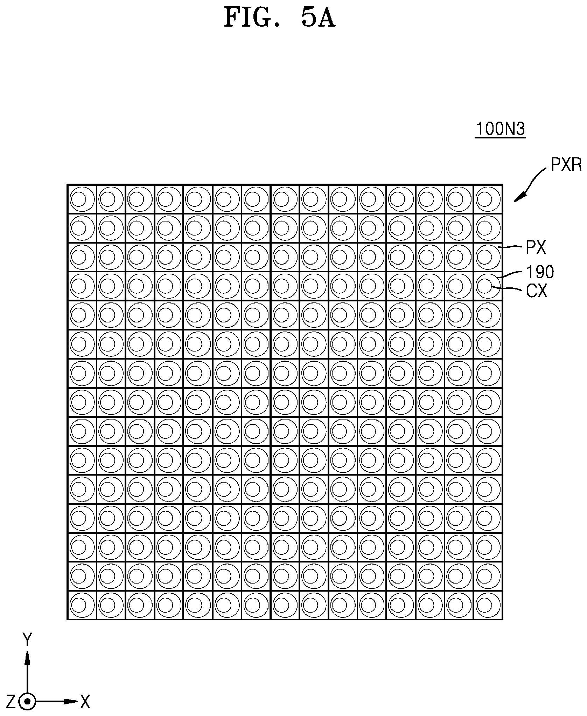

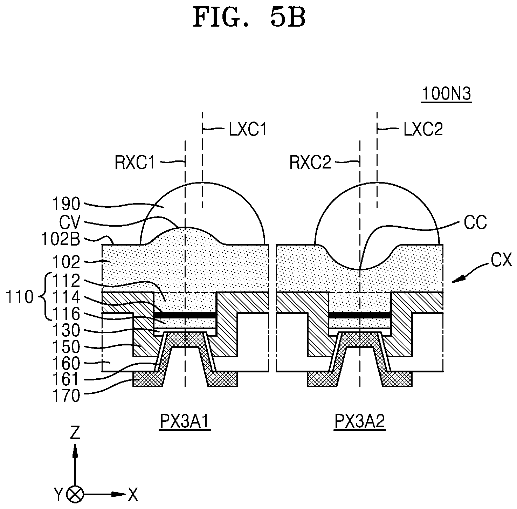

FIG. 5A is a plan view of a light source according to one or more embodiments. FIG. 5B is a cross-sectional view of a partial region included in the light source illustrated in FIG. 5A. In FIGS. 5A and 5B, the same reference numerals are used to denote the same elements as in FIGS. 1 to 3, and thus any redundant description will be omitted.

Referring to FIGS. 5A and 5B, a light source 100N3 may include a pixel region PXR including a plurality of pixels PX. In the light source 100N3, the plurality of pixels PX may include pixels having various structures described with reference to FIGS. 2A to 2M or at least two pixels having different structures selected from among pixels having various structures that are modified and changed within the scope of the disclosure. For example, in the light source 100N3, the plurality of pixels PX may include a first pixel PX3A1 and a second pixel PX3A2, which are illustrated in FIG. 5B. The first pixel PX3A1 and the second pixel PX3A2 may respectively have the same configurations as the first pixel PXA1 and the second pixel PXA2 described with reference to FIG. 2A.

In an X-Y plan view, a center axis of an optical guide light-emitting structure CX of each of the plurality of pixels PX included in the light source 100N3 and a center axis of a lens 190 corresponding thereto may be misaligned from each other in a lateral direction (e.g., X direction). FIGS. 5A and 5B illustrate a structure in which center axes LXC1 and LXC2 of lenses 190 corresponding to the first pixel PX3A1 and the second pixel PX3A2 are misaligned in a +X direction from center axes RXC1 and RXC2 of the optical guide light-emitting structures CX of the first pixel PX3A1 and the second pixel PX3A2. As illustrated in FIG. 5B, a center axis in a first direction (Z direction) of each of first and second optical path guide surfaces CV and CC included in the optical guide light-emitting structure CX may be misaligned in a lateral direction (e.g., +X direction) from a center axis in the first direction (Z direction) of a lens 190 corresponding thereto.

FIG. 6A is a schematic perspective view illustrating examples of shapes of the semiconductor light-emitting structure 110 and the transparent electrode layer 130 of the light source 100A illustrated in FIG. 2A, and FIG. 6B is a schematic plan view of the semiconductor light-emitting structure 110.

Referring to FIGS. 6A and 6B, in a plan view (X-Y plane), a first conductivity type semiconductor layer 112, an active layer 114, and a second conductivity type semiconductor layer 116, which are included in the semiconductor light-emitting structure 110, and the transparent electrode layer 130 may each have a tetragonal plane shape. In a lateral direction (e.g., X direction or Y direction) parallel with a main surface 102M (refer to FIG. 2A) of a first conductivity type base semiconductor layer 102, a width 110W f the semiconductor light-emitting structure 110 may be about 100 µm or less, about 50 µm or less, about 20 µm or less, about 10 µm or less, about 6 µm or less, about 5 µm or less, about 4 µm or less, or about 2 µm or less, without being limited thereto. In the lateral direction (e.g., X direction or Y direction) parallel with the main surface 102M of the first conductivity type base semiconductor layer 102, a width of the transparent electrode layer 130 may be the same as or similar to the width 110W of the semiconductor light-emitting structure 110.

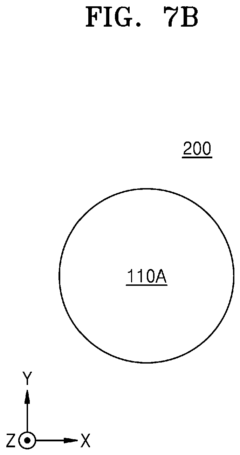

FIGS. 7A and 7B are diagrams of a light source 200 according to one or more embodiments. FIG. 7A is a schematic perspective view illustrating examples of shapes of a semiconductor light-emitting structure 110A and a transparent electrode layer 130 included in the light source 200, and FIG. 7B is a schematic plan view illustrating a plane shape of the semiconductor light-emitting structure 110A. In FIGS. 7A and 7B, the same reference numerals are used to denote the same elements as in FIG. 2A, and thus any redundant description will be omitted.

Referring to FIGS. 7A and 7B, the light source 200 may have substantially the same configuration as the light source 100A described with reference to FIG. 2A. However, the light source 200 may include a semiconductor light-emitting structure 110A instead of the semiconductor light-emitting structure 110. The semiconductor light-emitting structure 110A may include a first conductivity type semiconductor layer 112A, an active layer 114A, and a second conductivity type semiconductor layer 116A.

The first conductivity type semiconductor layer 112A, the active layer 114A, and the second conductivity type semiconductor layer 116A may substantially and respectively have the same configurations as the first conductivity type semiconductor layer 112, the active layer 114, and the second conductivity type semiconductor layer 116 described with reference to FIG. 2A. However, in a plan view (X-Y plane), the first conductivity type semiconductor layer 112A, the active layer 114A, and the second conductivity type semiconductor layer 116A included in the semiconductor light-emitting structure 110A and the transparent electrode layer 130 may each have a circular plane shape.

A local recess 130R may be formed in a surface opposite to a surface of a transparent electrode layer 130 in contact with the semiconductor light-emitting structure 110A. A portion of the reflective electrode layer 170 illustrated in in FIG. 2A may be accommodated in the local recess 130R of the transparent electrode layer 130.

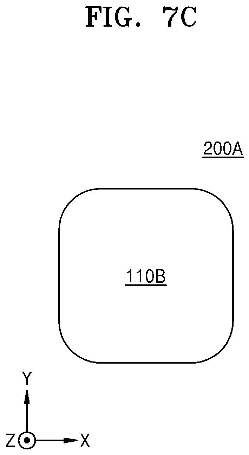

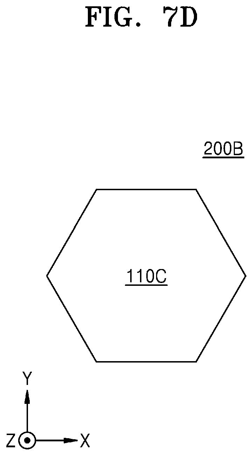

FIGS. 7C and 7D are plan views illustrating light sources 200A and 200B according to one or more embodiments. FIG. 7C is a schematic plan view illustrating examples of plane shapes of a semiconductor light-emitting structure 110B included in the light source 200A, and FIG. 7D is a schematic plan view illustrating examples of plane shapes of a semiconductor light-emitting structure 110C included in the light source 200B.

Referring to FIG. 7C, the light source 200A may have substantially the same configuration as the light source 100A described with reference to FIG. 2A. However, the light source 200A may include the semiconductor light-emitting structure 110B. The semiconductor light-emitting structure 110B may have substantially the same configuration as the semiconductor light-emitting structure 110 described with reference to FIG. 2A. However, in a plan view (X-Y plane), the semiconductor light-emitting structure 110B may have a tetragonal plane shape having rounded corners.

Referring to FIG. 7D, the light source 200B may have substantially the same configuration as the light source 100A described with reference to FIG. 2A. However, the light source 200B may include the semiconductor light-emitting structure 110C. The semiconductor light-emitting structure 110C may have substantially the same configuration as the semiconductor light-emitting structure 110 described with reference to FIG. 2A. However, in a plan view (X-Y plane), the semiconductor light-emitting structure 110C may have a hexagonal plane shape.

FIGS. 8, 9, and 10 are respectively partially cut-away cross-sectional views of light sources 300A, 300B, and 300C according to one or more embodiments. In FIGS. 8, 9, and 10, the same reference numerals are used to denote the same elements as in FIG. 2A, and thus any redundant description will be omitted.

Referring to FIG. 8, the light source 300A may have substantially the same configuration as the light source 100A described with reference to FIG. 2A. However, in the light source 300A, a sidewall of each of a first conductivity type semiconductor layer 112, an active layer 114, and a second conductivity type semiconductor layer 116 included a semiconductor light-emitting structure 110 and a sidewall of a transparent electrode layer 130 may be covered by a reflective structure 350. In a plan view (X-Y plane in FIG. 1), the semiconductor light-emitting structure 110 and the transparent electrode layer 130 may be surrounded by the reflective structure 350. The reflective structure 350 may include a distributed Bragg reflector (DBR).

The reflective structure 350 may have a DBR structure in which a first insulating layer 350A, a second insulating layer 350B, a third insulating layer 350C, and a fourth insulating layer 350D are sequentially stacked. Herein, the first insulating layer 350A and the third insulating layer 350C may include a first insulating material, and the second insulating layer 350B and the fourth insulating layer 350D may include a second insulating material. The first insulating material and the second insulating material may have different refractive indexes from each other. The refractive indexes may be measured at the wavelength of the light emitted from the semiconductor light-emitting structure 110 (e.g., at a visible range of the electromagnetic spectrum (e.g., having a wavelength from about 400 nm to about 700 nm)). In one or more embodiments, the first insulating material and the second insulating material may include different materials from each other selected from SiO₂, SiON, TiO₂, Si₃N₄, Al₂O₃, TiN, AlN, ZrO₂, TiAlN, TiSiN, HfO, NbO₂, TaO₂, and MgF₂.

The first insulating layer 350A of the reflective structure 350 may be in contact with a sidewall of each of the semiconductor light-emitting structure 110 and the transparent electrode layer 130. In one or more embodiments, the first insulating layer 350A may include a material having strengthened total reflection characteristics (e.g., improved total internal reflection characteristics at a boundary with the semiconductor light-emitting structure 110 and/or the transparent electrode layer 130). In one or more embodiments, the first insulating layer 350A may include an insulating material having a refractive index less than or equal to a refractive index of the semiconductor light-emitting structure 110 and/or the transparent electrode layer 130. The refractive indexes may be measured at the wavelength of the light emitted from the semiconductor light-emitting structure 110 (e.g., at a visible range of the electromagnetic spectrum (e.g., having a wavelength from about 400 nm to about 700 nm)). As an example, the first insulating layer 350A may include SiO₂ or MgF₂, without being limited thereto. Each of the first insulating layer 350A, the second insulating layer 350B, the third insulating layer 350C, and the fourth insulating layer 350D of the reflective structure 350 may have a thickness of about 10 nm to about 200 nm.

The reflective structure 350 may reflect light traveling from the inside of the semiconductor light-emitting structure 110 to the sidewall thereof to adjust the light distribution. As the reflective structure 150 includes a DBR, the reflective structure 150 may act as a band pass filter (BPF) suppressing the transmission of light of a particular wavelength and cause a transmittance difference according to an incident angle, and thus, the light distribution may be effectively adjusted. In addition, the reflective structure 150 may cause a relatively significant increase in the intensity of light emitted from a particular region by using the transmittance difference according to an incident angle of light emitted from the semiconductor light-emitting structure 110.

Referring to FIG. 9, the light source 300B may have substantially the same configuration as the light source 300A described with reference to FIG. 8. However, the light source 300B may include a transparent electrode layer 330 instead of the transparent electrode layer 130.

The transparent electrode layer 330 may have substantially the same configuration as the transparent electrode layer 130 described with reference to FIG. 2A. However, in the transparent electrode layer 330, a first surface 330A facing a second conductivity type semiconductor layer 116 and a second surface 330B facing A reflective electrode layer 170 may each extend flat in a lateral direction (e.g., X direction and/or Y direction), and the transparent electrode layer 330 may have a generally consistent thickness in the lateral direction. In one or more embodiments, in a first direction (Z direction), the transparent electrode layer 330 may have a thickness of about 50 nm to about 150 nm, for example, a thickness of 100 nm, without being limited thereto.

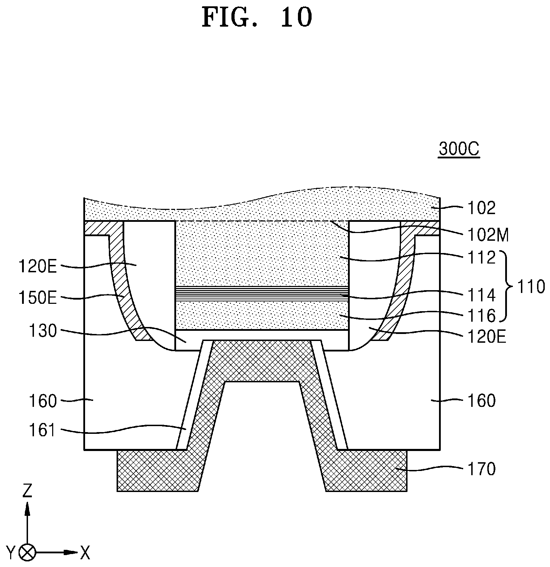

Referring to FIG. 10, the light source 300C may have substantially the same configuration as the light source 100A described with reference to FIG. 2A. However, the light source 300C may include an insulating spacer 120E and a reflective structure 150E instead of the reflective structure 150. Each of the insulating spacer 120E and the reflective structure 150E may cover a sidewall of each of a first conductivity type semiconductor layer 112, an active layer 114, and a second conductivity type semiconductor layer 116 included in a semiconductor light-emitting structure 110 in a lateral direction parallel with a main surface 102M (refer to FIG. 2A) of a first conductivity type base semiconductor layer 102.

The insulating spacer 120E may be in contact with the sidewall of each of the first conductivity type semiconductor layer 112, the active layer 114, and the second conductivity type semiconductor layer 116 included in the semiconductor light-emitting structure 110 and a sidewall of a transparent electrode layer 130. The reflective structure 150E may be apart (e.g., spaced apart) from each of the semiconductor light-emitting structure 110 and the transparent electrode layer 130 with the insulating spacer 120E therebetween.

In one or more embodiments, the insulating spacer 120E may include SiO₂, SiON, TiO₂, Si₃N₄, Al₂O₃, TiN, AlN, ZrO₂, TiAlN, TiSiN, HfO, NbO₂, TaO₂, MgF₂, or a combination thereof. The reflective structure 150E may include a metal. For example, the reflective structure 150E may include silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), gold (Au), titanium (Ti), titanium nitride (TiN), tantalum (Ta), tantalum nitride (TaN), tungsten (W), or a combination thereof.

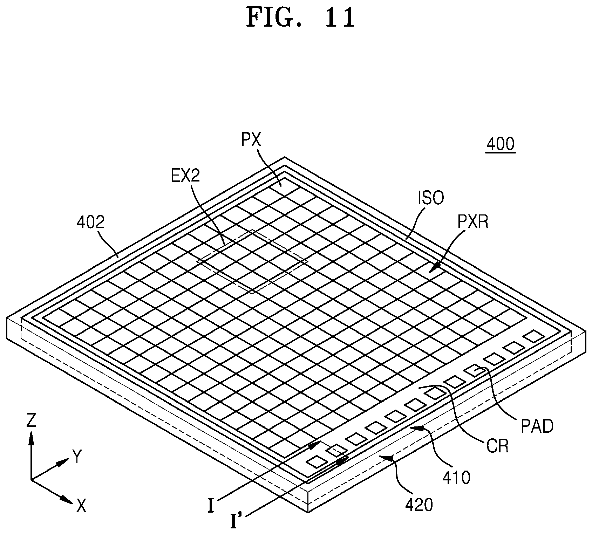

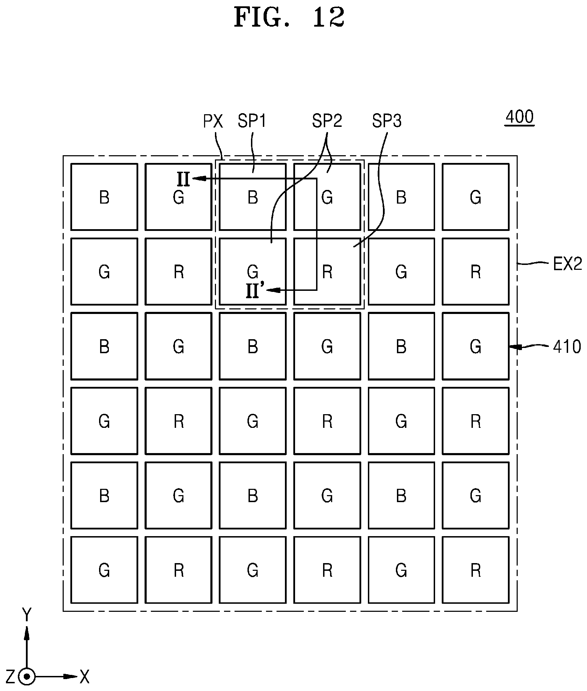

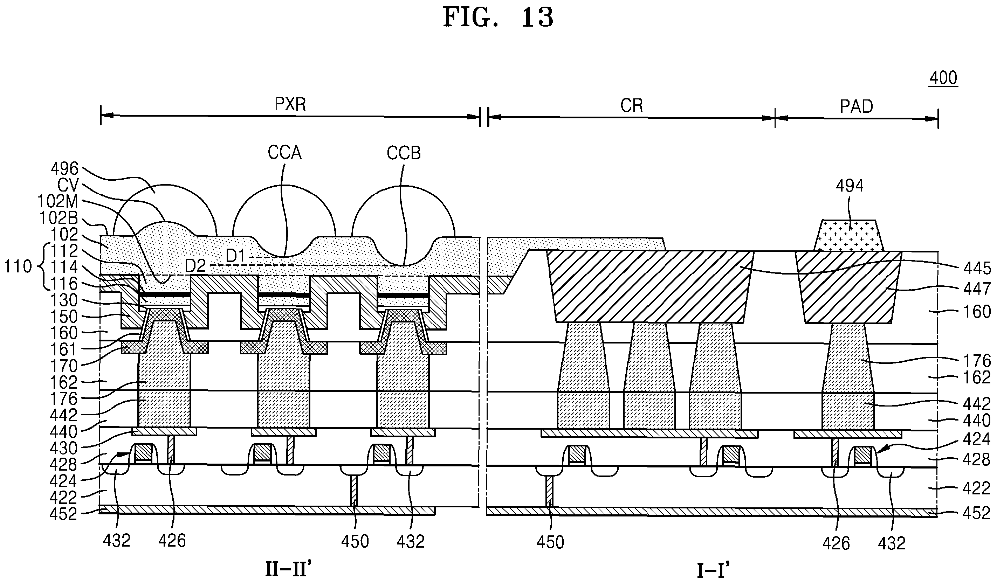

FIGS. 11 to 13 are diagrams illustrating a display device 400 according to one or more embodiments. FIG. 11 is a schematic perspective view of the display device 400, FIG. 12 is an enlarged plan view of a portion denoted by "EX2" in FIG. 11, and FIG. 13 is a cross-sectional view schematically illustrating components of a portion corresponding to a cross-section taken along line I-I' in FIG. 11 and a portion corresponding to a cross-section taken along line II-II' in FIG. 12. In FIGS. 11 to 13, the same reference numerals are used to denote the same elements as in FIGS. 1 to 2A, and thus any redundant description will be omitted.

Referring to FIGS. 11 to 13, the display device 400 may include a pixel array 410 and a circuit board 420 which are arranged to overlap each other in a first direction (Z direction in FIG. 11). The circuit board 420 may include driver circuits. The pixel array 410 may include a plurality of pixels PX arranged in a pixel region PXR on the circuit board 420. The display device 400 may further include a frame 402 surrounding the pixel array 410 and the circuit board 420.

The circuit board 420 may be a driver circuit board including a plurality of transistors. In one or more embodiments, the circuit board 420 may include an application-specific integrated circuit (ASIC) including a plurality of driver circuits. In one or more embodiments, the circuit board 420 may include a flexible substrate. In this case, the display device 400 may be implemented as a variable or curved display device.

The pixel array 410 may include the pixel region PXR in which the plurality of pixels PX are arranged, a plurality of contact pad regions PAD in which a contact pad electrode 494 is arranged, a connection region CR for interconnecting the pixels PX to the contact pad electrode 494, and an edge region ISO.

The plurality of pixels PX may include a plurality of first subpixels SP1, a plurality of second subpixels SP2, and a plurality of third subpixels SP3, which are each configured to emit light of a particular wavelength, for example, light of a particular color. The plurality of first subpixels SP1, the plurality of second subpixels SP2, and the plurality of third subpixels SP3 may each include a structure selected from various pixels described with reference to FIGS. 2A to 2M.

In one or more embodiments, the first to third subpixels SP1, SP2, and SP3 may respectively be configured to emit blue (B) light, green (G) light, and red (R) light. In one or more embodiments, each of the plurality of pixels PX may include the first to third subpixels SP1, SP2, and SP3 arranged in a Bayer pattern. That is, each of the plurality of pixels PX may include the first and third subpixels SP1 and SP3 arranged in a first diagonal direction and two second subpixels SP2 arranged in a second diagonal direction intersecting with the first diagonal direction. FIG. 12 illustrates that the first to third subpixels SP1, SP2, and SP3 are arranged in a 2X2 Bayer pattern in each of the plurality of pixels PX, without being limited thereto. For example, each of the plurality of pixels PX may have other arrangements, such as 3X3, 4X4, etc. In other one or more embodiments, some of the plurality of pixels PX may be configured to emit light having a color other than red (R), green (G), and blue (B), for example, yellow light. FIG. 11 illustrates that in the pixel array 410, the plurality of pixels PX are in a 15X15 arrangement along the first lateral direction (X direction) and a second lateral direction (Y direction), without being limited thereto. The pixel array 410 may include a proper number of pixels PX along a column direction and a row direction, for example, a plurality of pixels PX having a 1,024 X 768 arrangement.

The plurality of contact pad regions PAD may be arranged along an edge of the display device 400 on at least one side of the pixel region PXR. The plurality of contact pad regions PAD may be electrically connected to the plurality of pixels PX and the driver circuits of the circuit board 420. The display device 400 may be electrically connected to an external device through the plurality of contact pad regions PAD. The number of the contact pad regions PAD included in the display device 400 may vary. In one or more embodiments, the number of the contact pad regions PAD included in the display device 400 may be determined according to the number of the pixels PX included in the pixel array 410, a driving method of the driver circuit included in the circuit board 420, etc.

The connection region CR may be arranged between the pixel region PXR and the plurality of contact pad regions PAD. Wiring structures electrically connected to the plurality of pixels PX and a common electrode 445 may be arranged in the connection region CR.

The edge region ISO of the display device 400 may be a region along edges of the pixel array 410. A semiconductor light-emitting structure 110 may not be arranged in the edge region ISO.

The frame 402 of the display device 400 may be arranged around the pixel array 410 and serve as a guide defining a space in which the pixel array 410 is arranged. The frame 402 may include polymer, ceramic, semiconductor, metal, or a combination thereof.

As illustrated in FIG. 13, the circuit board 420 may include a semiconductor substrate 422, a driver circuit formed on the semiconductor substrate 422 and including a plurality of driver devices 424 including transistors, a plurality of interconnections 426 electrically connected to the plurality of driver devices 424, and a plurality of wiring lines 430 connected to the plurality of interconnections 426. The plurality of driver devices 424 constituting the driver circuit, the plurality of interconnections 426, and the plurality of wiring lines 430 may be covered by an insulating layer 428. The circuit board 420 may further include a first bonding insulating layer 440 on the insulating layer 428 and a plurality of first bonding electrodes 442 passing through the first bonding insulating layer 440 and connected to the plurality of wiring lines 430.

The semiconductor substrate 422 may include a plurality of impurity regions 432 constituting source region/drain regions of the plurality of transistors constituting the plurality of driver devices 424. The semiconductor substrate 422 may include a semiconductor such as silicon (Si) or germanium (Ge) or a compound semiconductor such as SiGe, SiC, GaAs, InAs, or InP. The semiconductor substrate 422 may further include a plurality of through electrodes 450 (e.g., through silicon vias (TSVs)) connected to the driver circuit and a plurality of substrate wiring lines 452 connected to the plurality of through electrodes 450.

The driver circuit may be a circuit for controlling the drive of the pixels PX or the first to third subpixels SP1, SP2, and SP3. Some of the plurality of impurity regions 432 may be electrically connected to at least one of the first to third subpixels SP1, SP2, and SP3 through the interconnections 426, the wiring lines 430, and the first bonding electrodes 442. In one or more embodiments, some of the plurality of impurity regions 432 may be connected to one substrate wiring line 452 from among the plurality of substrate wiring lines 452 through the through electrode 450.

Upper surfaces of the plurality of first bonding electrodes 442 and an upper surface of the first bonding insulating layer 440 may constitute an upper surface of the circuit board 420. The plurality of first bonding electrodes 442 included in the circuit board 420 may be bonded to a plurality of second bonding electrodes 176 included in the pixel array 410 and provide an electrical connection path. In one or more embodiments, the plurality of first bonding electrodes 442 and the plurality of second bonding electrodes 176 may each include a copper (Cu) film. Each of the plurality of first bonding electrodes 442 and the plurality of second bonding electrodes 176 may further include a barrier metal layer surrounding the copper (Cu) film. The barrier metal layer may include Ta, TaN, or a combination thereof.

The first bonding insulating layer 440 included in the circuit board 420 may be bonded to a second bonding insulating layer 162 included in the pixel array 410. Each of the first bonding insulating layer 440 and the second bonding insulating layer 162 may include SiO, SiN, SiCN, SiOC, SiON, SiOCN, or a combination thereof.

In the pixel array 410, each of the first to third subpixels SP1, SP2, and SP3 may include the semiconductor light-emitting structure 110 described with reference to FIG. 1. In the pixel array 410, a plurality of semiconductor light-emitting structures 110 may be arranged apart (e.g., spaced apart) from each other in a lateral direction parallel with a main surface 102M of a first conductivity type base semiconductor layer 102. Each of the plurality of semiconductor light-emitting structures 110 may include a first conductivity type semiconductor layer 112, an active layer 114, and a second conductivity type semiconductor layer 116, which are sequentially stacked in a first direction (Z direction) perpendicular to the main surface 102M of the first conductivity type base semiconductor layer 102. Detailed configurations of the first conductivity type semiconductor layer 112, the active layer 114, and the second conductivity type semiconductor layer 116 are the same as described above with reference to FIG. 2A.

A rear surface 102B of the first conductivity type base semiconductor layer 102 may include a plurality of optical path guide surfaces. For example, as illustrated in FIG. 13, the rear surface 102B of the first conductivity type base semiconductor layer 102 may include a first optical path guide surface CV, a second optical path guide surface CCA, and a third optical path guide surface CCB included in the first to third subpixels SP1, SP2, and SP3. The first optical path guide surface CV, the second optical path guide surface CCA, and the third optical path guide surface CCB may include non-flat surfaces having different shapes. A detailed configuration of the first optical path guide surface CV is the same as described with reference to FIG. 2A. The second optical path guide surface CCA and the third optical path guide surface CCB may have substantially the same configuration as the second optical path guide surface CC described with reference to FIG. 2A. However, a vertical level D1 of a lowermost surface of the second optical path guide surface CCA may be closer to a vertical level of a flat portion of the rear surface 102B of the first conductivity type base semiconductor layer 102 than a vertical level D2 of a lowermost surface of the third optical path guide surface CCB. Accordingly, a first maximum length in the first direction (Z direction) of a concave portion defined by the second optical path guide surface CCA may be less than a second maximum length in the first direction (Z direction) of a concave portion defined by the third optical path guide surface CCB.

A plurality of lenses 496 may be arranged on the rear surface 102B of the first conductivity type base semiconductor layer 102. Each of the plurality of lenses 496 may be in contact with the rear surface 102B of the first conductivity type base semiconductor layer 102. The plurality of lenses 496 may be arranged to overlap the plurality of semiconductor light-emitting structures 110 in a direction perpendicular to the main surface 102M of the first conductivity type base semiconductor layer 102. A detailed configuration of the plurality of lenses 496 is substantially the same as that of the lens 190 described with reference to FIG. 2A.

The pixel array 410 of the display device 400 may further include a plurality of transparent electrode layers 130, a reflective structure 150, and a reflective electrode layer 170 passing through the reflective structure 150 and in contact with the transparent electrode layer 130. Detailed configurations of the transparent electrode layer 130, the reflective structure 150, and the reflective electrode layer 170 are the same as described above with reference to FIG. 2A.

The plurality of semiconductor light-emitting structures 110 included in the pixel array 410 of the display device 400 may be configured to emit light having a wavelength (λ) selected within a range from about 400 nm to about 700 nm, for example, a wavelength (λ) selected within a range from about 490 nm to about 700 nm.

In the pixel array 410 of the display device 400, the plurality of second bonding electrodes 176 may be connected to a plurality of reflective electrode layers 170, and the second bonding insulating layer 162 surrounding the plurality of second bonding electrodes 176 may be in contact with a portion of the reflective electrode layer 170 and may be in contact with the insulating layer 160 covering the reflective structure 150.

The display device 400 may further include a common electrode 445 and an inner pad electrode 447. In the pixel array 410, the insulating layer 160 covering the reflective electrode layer 170 may extend to the connection region CR and the contact pad regions PAD to cover the common electrode 445 and the inner pad electrode 447. A contact pad electrode 494 may be arranged on the inner pad electrode 447 in the contact pad region PAD.

The plurality of second bonding electrodes 176 may be connected to the common electrode 445. The common electrode 445 may have a ring shape or a tetragonal ring shape surrounding a pixel region PXR in a plan view parallel with the main surface 102M of the first conductivity type base semiconductor layer 102. However, the arrangement of the common electrode 445 may be variously modified and changed according to a need.

The inner pad electrode 447 may be in contact with the contact pad electrode 494. The inner pad electrode 447 may be arranged between the contact pad electrode 494 and the second bonding electrode 176 and may interconnect the contact pad electrode 494 and the second bonding electrode 176. The common electrode 445 and the inner pad electrode 447 may include a conductive material, for example, silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), gold (Au), or a combination thereof.

The contact pad electrode 494 may be connected to an external device or an external integrated circuit (IC) which may apply an electric signal to the circuit board 420 through wire bonding or anisotropic conductive film (AFC) bonding. The contact pad electrode 494 may electrically connect the external device to the driver circuits of the circuit board 420. The contact pad electrode 494 may include a metal, for example, gold (Au), silver (Ag), nickel (Ni), etc.

The second bonding electrode 176 arranged in the pixel region PXR, from among the plurality of second bonding electrodes 176, may be connected to the reflective electrode layer 170, the second bonding electrode 176 arranged in the connection region CR, from among the plurality of second bonding electrodes 176, may be connected to the common electrode 445, and the second bonding electrode 176 arranged in the contact pad region PAD, from among the plurality of second bonding electrodes 176, may be connected to the inner pad electrode 447.

A surface of the second bonding insulating layer 162 which faces the circuit board 420 and surfaces of the plurality of second bonding electrodes 176 which face the circuit board 420 may extend on one plane. The second bonding insulating layer 162 may form a dielectric-dielectric bonding along with the first bonding insulating layer 440. The circuit board 420 and the pixel array 410 may be bonded to each other by the bonding between the plurality of first bonding electrodes 442 and the plurality of second bonding electrodes 176 and the bonding between the first bonding insulating layer 440 and the second bonding insulating layer 162.

In one or more embodiments, the bonding between the plurality of first bonding electrodes 442 and the plurality of second bonding electrodes 176 may be, for example, copper (Cu)-copper (Cu) bonding, and the bonding between the first bonding insulating layer 440 and the second bonding insulating layer 162 may be dielectric-dielectric bonding such as SiCN-SiCN bonding. The circuit board 420 and the pixel array 410 may be bonded by hybrid bonding including copper (Cu)-copper (Cu) bonding and dielectric-dielectric bonding or may be bonded without a separate bonding layer.

The display device 400 according to the embodiment may include the plurality of semiconductor light-emitting structures 110 and a plurality of optical path guide surfaces included in the rear surface 102B of the first conductivity type base semiconductor layer 102 on the plurality of semiconductor light-emitting structures 110. The first optical path guide surface CV, the second optical path guide surface CCA, and the third optical path guide surface CCB are illustrated as examples of the plurality of optical path guide surfaces in FIG. 13, without being limited thereto. The plurality of optical path guide surfaces may include optical path guide surfaces having various structures described with reference to FIGS. 2A to 2M, for example, at least two optical path guide surfaces having different structures selected from the first optical path guide surfaces CV, CC1A, CV1A, and CN1A, the second optical path guide surfaces CC, CC1B, CV1B, and CN1B, and the optical path guide surfaces FTS and CF, which are illustrated in FIGS. 2A to 2M, and optical path guide surfaces having structures that are variously modified and changed within the scope of the disclosure.

In the display device 400, the plurality of semiconductor light-emitting structures 110 may be arranged to overlap the plurality of optical path guide surfaces in the first direction (Z direction). In the first to third subpixels SP1, SP2, and SP3 included in each of the plurality of pixels PX, red light, green light, or blue light may be controlled such that a focal length of red light, green light, or blue light passing through one of the plurality of optical path guide surfaces is located at a desired position. As described above, because the first to third subpixels SP1, SP2, and SP3 included in the plurality of pixels PX include the plurality of optical path guide surfaces having different shapes, focal lengths of light emitted by the plurality of pixels PX through the lens 496 may be controlled to be substantially the same as or similar to each other. Thus, light extraction efficiency (or LEE) of the display device 400 may be optimized. Accordingly, the display device 400 having a structure optimized to a micro-sized chip may be provided.

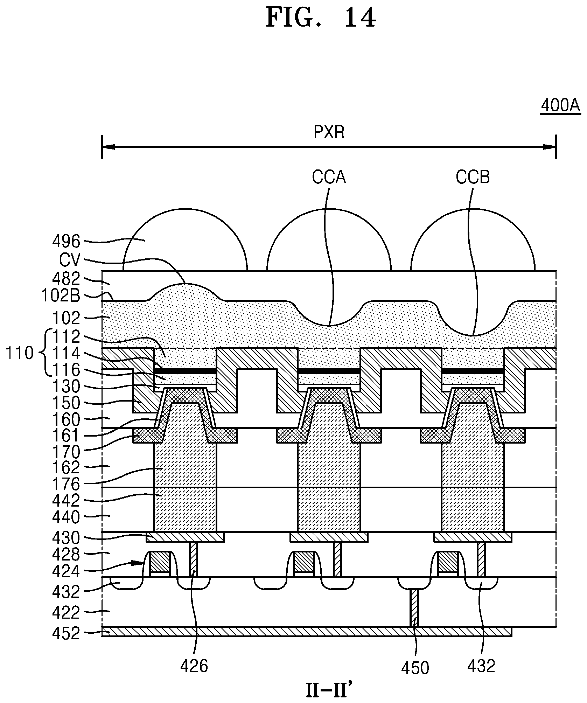

FIGS. 14 to 23 are respectively cross-sectional views of display devices 400A, 400B, 500, 500A, 500B, 600, 600A, 600B, 700, and 800 according to one or more embodiments. In FIGS. 14 to 23, the same reference numerals are used to denote the same elements as in FIGS. 1 to 13, and thus any redundant description will be omitted.

Referring to FIG. 14, the display device 400A may have substantially the same configuration as the display device 400 described with reference to FIGS. 11 to 13. However, the display device 400A may further include a transparent layer 482 between a first optical path guide surface CV, a second optical path guide surface CCA, and a third optical path guide surface CCB of a first conductivity type base semiconductor layer 102 and a plurality of lenses 496, which respectively face the first optical path guide surface CV, the second optical path guide surface CCA, and the third optical path guide surface CCB. A detailed configuration of the transparent layer 482 is the same as the transparent layer 182 described above with reference to FIG. 2B.

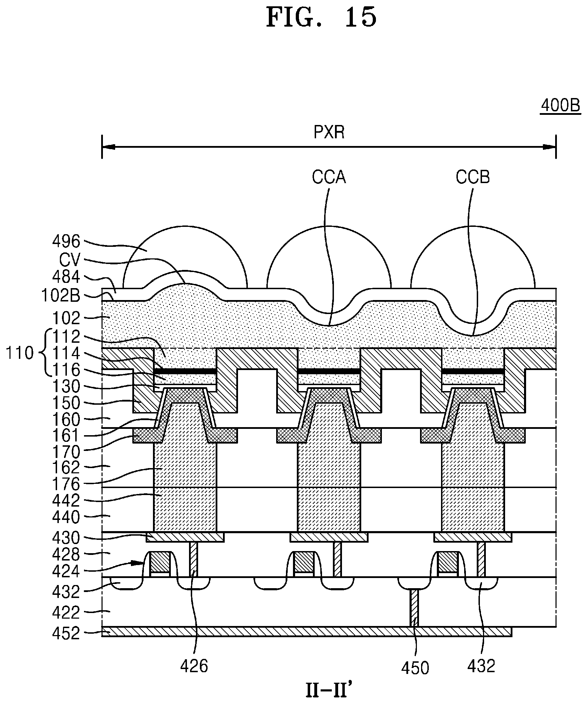

Referring to FIG. 15, the display device 400B may have substantially the same configuration as the display device 400 described with reference to FIGS. 11 to 13. However, the display device 400B may further include a transparent layer 484 between a first optical path guide surface CV, a second optical path guide surface CCA, and a third optical path guide surface CCB of a first conductivity type base semiconductor layer 102 and a plurality of lenses 496, which respectively face the first optical path guide surface CV, the second optical path guide surface CCA, and the third optical path guide surface CCB. A detailed configuration of the transparent layer 484 is the same as the transparent layer 184 described above with reference to FIG. 2C.

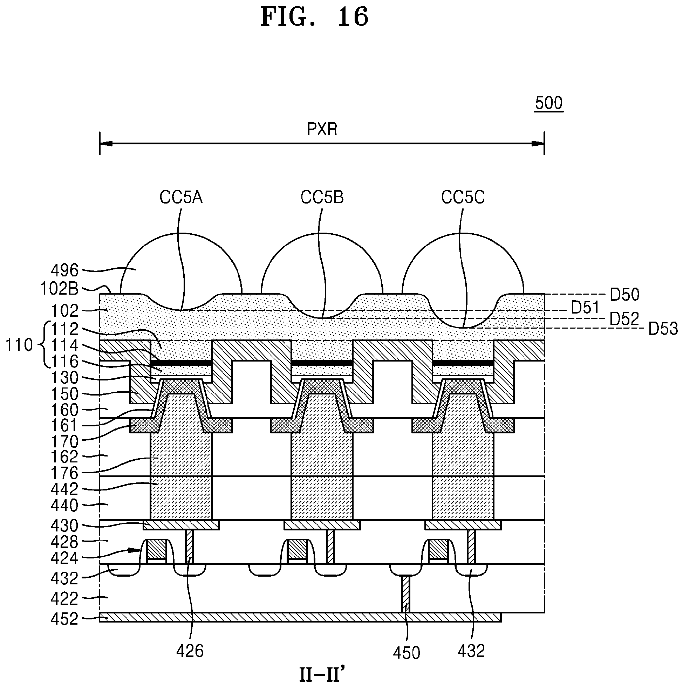

Referring to FIG. 16, the display device 500 may have substantially the same configuration as the display device 400 described with reference to FIGS. 11 to 13. However, in the display device 500, a rear surface 102B of a first conductivity type base semiconductor layer 102 may include a first optical path guide surface CC5A, a second optical path guide surface CC5B, and a third optical path guide surface CC5C included in a plurality of pixels PX. The first optical path guide surface CC5A, the second optical path guide surface CC5B, and the third optical path guide surface CC5C may include non-flat surfaces having different shapes. The first optical path guide surface CC5A, the second optical path guide surface CC5B, and the third optical path guide surface CC5C may have substantially the same configuration as the second optical path guide surface CC described with reference to FIG. 2A. However, a vertical level D51 of a lowermost surface of the first optical path guide surface CC5A may be closer to a vertical level D50 of a flat portion of the rear surface 102B of the first conductivity type base semiconductor layer 102 than a vertical level D52 of a lowermost surface of the second optical path guide surface CC5B, and the vertical level D52 of the lowermost surface of the second optical path guide surface CC5B may be closer to the vertical level D50 of the flat portion of the rear surface 102B of the first conductivity type base semiconductor layer 102 than a vertical level D53 of a lowermost surface of the third optical path guide surface CC5C. Accordingly, a first maximum length in a first direction (Z direction) of a concave portion defined by the first optical path guide surface CC5A may be less than a second maximum length in the first direction (Z direction) of a concave portion defined by the second optical path guide surface CC5B, and the second maximum length may be less than a third maximum length in the first direction (Z direction) of a concave portion defined by the third optical path guide surface CC5C.

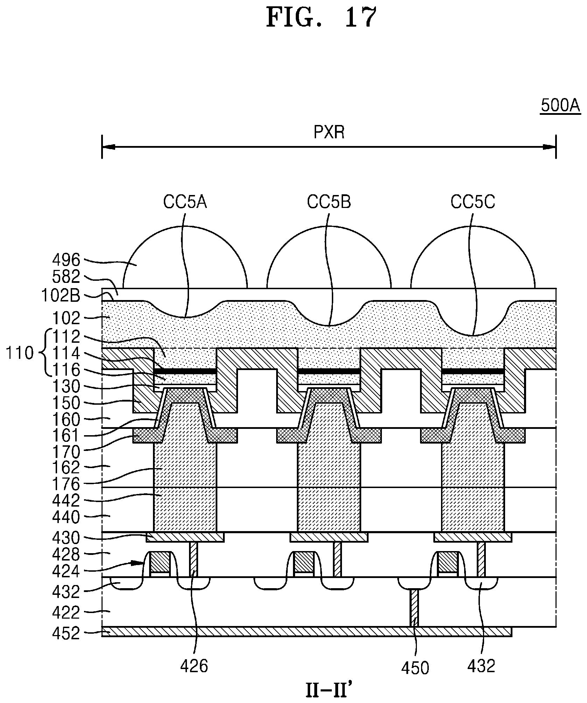

Referring to FIG. 17, the display device 500A may have substantially the same configuration as the display device 500 described with reference to FIG. 16. However, the display device 500A may further include a transparent layer 582 between a first optical path guide surface CC5A, a second optical path guide surface CC5B, and a third optical path guide surface CC5C of a first conductivity type base semiconductor layer 102 and a plurality of lenses 496, which respectively face the first optical path guide surface CC5A, the second optical path guide surface CC5B, and the third optical path guide surface CC5C. A detailed configuration of the transparent layer 582 is the same as the transparent layer 182 described above with reference to FIG. 2B.

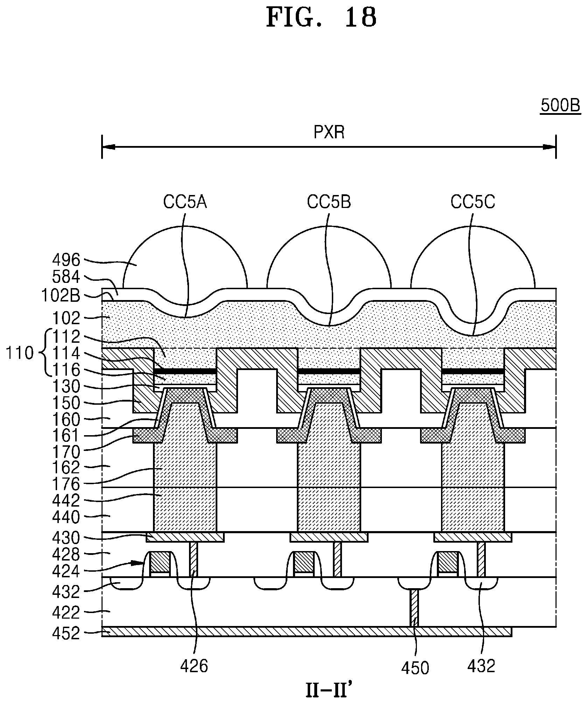

Referring to FIG. 18, the display device 500B may have substantially the same configuration as the display device 500 described with reference to FIG. 16. However, the display device 500B may further include a transparent layer 584 between a first optical path guide surface CC5A, a second optical path guide surface CC5B, and a third optical path guide surface CC5C of a first conductivity type base semiconductor layer 102 and a plurality of lenses 496, which respectively face the first optical path guide surface CC5A, the second optical path guide surface CC5B, and the third optical path guide surface CC5C. A detailed configuration of the transparent layer 584 is the same as the transparent layer 184 described above with reference to FIG. 2C.

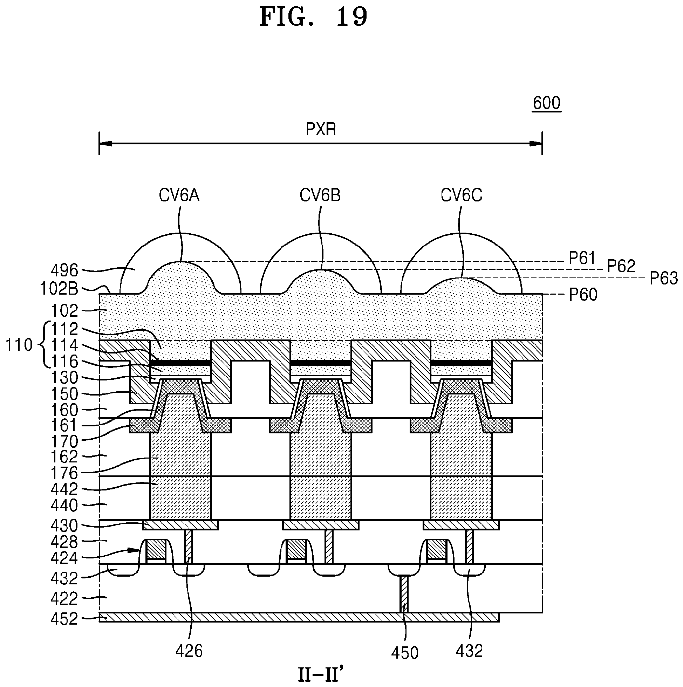

Referring to FIG. 19, the display device 600 may have substantially the same configuration as the display device 400 described with reference to FIGS. 11 to 13. However, in the display device 600, a rear surface 102B of a first conductivity type base semiconductor layer 102 may include a first optical path guide surface CV6A, a second optical path guide surface CV6B, and a third optical path guide surface CV6C included in a plurality of pixels PX. The first optical path guide surface CV6A, the second optical path guide surface CV6B, and the third optical path guide surface CV6C may include non-flat surfaces having different shapes.

The first optical path guide surface CV6A, the second optical path guide surface CV6B, and the third optical path guide surface CV6C may each have substantially the same configuration as the first optical path guide surface CV described with reference to FIG. 2A. However, a vertical level P61 of an uppermost surface of the first optical path guide surface CV6A may be farther from a vertical level P60 of a flat portion of the rear surface 102B of the first conductivity type base semiconductor layer 102 than a vertical level P62 of an uppermost surface of the second optical path guide surface CV6B. The vertical level P62 of the uppermost surface of the second optical path guide surface CV6B may be farther from the vertical level P60 of the flat portion of the rear surface 102B of the first conductivity type base semiconductor layer 102 than a vertical level P63 of an uppermost surface of the third optical path guide surface CV6C. Accordingly, a first maximum length in a first direction (Z direction) of a first convex portion defined by the first optical path guide surface CV6A may be greater than a second maximum length in the first direction (Z direction) of a second convex portion defined by the second optical path guide surface CV6B, and the second maximum length may be greater than a third maximum length in the first direction (Z direction) of a third convex portion defined by the third optical path guide surface CV6C.

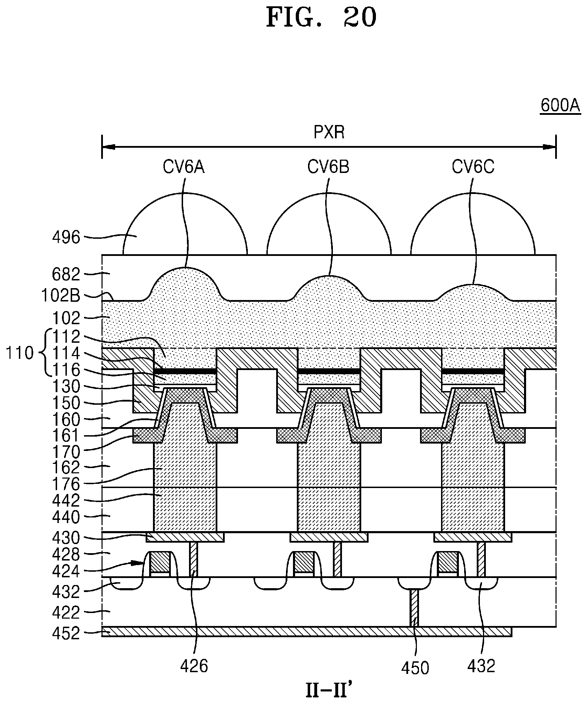

Referring to FIG. 20, the display device 600A may have substantially the same configuration as the display device 600 described with reference to FIG. 19. However, the display device 600A may further include a transparent layer 682 between a first optical path guide surface CV6A, a second optical path guide surface CV6B, and a third optical path guide surface CV6C of a first conductivity type base semiconductor layer 102 and a plurality of lenses 496, which respectively face the first optical path guide surface CV6A, the second optical path guide surface CV6B, and the third optical path guide surface CV6C. A detailed configuration of the transparent layer 682 is the same as the transparent layer 182 described above with reference to FIG. 2B.

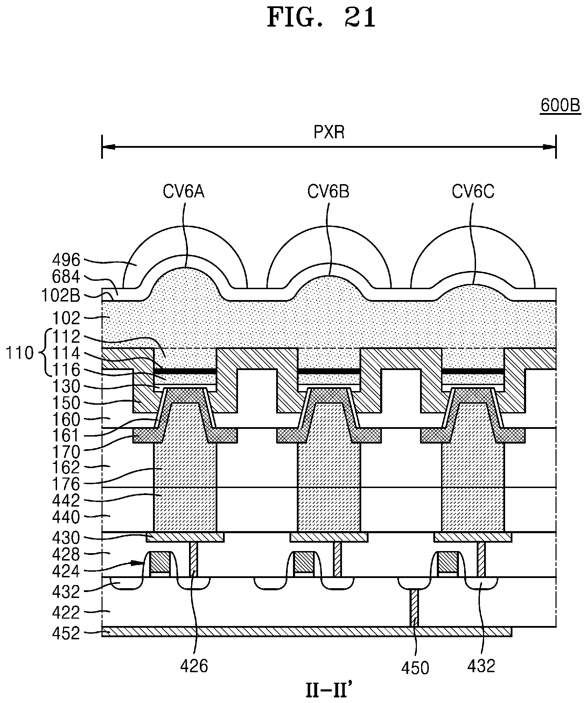

Referring to FIG. 21, the display device 600B may have substantially the same configuration as the display device 600 described with reference to FIG. 19. However, the display device 600B may further include a transparent layer 684 between a first optical path guide surface CV6A, a second optical path guide surface CV6B, and a third optical path guide surface CV6C of a first conductivity type base semiconductor layer 102 and a plurality of lenses 496, which respectively face the first optical path guide surface CV6A, the second optical path guide surface CV6B, and the third optical path guide surface CV6C. A detailed configuration of the transparent layer 684 is the same as the transparent layer 184 described above with reference to FIG. 2C.

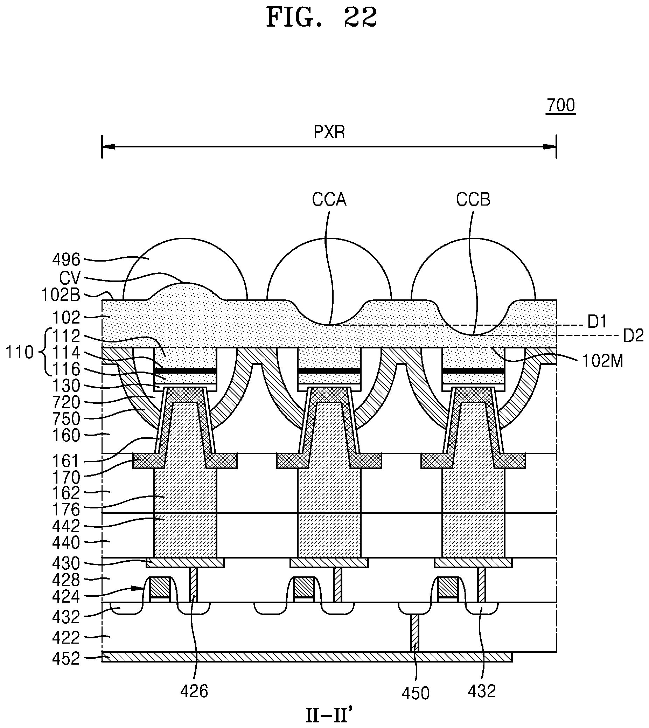

Referring to FIG. 22, the display device 700 may have substantially the same configuration as the display device 400 described with reference to FIGS. 11 to 13. However, the display device 700 may include an insulating spacer 720 and a reflective structure 750. Each of the insulating spacer 720 and the reflective structure 750 may cover a sidewall of each of a first conductivity type semiconductor layer 112, an active layer 114, and a second conductivity type semiconductor layer 116 included in a semiconductor light-emitting structure 110 in a lateral direction parallel with a main surface 102M of a first conductivity type base semiconductor layer 102. The insulating spacer 720 may include a portion in contact with a sidewall and an upper surface of a transparent electrode layer 130. A reflective electrode layer 170 may be in contact with the transparent electrode layer 130 by passing through the reflective structure 750 and the insulating spacer 720.

The insulating spacer 720 may be in contact with the sidewall of each of the first conductivity type semiconductor layer 112, the active layer 114, and the second conductivity type semiconductor layer 116 included in the semiconductor light-emitting structure 110 and the sidewall of the transparent electrode layer 130. The reflective structure 750 may be apart (e.g., spaced apart) from each of the semiconductor light-emitting structure 110 and the transparent electrode layer 130 with the insulating spacer 720 therebetween.

In one or more embodiments, the insulating spacer 720 may include SiO₂, SiON, TiO₂, Si₃N₄, Al₂O₃, TiN, AlN, ZrO₂, TiAlN, TiSiN, HfO, NbO₂, TaO₂, MgF₂, or a combination thereof. The reflective structure 750 may include a metal. For example, the reflective structure 750 may include silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), gold (Au), titanium (Ti), titanium nitride (TiN), tantalum (Ta), tantalum nitride (TaN), tungsten (W), or a combination thereof.

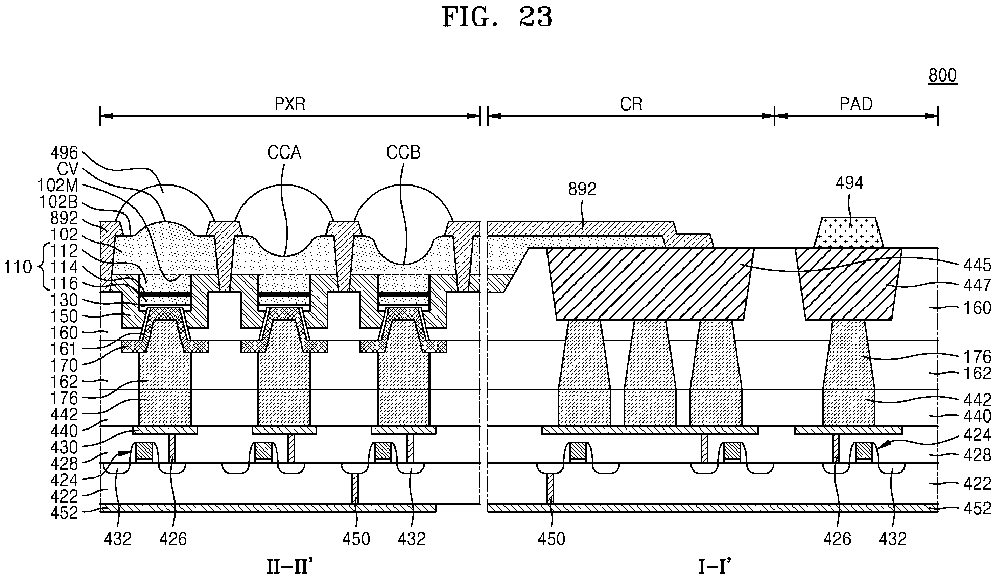

Referring to FIG. 23, the display device 800 may have substantially the same configuration as the display device 400 described with reference to FIGS. 11 to 13. However, the display device 800 may further include a grid electrode 892 passing through the first conductivity type base semiconductor layer 102 in a first direction (Z direction). The grid electrode 892 may include a metal layer. In a plan view parallel with a main surface 102M of the first conductivity type base semiconductor layer 102, the grid electrode 892 may include local regions extending along respective regions between a plurality of semiconductor light-emitting structures 110, and the local regions of the grid electrode 892 may be connected to each other to form a single layer. The grid electrode 892 may be arranged in a form that surrounds each of the plurality of semiconductor light-emitting structures 110. The local regions of the grid electrode 892 may be connected to each other in a grid shape or a mesh shape. The grid electrode 892 may be arranged to fill respective spaces between the plurality of semiconductor light-emitting structures 110, and thus, the spreading of current may improve, and light emission efficiency at a pixel array of the display device 800 may increase. In one or more embodiments, by forming the grid electrode 892 using a plating process, relatively narrow spaces between the plurality of semiconductor light-emitting structures 110 may be stably filled.

A portion of the grid electrode 892 may be in contact with a sidewall of the first conductivity type base semiconductor layer 102. Another portion of the grid electrode 892 may be in contact with a rear surface 102B of the first conductivity type base semiconductor layer 102. In one or more embodiments, the grid electrode 892 may include silver (Ag), nickel (Ni), aluminum (Al), chromium (Cr), rhodium (Rh), iridium (Ir), palladium (Pd), ruthenium (Ru), magnesium (Mg), zinc (Zn), platinum (Pt), gold (Au), or a combination thereof.

A plurality of lenses 496 may be arranged on an emission surface defined by the grid electrode 892, of the rear surface 102B of the first conductivity type base semiconductor layer 102. Each of the plurality of lenses 496 may be in contact with a portion of the grid electrode 892 that covers the rear surface 102B.

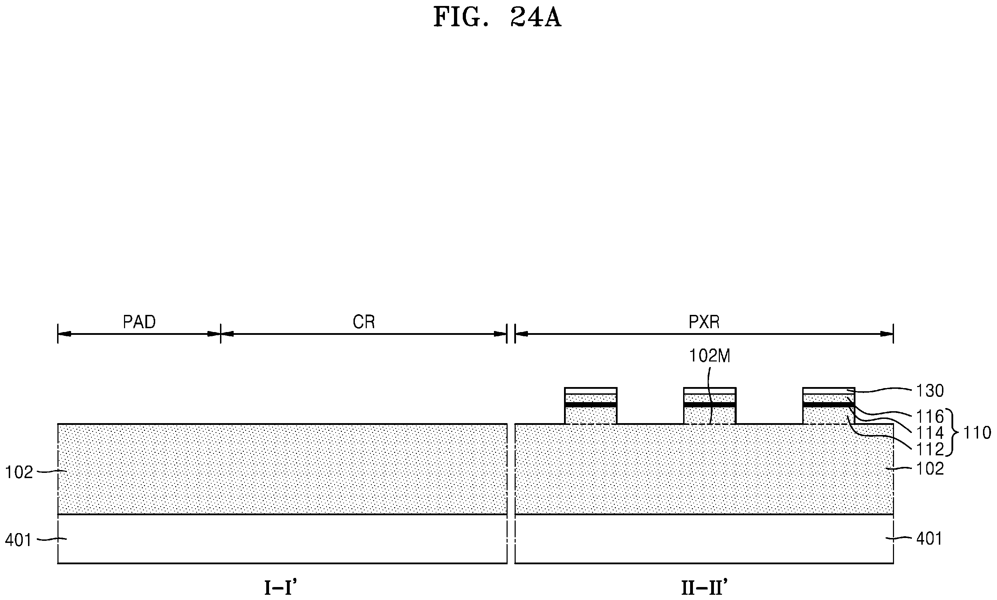

FIGS. 24A to 24H are each a cross-sectional view illustrating a process sequence of a method of manufacturing a display device, according one or more embodiments. An example of a method of manufacturing the display device 400 illustrated in FIGS. 11, 12, and 13 is described with reference to FIGS. 24A to 24H. In FIGS. 24A to 24H, the same reference numerals are used to denote the same elements as in FIGS. 1 to 13, and thus any redundant description will be omitted.

Referring to FIG. 24A, by using a semiconductor single crystal growth process, a deposition process, an etching process, etc. using a substrate for growth 401, a structure in which a first conductivity type base semiconductor layer 102, a plurality of semiconductor light-emitting structures 110 arranged in a pixel region PXR and each including a first conductivity type semiconductor layer 112, an active layer 114, and a second conductivity type semiconductor layer 116, and a plurality of transparent electrode layers 130 covering the plurality of semiconductor light-emitting structures 110 are arranged may be formed on the substrate for growth 401.

The substrate for growth 401 may be a substrate for semiconductor single crystal growth and may include AlN, AlGaN, ZnO, GaAs, MgAl₂O₄, MgO, LiAlO₂, LiGaO₂, GaN, or a combination thereof. In one or more embodiments, for improvement in crystallinity of semiconductor layers and light extraction efficiency, at least a portion of an upper surface of the substrate for growth 401 may have an uneven structure. In this case, layers grown on the substrate for growth 401 may also have an uneven structure.

In one or more embodiments, to form the structure illustrated in FIG. 24A, the first conductivity type base semiconductor layer 102, the first conductivity type semiconductor layer 112, the active layer 114, and the second conductivity type semiconductor layer 116 may be sequentially formed on the substrate for growth 401, and the transparent electrode layer 130 may be formed on the second conductivity type semiconductor layer 116. Then, by an etching process using a hard mask pattern as an etching mask, each of the transparent electrode layer 130, the second conductivity type semiconductor layer 116, the active layer 114, and the first conductivity type semiconductor layer 112 may be partially etched such that the plurality of semiconductor light-emitting structures 110 and the plurality of transparent electrode layers 130 covering the plurality of semiconductor light-emitting structures 110, which are arranged apart (e.g., spaced apart) from each other, are left on the first conductivity type base semiconductor layer 102. The plurality of semiconductor light-emitting structures 110 may form a plurality of cylindrical shapes having a circular, elliptical, or polygonal plane shape, along with the plurality of transparent electrode layers 130.

The first conductivity type base semiconductor layer 102, the first conductivity type semiconductor layer 112, the active layer 114, and the second conductivity type semiconductor layer 116 may be formed by using a metal organic chemical vapor deposition (MOCVD) process, a hydride vapor phase epitaxy (HVPE) process, or a molecular beam epitaxy (MBE) process. Detailed configurations of the first conductivity type base semiconductor layer 102, the first conductivity type semiconductor layer 112, the active layer 114, and the second conductivity type semiconductor layer 116 are the same as described above with reference to FIG. 2A.

In one or more embodiments, in each of the plurality of semiconductor light-emitting structures 110, a wet etching process may be further performed to remove damaged regions due to the etching. In the wet etching process, by controlling process conditions to differentiate the selectivity of crystal surfaces, only the damaged portions may be selectively removed from each of the plurality of semiconductor light-emitting structure 110, and a sidewall of each of the plurality of semiconductor light-emitting structures 110 may have a profile extending in a direction perpendicular to a main surface 102M of the first conductivity type base semiconductor layer 102. In addition, non-radiative recombination due to the damaged regions may decrease in the sidewall of each of the plurality of semiconductor light-emitting structures 110, which may lead to improved luminance in a light source.

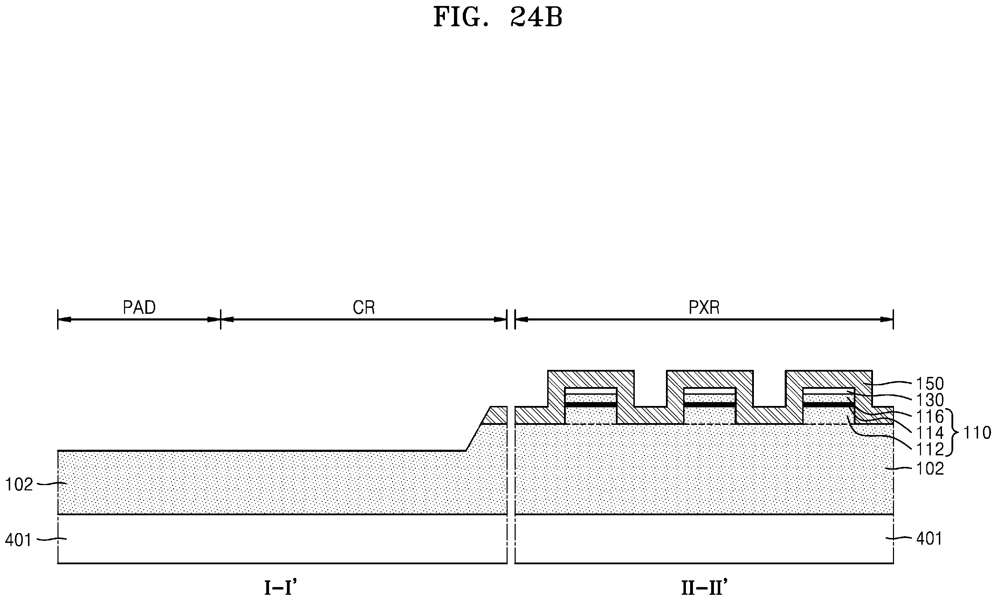

Referring to FIG. 24B, in the resultant structure of FIG. 24A, a reflective structure 150 covering respective surfaces of the first conductivity type base semiconductor layer 102, the plurality of semiconductor light-emitting structures 110, and the plurality of transparent electrode layers 130 may be formed, and the reflective structure 150 may be partially removed in a connection region CR and a contact pad region PAD to expose the first conductivity type base semiconductor layer 102. Then, by partially removing the exposed first conductivity type base semiconductor layer 102 by a certain thickness, a thickness of the first conductivity type base semiconductor layer 102 may be reduced in the connection region CR and the contact pad region PAD.

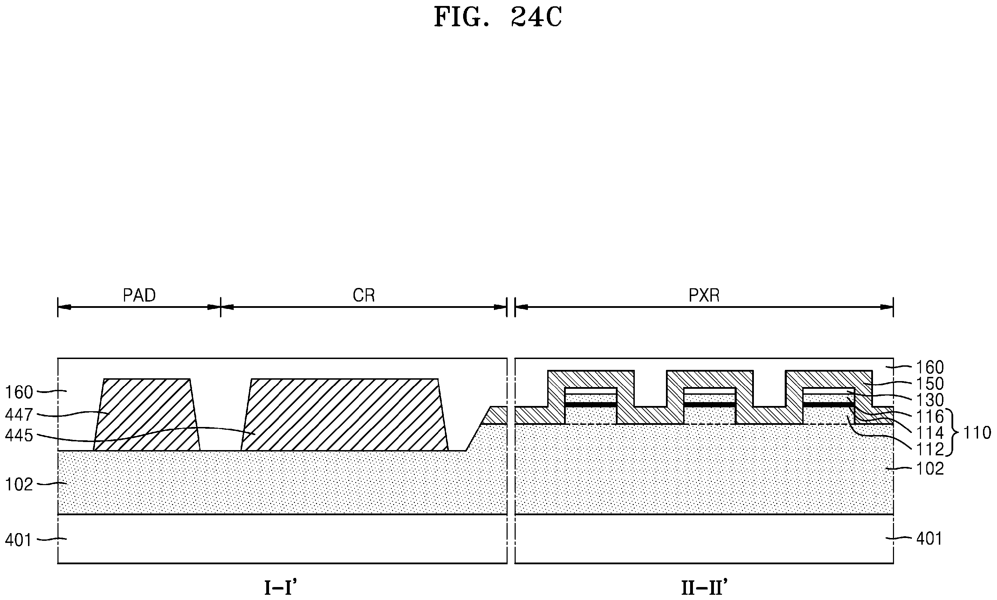

Referring to FIG. 24C, a common electrode 445 arranged on the first conductivity type base semiconductor layer 102 may be formed in the connection region CR, and an inner pad electrode 447 arranged on the first conductivity type base semiconductor layer 102 may be formed in the contact pad region PAD. Afterwards, an insulating layer 160 may be formed to cover the obtained resultant structure. The insulating layer 160 may be formed to cover the reflective structure 150 in a pixel region PXR and cover the common electrode 445 and the inner pad electrode 447 in the connection region CR and the contact pad region PAD. The insulating layer 160 may be formed to have a flat upper surface.

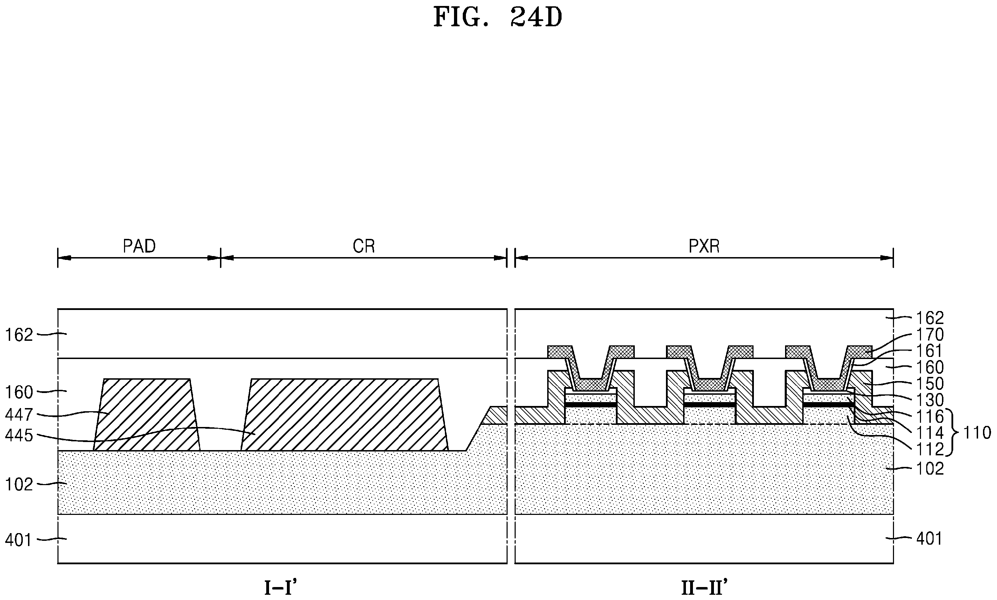

Referring to FIG. 24D, in the resultant structure of FIG. 24C, partial regions of the insulating layer 160 and the reflective structure 150 may be etched to expose the plurality of transparent electrode layers 130 in the pixel region PXR, and thus, a plurality of contact holes may be formed. In this case, by overetching, a portion of each of the plurality of transparent electrode layers 130 exposed at the plurality of contact holes may be partially etched to form a local recess 130R (refer to FIG. 6A) in an exposed surface of each of the plurality of transparent electrode layers 130.

Thereafter, a plurality of insulating spacers 161 may be formed to cover inner sidewalls of the plurality of contact holes, and a plurality of reflective electrode layers 170 may be formed on the plurality of insulating spacers 161 and the plurality of transparent electrode layers 130.

Subsequently, a second bonding insulating layer 162 may be formed to cover the plurality of reflective electrode layers 170 and the insulating layer 160 in the pixel region PXR and to cover the insulating layer 160 in the connection region CR and the contact pad region PAD. The second bonding insulating layer 162 may be formed to have a flat upper surface.

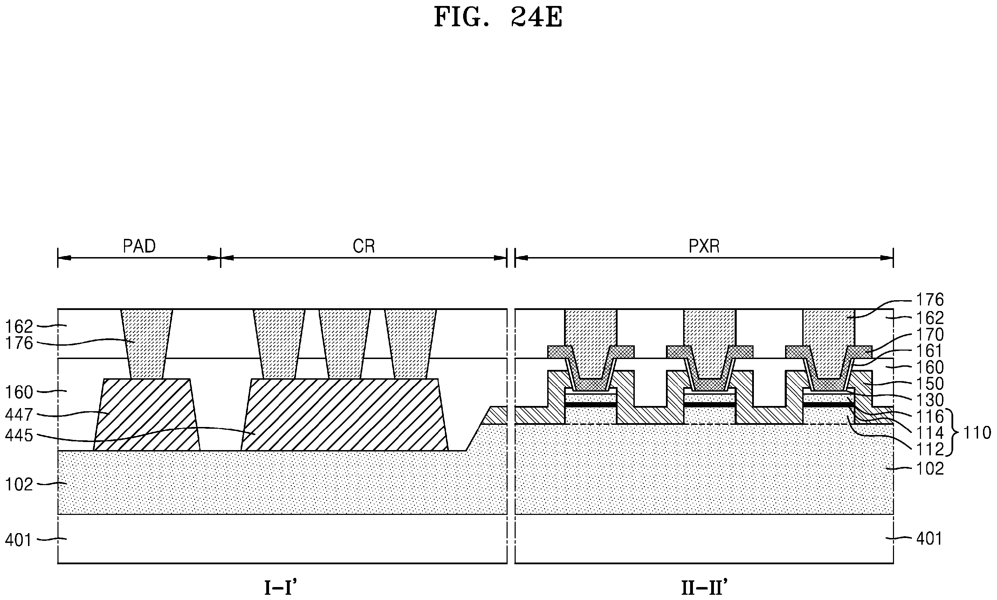

Referring to FIG. 24E, by etching partial regions of the second bonding insulating layer 162 in the pixel region PXR, the connection region CR, and the contact pad region PAD, a plurality of via holes exposing the plurality of reflective electrode layers 170, the common electrode 445, and the inner pad electrode 447 may be formed, and a plurality of second bonding electrodes 176 filling the plurality of via holes may be formed.

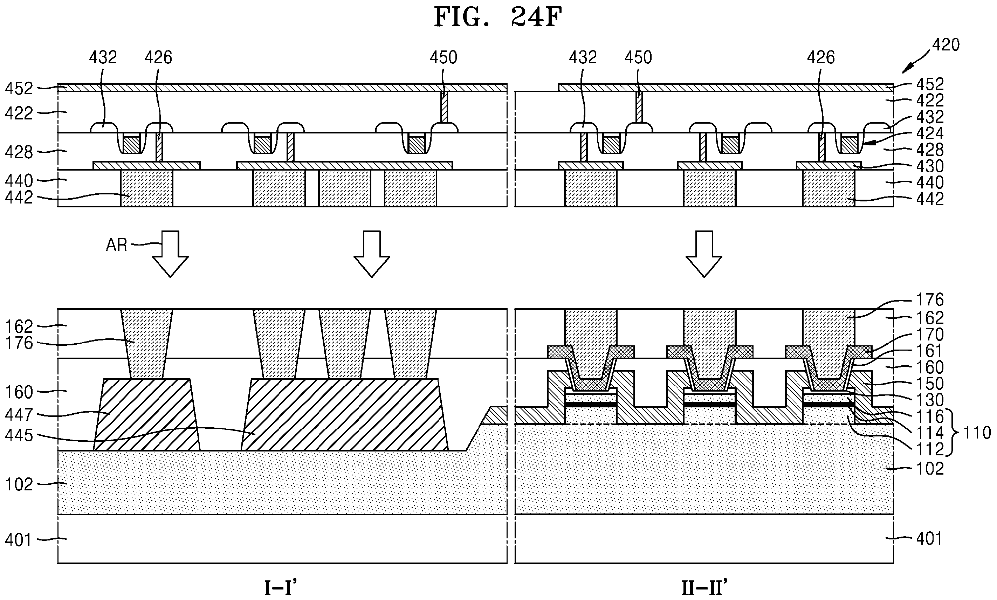

Referring to FIG. 24F, after preparing the circuit board 420, the circuit board 420 may be located on the resultant structure of FIG. 24E such that, in the resultant structure of FIG. 24E, the second bonding insulating layer 162 and the plurality of second bonding electrodes 176 respectively face the first bonding insulating layer 440 and the plurality of first bonding electrodes 442 that are included in the circuit board 420. The circuit board 420 may be pressurized in an arrow AR direction on a surface exposing the second bonding insulating layer 162 and the plurality of second bonding electrodes 176 to bond the plurality of first bonding electrodes 442 to the plurality of second bonding electrodes 176 and bond the first bonding insulating layer 440 to the second bonding insulating layer 162.

The bonding between the plurality of first bonding electrodes 442 and the plurality of second bonding electrodes 176 and the bonding between the first bonding insulating layer 440 and the second bonding insulating layer 162 may be performed by wafer bonding, for example, hybrid bonding described above.

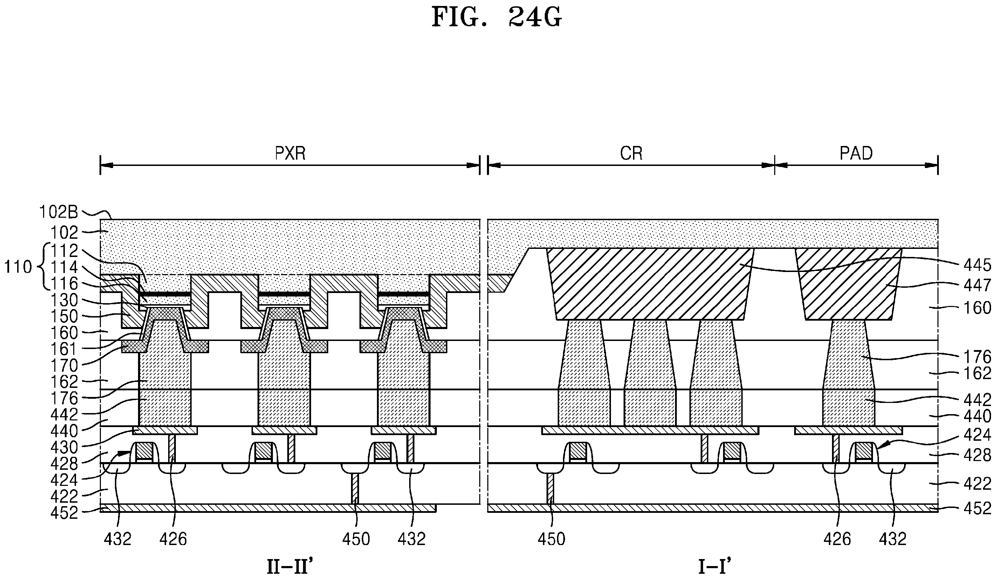

Referring to FIG. 24G, from the resultant structure in which the plurality of first bonding electrodes 442 and the plurality of second bonding electrodes 176 are bonded and first bonding insulating layer 440 and the second bonding insulating layer 162 are bonded according to the process described with reference to FIG. 24F, the substrate for growth 401 covering the first conductivity type base semiconductor layer 102 may be removed to expose the first conductivity type base semiconductor layer 102. The substrate for growth 401 may be removed by various processes such as laser lift-off, mechanical polishing, mechanical-chemical polishing, or etching. After the first conductivity type base semiconductor layer 102 is exposed by removing the substrate for growth 401, the thickness of the first conductivity type base semiconductor layer 102 may be reduced by using a polishing process such as chemical mechanical polishing (CMP), etc.

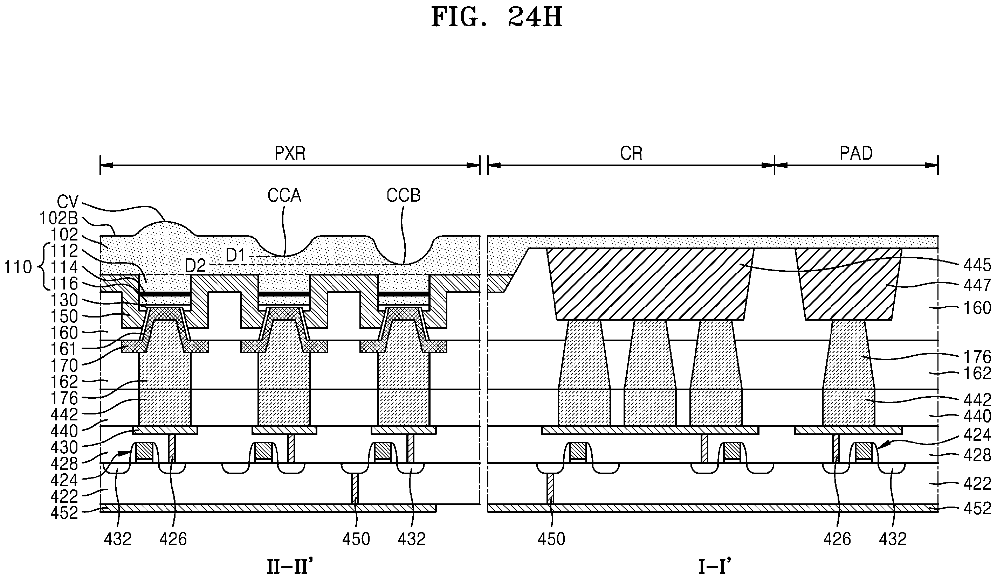

Referring to FIG. 24H, by patterning partial regions of the exposed first conductivity type base semiconductor layer 102 in the pixel region PXR of the resultant structure of FIG. 24G, a first optical path guide surface CV, a second optical path guide surface CCA, and a third optical path guide surface CCB may be formed on a rear surface 102B of the first conductivity type base semiconductor layer 102.

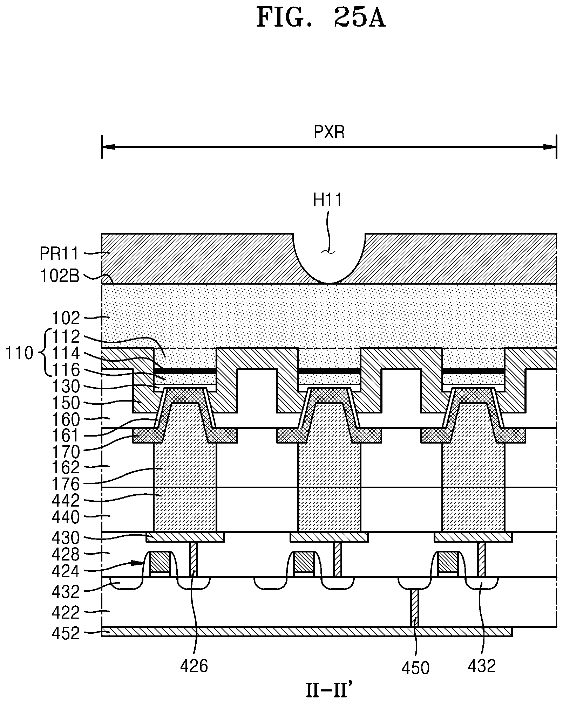

FIGS. 25A to 25F are cross-sectional views specifically illustrating a process sequence of an example of a process of forming the first optical path guide surface CV, the second optical path guide surface CCA, and the third optical path guide surface CCB on the rear surface 102B of the first conductivity type base semiconductor layer 102 in the pixel region PXR according to the process described with reference to FIG. 24H.

Referring to FIG. 25A, a first photoresist pattern PR11 covering the rear surface 102B of the first conductivity type base semiconductor layer 102 may be formed in the pixel region PXR of the resultant structure of FIG. 24G. The first photoresist pattern PR11 may include a first opening H11 having an inclined sidewall that has a lateral width decreasing in a direction toward the rear surface 102B of the first conductivity type base semiconductor layer 102. The first opening H11 of the first photoresist pattern PR11 may be formed at a position overlapping at least one of the plurality of semiconductor light-emitting structures 110 located thereunder in a first direction (Z direction). To form the first photoresist pattern PR11, a photoresist film may be formed on the rear surface 102B of the first conductivity type base semiconductor layer 102, and exposure and development processes on the photoresist film by using known processes.

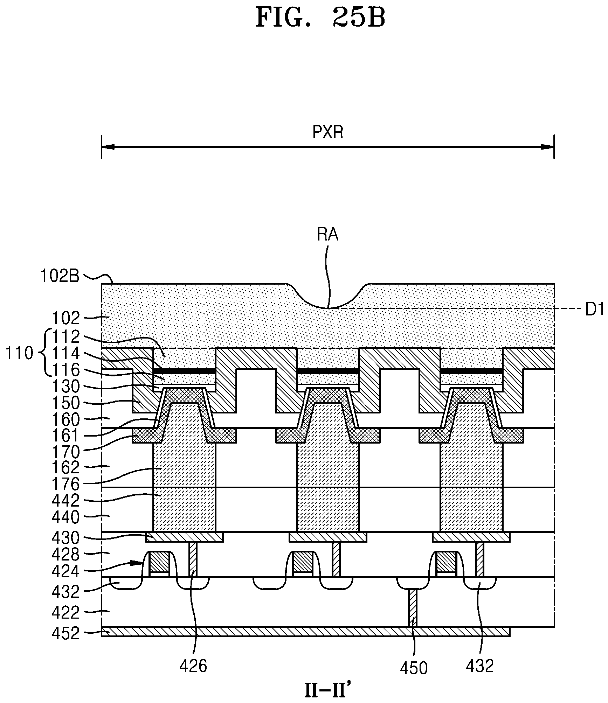

Referring to FIG. 25B, in the resultant structure of FIG. 25A, a portion of the first conductivity type base semiconductor layer 102 may be etched by using the first photoresist pattern PR11 as an etch mask to form a first recess RA in a local region of the rear surface 102B of the first conductivity type base semiconductor layer 102, and residue of the first photoresist pattern PR11 on the rear surface 102B of the first conductivity type base semiconductor layer 102 may be removed by ashing and stripping processes. The first recess RA may be formed at a position corresponding to a position of the first opening H11 of the first photoresist pattern PR11 on the rear surface 102B of the first conductivity type base semiconductor layer 102.

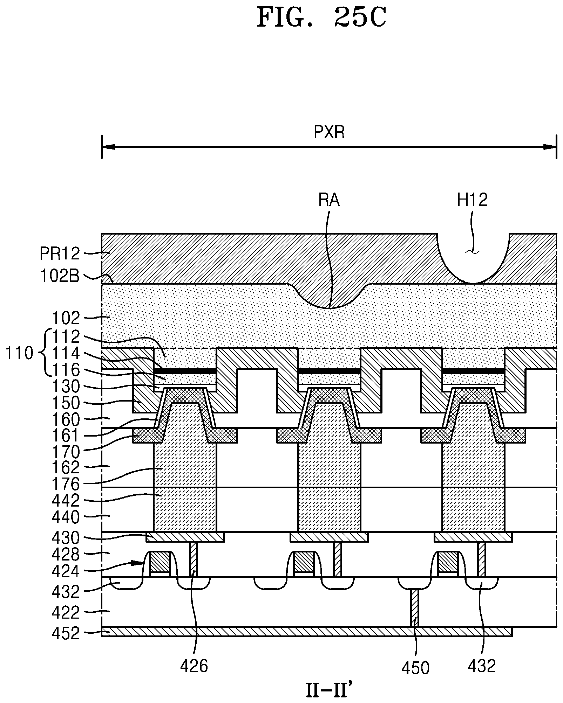

Referring to FIG. 25C, in the resultant structure of FIG. 25B, a second photoresist pattern PR12 may be formed to cover the rear surface 102B of the first conductivity type base semiconductor layer 102 and the first recess RA. The second photoresist pattern PR12 may include a second opening H12 having an inclined sidewall that has a lateral width decreasing in a direction toward the rear surface 102B of the first conductivity type base semiconductor layer 102. The second opening H12 of the second photoresist pattern PR12 may be formed at a position overlapping at least one of the plurality of semiconductor light-emitting structures 110 located thereunder in the first direction (Z direction).

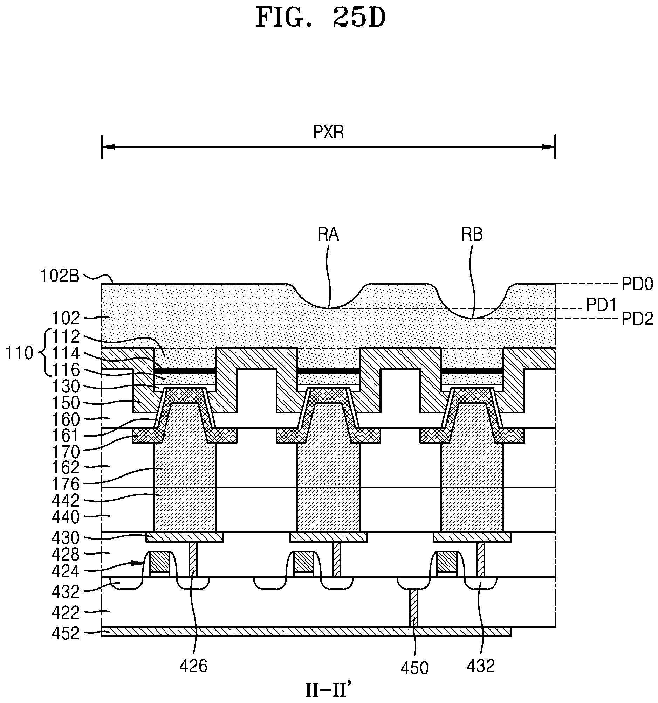

Referring to FIG. 25D, in the resultant structure of FIG. 25C, another portion of the first conductivity type base semiconductor layer 102 may be etched by using the second photoresist pattern PR12 as an etch mask to form a second recess RB in another local region of the rear surface 102B of the first conductivity type base semiconductor layer 102, and residue of the second photoresist pattern PR12 on the rear surface 102B of the first conductivity type base semiconductor layer 102 may be removed by ashing and stripping processes. The second recess RB may be formed at a position corresponding to a position of the second opening H12 of the second photoresist pattern PR12 on the rear surface 102B of the first conductivity type base semiconductor layer 102. A vertical level PD1 of a lowermost surface of the first recess RA may be closer to a vertical level PD0 of a flat portion of the rear surface 102B of the first conductivity type base semiconductor layer 102 than a vertical level PD2 of a lowermost surface of the second recess RB.

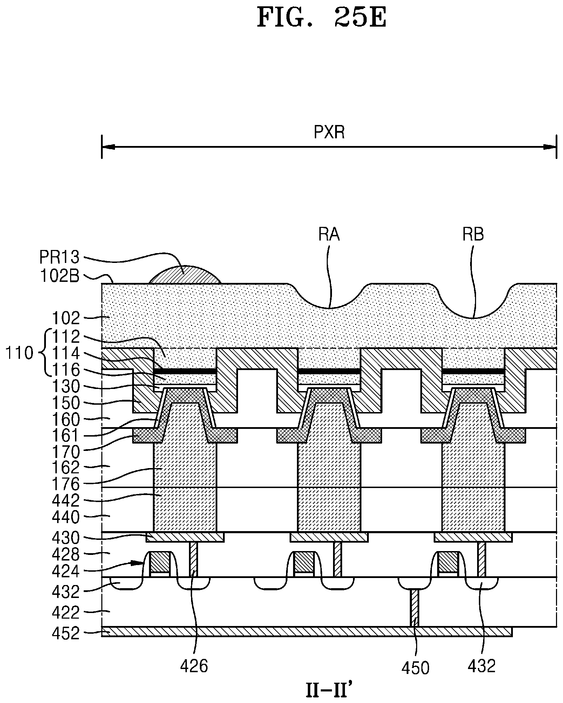

Referring to FIG. 25E, in the resultant structure of FIG. 25D, a third photoresist pattern PR13 may be formed on the rear surface 102B of the first conductivity type base semiconductor layer 102. The third photoresist pattern PR13 may be formed apart (e.g., spaced apart) from the first recess RA and the second recess RB in a lateral direction to cover a local region of the rear surface 102B of the first conductivity type base semiconductor layer 102. The third photoresist pattern PR13 may be formed at a position overlapping at least one of the plurality of semiconductor light-emitting structures 110 located thereunder in the first direction (Z direction).

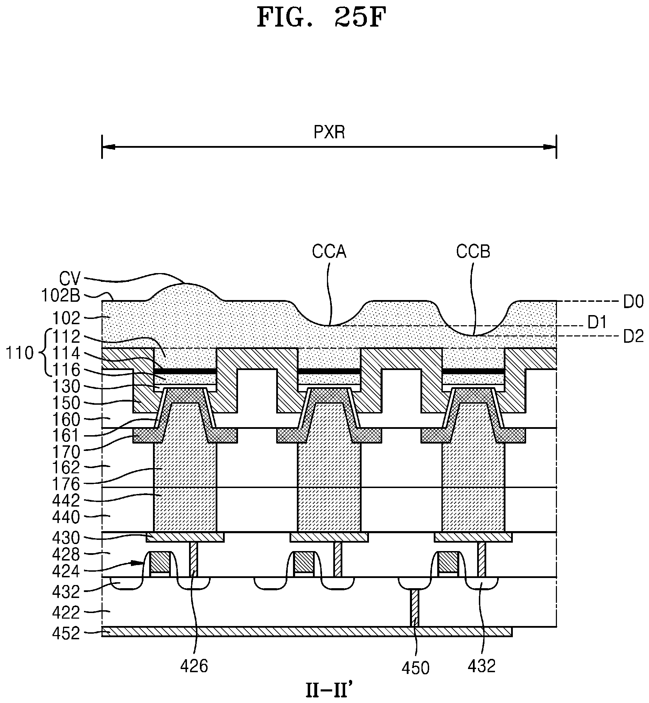

Referring to FIG. 25F, in the resultant structure of FIG. 25E, the first conductivity type base semiconductor layer 102 exposed around the third photoresist pattern PR13 may be etched by using the third photoresist pattern PR13 as an etch mask, and thus, a first optical path guide surface CV may be formed on a portion covered by the third photoresist pattern PR13.

During the etching of the first conductivity type base semiconductor layer 102 to form the first optical path guide surface CV, a vertical level of each of the first recess RA and the second recess RB may be lowered. Thus, a second optical path guide surface CCA to which a shape of the first recess RA is transferred and a third optical path guide surface CCB to which a shape of the second recess RB is transferred may be formed on the rear surface 102B of the first conductivity type base semiconductor layer 102. A vertical level D1 of a lowermost surface of the second optical path guide surface CCA may be closer to a vertical level D0 of a flat portion of the rear surface 102B of the first conductivity type base semiconductor layer 102 than a vertical level D2 of a lowermost surface of the third optical path guide surface CCB. Accordingly, a first maximum length in the first direction (Z direction) of a concave portion defined by the second optical path guide surface CCA may be less than a second maximum length in the first direction (Z direction) of a concave portion defined by the third optical path guide surface CCB.

Referring back to FIG. 24H, in the resultant structure including the first conductivity type base semiconductor layer 102 having the first optical path guide surface CV, the second optical path guide surface CCA, and the third optical path guide surface CCB, a plurality of lenses 496 (refer to FIG. 13) covering each of the first optical path guide surface CV, the second optical path guide surface CCA, and the third optical path guide surface CCB may be formed on the rear surface 102B of the first conductivity type base semiconductor layer 102, and a contact pad electrode 494 may be formed on the inner pad electrode 447 in the contact pad region PAD. By dicing an edge region ISO (refer to FIG. 11) of each of a plurality of adjacent modules, the display device 400 described with reference to FIGS. 11 to 13 may be manufactured.

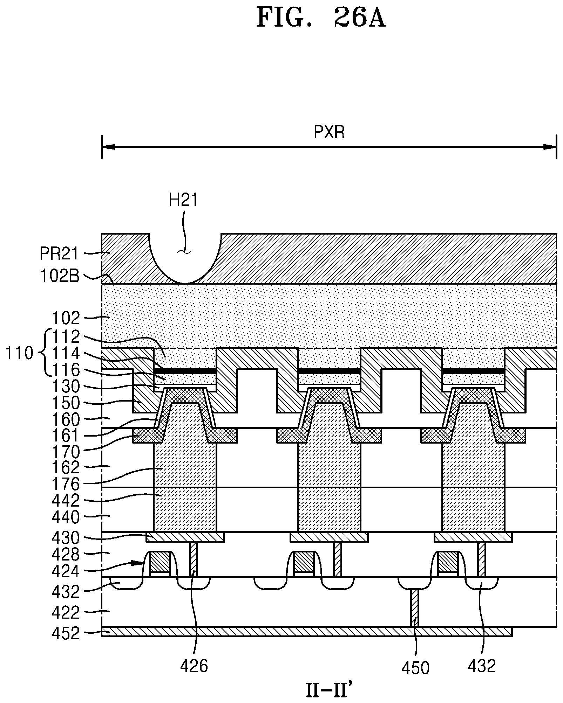

FIGS. 26A to 26F are each a cross-sectional view illustrating a process sequence of a method of manufacturing a display device, according one or more embodiments. An example of a method of manufacturing the display device 500 illustrated in FIG. 16 is described with reference to FIGS. 26A to 26F. In FIGS. 26A to 26F, the same reference numerals are used to denote the same elements as in FIGS. 1 to 25F, and thus any redundant description will be omitted.

Referring to FIG. 26A, after performing the processes described with reference to FIGS. 24A to 24G, a first photoresist pattern PR21 covering a rear surface 102B of a first conductivity type base semiconductor layer 102 may be formed in a pixel region PXR of the resultant structure of FIG. 24G. The first photoresist pattern PR21 may include a first opening H21 having an inclined sidewall that has a lateral width decreasing in a direction toward the rear surface 102B of the first conductivity type base semiconductor layer 102. The first opening H21 of the first photoresist pattern PR21 may be formed at a position overlapping at least one of a plurality of semiconductor light-emitting structures 110 located thereunder in a first direction (Z direction).

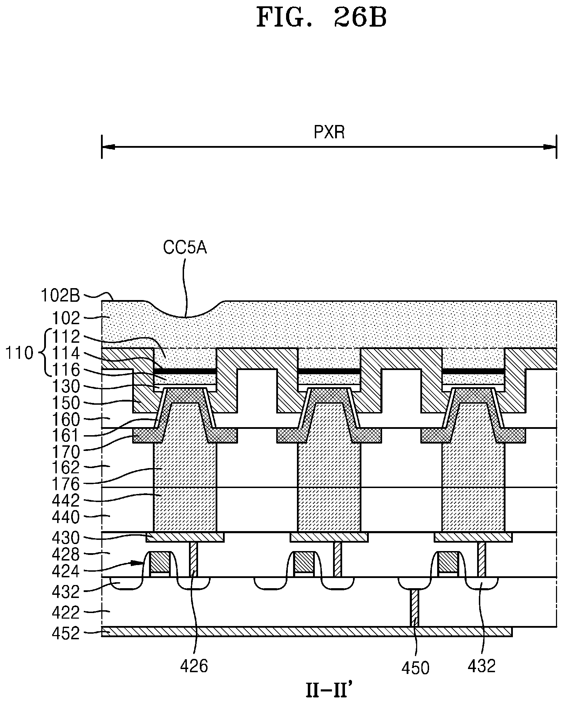

Referring to FIG. 26B, in the resultant structure of FIG. 26A, a portion of the first conductivity type base semiconductor layer 102 may be etched by using the first photoresist pattern PR21 as an etch mask to form a first optical path guide surface CC5A in a local region of the rear surface 102B of the first conductivity type base semiconductor layer 102, and residue of the first photoresist pattern PR21 on the rear surface 102B of the first conductivity type base semiconductor layer 102 may be removed by ashing and stripping processes. The first optical path guide surface CC5A may be formed at a position corresponding to a position of the first opening H21 of the first photoresist pattern PR21 on the rear surface 102B of the first conductivity type base semiconductor layer 102.

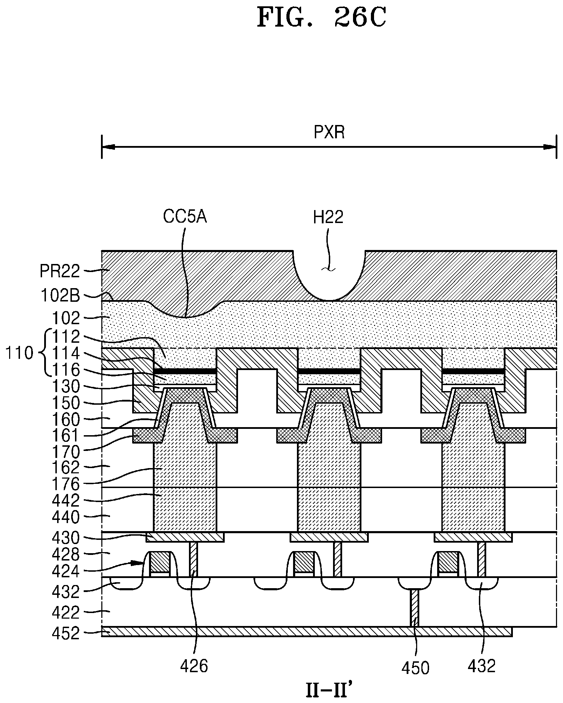

Referring to FIG. 26C, in the resultant structure of FIG. 26B, a second photoresist pattern PR22 may be formed to cover the rear surface 102B of the first conductivity type base semiconductor layer 102 and cover the first optical path guide surface CC5A. The second photoresist pattern PR22 may include a second opening H22 having an inclined sidewall that has a lateral width decreasing in a direction toward the rear surface 102B of the first conductivity type base semiconductor layer 102. The second opening H22 of the second photoresist pattern PR22 may be formed at a position overlapping at least one of the plurality of semiconductor light-emitting structures 110 located thereunder in the first direction (Z direction).

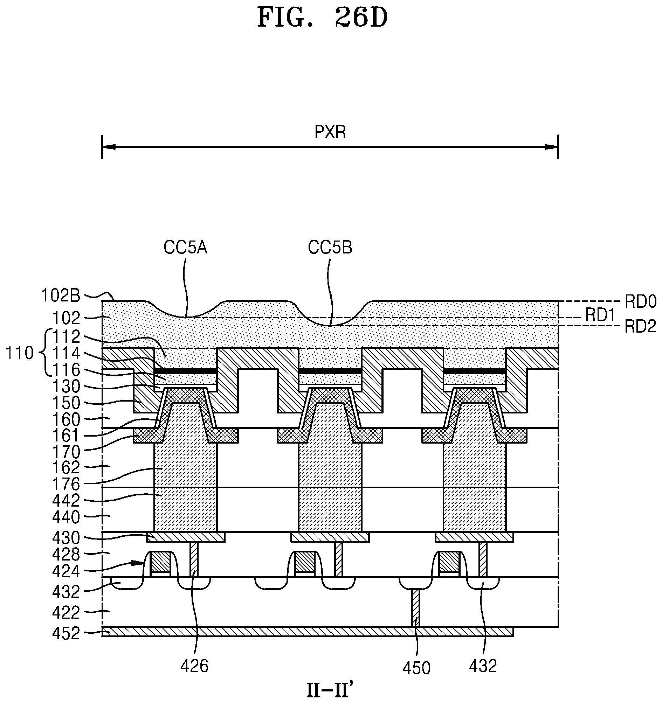

Referring to FIG. 26D, in the resultant structure of FIG. 26C, another portion of the first conductivity type base semiconductor layer 102 may be etched by using the second photoresist pattern PR22 as an etch mask to form a second optical path guide surface CC5B in another local region of the rear surface 102B of the first conductivity type base semiconductor layer 102, and residue of the second photoresist pattern PR22 on the rear surface 102B of the first conductivity type base semiconductor layer 102 may be removed by ashing and stripping processes. The second optical path guide surface CC5B may be formed at a position corresponding to a position of the second opening H22 of the second photoresist pattern PR22 on the rear surface 102B of the first conductivity type base semiconductor layer 102. A vertical level RD1 of a lowermost surface of the first optical path guide surface CC5A may be closer to a vertical level RD0 of a flat portion of the rear surface 102B of the first conductivity type base semiconductor layer 102 than a vertical level RD2 of a lowermost surface of the second optical path guide surface CC5B.

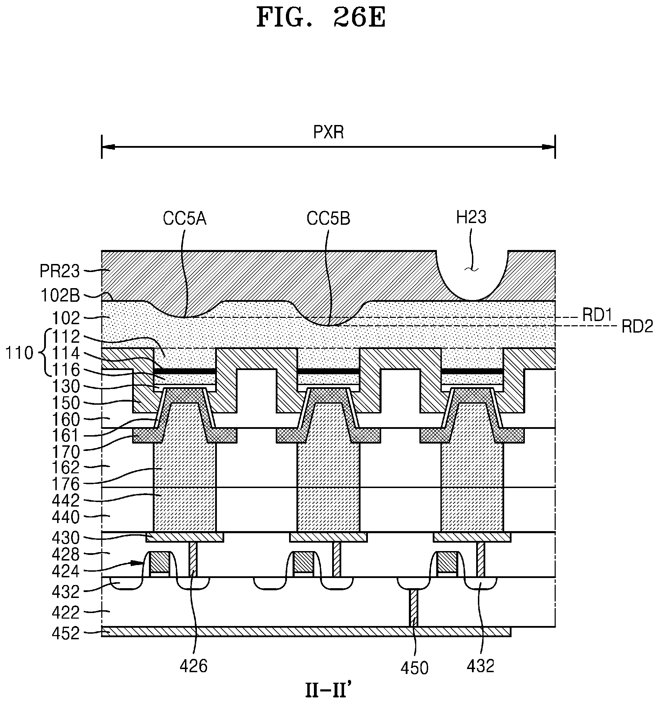

Referring to FIG. 26E, in the resultant structure of FIG. 26D, a third photoresist pattern PR23 may be formed on the rear surface 102B of the first conductivity type base semiconductor layer 102. The third photoresist pattern PR23 may cover the first optical path guide surface CC5A and the second optical path guide surface CC5B and include a third opening H23 having an inclined sidewall that has a lateral width decreasing in a direction toward the rear surface 102B of the first conductivity type base semiconductor layer 102. The third opening H23 of the third photoresist pattern PR23 may be formed at a position overlapping at least one of the plurality of semiconductor light-emitting structures 110 located thereunder in the first direction (Z direction).

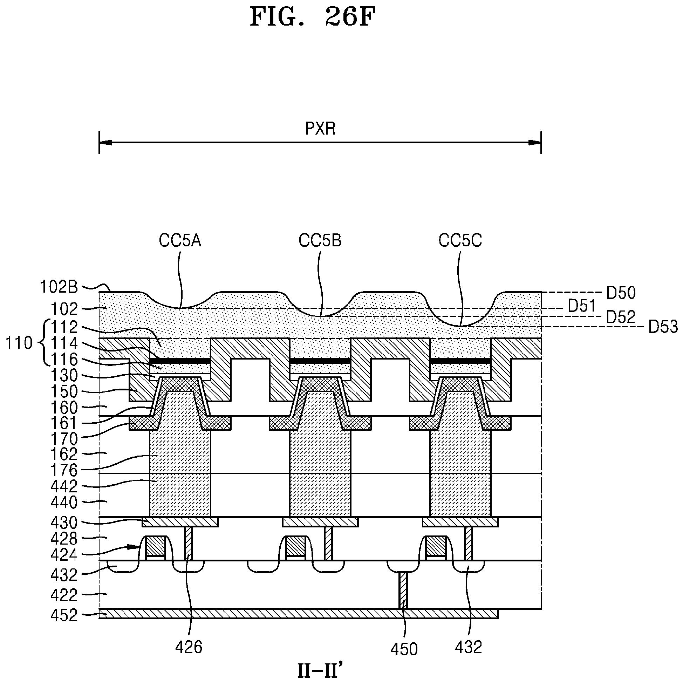

Referring to FIG. 26F, in the resultant structure of FIG. 26E, another portion of the first conductivity type base semiconductor layer 102 may be etched by using the third photoresist pattern PR23 as an etch mask to form a third optical path guide surface CC5C in yet another local region of the rear surface 102B of the first conductivity type base semiconductor layer 102, and residue of the third photoresist pattern PR23 on the rear surface 102B of the first conductivity type base semiconductor layer 102 may be removed by ashing and stripping processes.

After the third optical path guide surface CC5C is formed, a vertical level D51 of a lowermost surface of the first optical path guide surface CC5A may be closer to a vertical level D50 of a flat portion of the rear surface 102B of the first conductivity type base semiconductor layer 102 than a vertical level D52 of a lowermost surface of the second optical path guide surface CC5B, and the vertical level D52 of the lowermost surface of the second optical path guide surface CC5B may be closer to the vertical level D50 of the flat portion of the rear surface 102B of the first conductivity type base semiconductor layer 102 than a vertical level D53 of a lowermost surface of the third optical path guide surface CC5C. Accordingly, a first maximum length in the first direction (Z direction) of a concave portion defined by the first optical path guide surface CC5A may be less than a second maximum length in the first direction (Z direction) of a concave portion defined by the second optical path guide surface CC5B, and the second maximum length may be less than a third maximum length in the first direction (Z direction) of a concave portion defined by the third optical path guide surface CC5C.

Thereafter, by using a method similar to that described with reference to FIG. 24H, in the resultant structure including the first conductivity type base semiconductor layer 102 having the first optical path guide surface CC5A, the second optical path guide surface CC5B, and the third optical path guide surface CC5C, a plurality of lenses 496 (refer to FIG. 13) may be formed on the rear surface 102B of the first conductivity type base semiconductor layer 102, a contact pad electrode 494 may be formed on an inner pad electrode 447 in a contact pad region PAD, and an edge region ISO (refer to FIG. 11) of each of a plurality of adjacent modules may be diced.

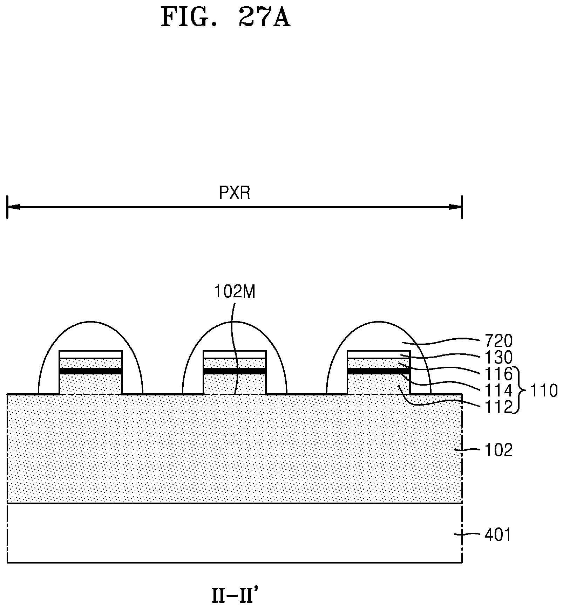

FIGS. 27A to 27C are cross-sectional views illustrating a process sequence of a method of manufacturing a display device, according to one or more embodiments. An example of a method of manufacturing the display device 700 illustrated in FIG. 22 is described with reference to FIGS. 27A to 27C. In FIGS. 27A to 27C, the same reference numerals are used to denote the same elements as in FIGS. 1 to 24H, and thus any redundant description will be omitted.

Referring to FIG. 27A, as described above with reference to FIG. 24A, a structure in which a first conductivity type base semiconductor layer 102, a plurality of semiconductor light-emitting structures 110 arranged in a pixel region PXR and each including a first conductivity type semiconductor layer 112, an active layer 114, and a second conductivity type semiconductor layer 116, and a plurality of transparent electrode layers 130 covering the plurality of semiconductor light-emitting structures 110 are arranged may be formed on a substrate for growth 401.

Thereafter, a plurality of insulating spacers 720 covering the plurality of semiconductor light-emitting structures 110 may be formed on the first conductivity type base semiconductor layer 102. The plurality of insulating spacers 720 may be formed to cover a sidewall of each of a plurality of semiconductor light-emitting structures 110 and a sidewall and a top surface of a transparent electrode layer 130.

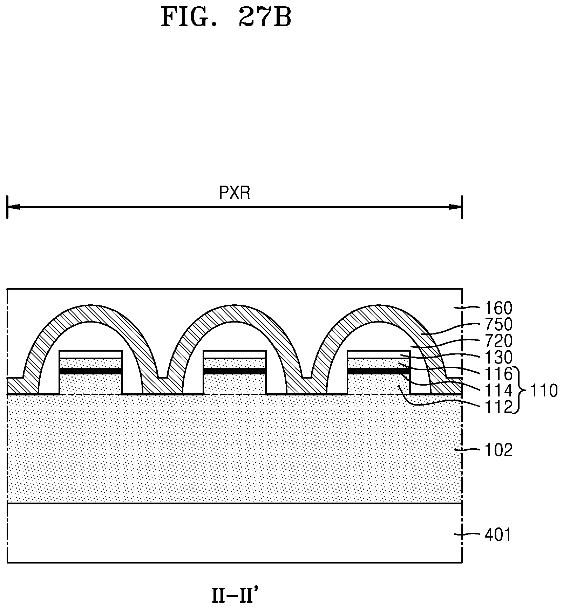

Referring to FIG. 27B, a reflective structure 750 and an insulating layer 160 may be formed to cover the resultant structure of FIG. 27A. The insulating layer 160 may be formed to have a flat upper surface.

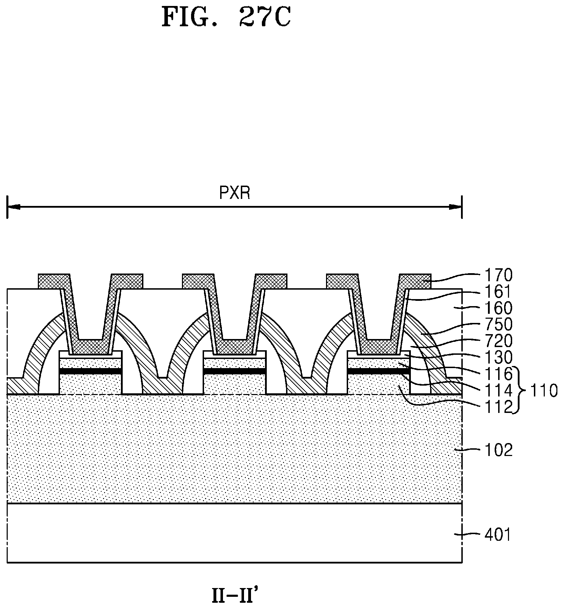

Referring to FIG. 27C, in the resultant structure of FIG. 27B, partial regions of the insulating layer 160 and the reflective structure 750 may be etched to expose the plurality of transparent electrode layers 130 in the pixel region PXR, and thus, a plurality of contact holes may be formed. In this case, by overetching, a portion of each of the plurality of transparent electrode layers 130 exposed at the plurality of contact holes may be partially etched to form a local recess 130R (refer to FIG. 6A) in an exposed surface of each of the plurality of transparent electrode layers 130. Thereafter, a plurality of insulating spacers 161 may be formed to cover inner sidewalls of the plurality of contact holes, and a plurality of reflective electrode layers 170 may be formed on the plurality of insulating spacers 161 and the plurality of transparent electrode layers 130.

Subsequently, the processes described with reference to FIGS. 24D to 24H may be performed on the resultant structure of FIG. 27C, and thus, the display device 700 illustrated in FIG. 22 may be manufactured.

To manufacture the display device 800 illustrated in FIG. 23, processes similar to the processes described with reference to FIGS. 24A to 24G may be performed. However, after forming a first optical path guide surface CV, a second optical path guide surface CCA, and a third optical path guide surface CCB on a rear surface 102B of the first conductivity type base semiconductor layer 102 according to the process described with reference to FIG. 24H and before forming a plurality of lenses 496, by etching a partial region of the first conductivity type base semiconductor layer 102 in a connection region CR and a contact pad region PAD of the resultant structure of FIG. 24H, a portion of a common electrode 445 and an inner pad electrode 447 may be exposed, and by etching partial regions of the first conductivity type base semiconductor layer 102 and partial regions of the reflective structure 150 in the pixel region PXR, an electrode space in a grid shape or a mesh shape passing through the first conductivity type base semiconductor layer 102 and the reflective structure 150 may be arranged. Then, by filling a conductive material in the electrode space, a grid electrode 892 may be formed. In the pixel region PXR, grid electrodes 892 may be formed to be connected to each other in a grid shape or a mesh shape.

The grid electrode 892 may be formed to include a portion covering the rear surface 102B of the first conductivity type base semiconductor layer 102 in the pixel region PXR and the connection region CR. The grid electrode 892 may be formed in contact with each of the first conductivity type base semiconductor layer 102 and the common electrode 445 in the connection region CR. A plating process may be used to form the grid electrode 892, without being limited thereto.

Thereafter, as illustrated in FIG. 23, the plurality of microlenses 496 covering a plurality of emission surfaces defined by the grid electrode 892, of the rear surface 102B of the first conductivity type base semiconductor layer 102, may be formed.

Although the methods of manufacturing the display devices 400, 500, 700, and 800 illustrated in FIGS. 11, 12, 13, 16, 22, and 23 have been described with reference to FIGS. 24A to 27C, it will be understood that the display devices 400, 500, 700, and 800 and display devices having variously changed structures may be manufactured by applying various modifications and changes to the processes described with reference to FIGS. 24A to 27C within the scope of the disclosure.

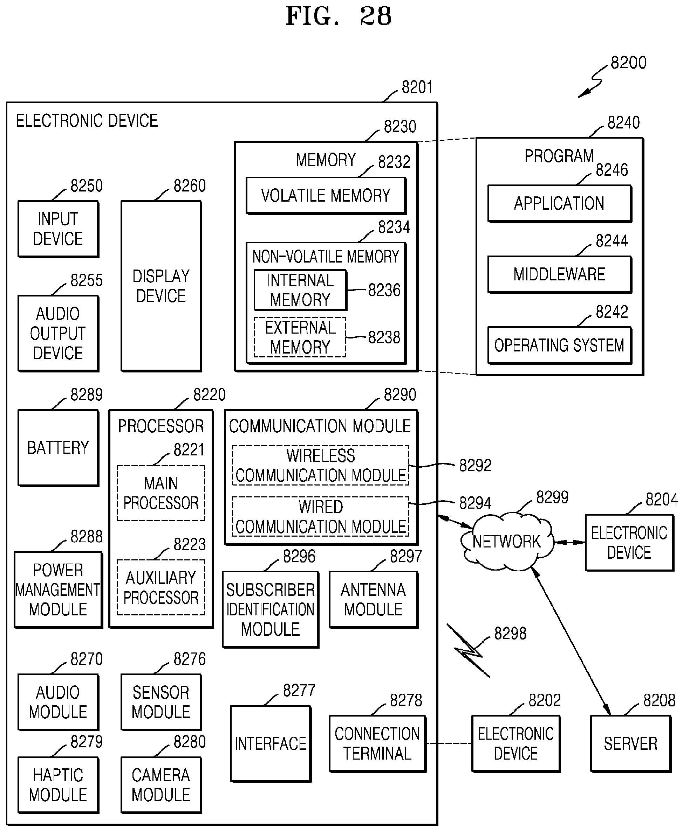

FIG. 28 is a block diagram illustrating an example of an electronic device including a light source or a display device, according to one or more embodiments.

Referring to FIG. 28, an electronic device 8201 may be provided in a network environment 8200. In the network environment 8200, the electronic device 8201 may communicate with another electronic device 8202 through a first network 8298 (a short-range wireless communication network, etc.) or communicate with another electronic device 8204 and/or a server 8208 through a second network 8299 (a long-distance wireless communication network, etc.). The electronic device 8201 may communicate with the electronic device 8204 through the server 8208. The electronic device 8201 may include a processor 8220, a memory 8230, an input device 8250, an audio output device 8255, a display device 8260, an audio module 8270, a sensor module 8276, an interface 8277, a haptic module 8279, a camera module 8280, a power management module 8288, a battery 8289, a communication module 8290, a subscriber identification module 8296, and/or an antenna module 8297. In the electronic device 8201, some of the constituent components may be omitted or other constituent components may be added. Some of these components may be implemented as one integrated circuit. For example, the sensor module 8276 (a fingerprint sensor, an iris sensor, an illuminance sensor, and the like) may be implemented by being embedded in the display device 8260 (a display, and the like).

The processor 8220 may control one or a plurality of other constituent elements (hardware and software constituent elements, and the like) of the electronic device 8201 connected to the processor 8220 by executing software (a program 8240, and the like), and perform various data processing or calculations. As part of the data processing or calculations, the processor 8220 may load, in a volatile memory 8232, commands and/or data received from other constituent elements (the sensor module 8276, the communication module 8290, and the like), process the commands and/or data stored in the volatile memory 8232, and store result data in a non-volatile memory 8234. The processor 8220 may include a main processor 8221 (a central processing unit, an application processor, and the like) and an auxiliary processor 8223 (a graphics processing unit, an image signal processor, a sensor hub processor, a communication processor, and the like) that is operable independently of or together with the main processor 8221. The auxiliary processor 8223 may use less power than the main processor 8221 and may perform a specialized function.

Instead of the main processor 8221 when the main processor 8221 is in an inactive state (sleep state), or with the main processor 8221 when the main processor 8221 is in an active state (application execution state), the auxiliary processor 8223 may control functions and/or states related to some constituent elements (the display device 8260, the sensor module 8276, the communication module 8290, and the like) of the constituent elements of the electronic device 8201. The auxiliary processor 8223 (an image signal processor, a communication processor, and the like) may be implemented as a part of functionally related other constituent elements (the camera module 8280, the communication module 8290, and the like).

The memory 8230 may store various data needed by the constituent elements (the processor 8220, the sensor module 8276, and the like) of the electronic device 8201. The data may include, for example, software (the program 8240, and the like) and input data and/or output data about commands related thereto. The memory 8230 may include the volatile memory 8232 and/or the non-volatile memory 8234.

The program 8240 may be stored in the memory 8230 as software, and may include an operating system 8242, middleware 8244, and/or an application 8246.

The input device 8250 may receive commands and/or data to be used for constituent elements (the processor 8220, and the like) of the electronic device 8201, from the outside (a user, and the like) of the electronic device 8201. The input device 8250 may include a remote controller, a microphone, a mouse, a keyboard, and/or a digital pen (a stylus pen, and the like).

The audio output device 8255 may output an audio signal to the outside of the electronic device 8201. The audio output device 8255 may include a speaker and/or a receiver. The speaker may be used for general purposes such as multimedia playback or recording playback, and the receiver can be used to receive incoming calls. The receiver may be implemented by being coupled as a part of the speaker or by an independent separate device.

The display device 8260 may visually provide information to the outside of the electronic device 8201. The display device 8260 may include a display, a hologram device, or a projector, and a control circuit to control a corresponding device. The display device 8260 may include at least one of light sources having various structures illustrated in FIGS. 1 to 10 and display devices having various structures illustrated in FIGS. 11 to 23. The display device 8260 may include a touch circuitry set to detect a touch and/or a sensor circuit (a pressure sensor, and the like) set to measure the strength of a force generated by the touch.

The audio module 8270 may convert sound into electrical signals or reversely electrical signals into sound. The audio module 8270 may obtain sound through the input device 8250, or output sound through a speaker and/or a headphone of another electronic device (the electronic device 8202, and the like) connected to the audio output device 8255 and/or the electronic device 8201 in a wired or wireless manner.

The sensor module 8276 may detect an operation state (power, temperature, and the like) of the electronic device 8201, or an external environment state (a user state, and the like), and generate an electrical signal and/or a data value corresponding to a detected state. The sensor module 8276 may include a gesture sensor, a gyro sensor, a barometric pressure sensor, a magnetic sensor, an acceleration sensor, a grip sensor, a proximity sensor, a color sensor, an IR sensor, a biometric sensor, a temperature sensor, a humidity sensor, and/or an illuminance sensor.

The interface 8277 may support one or more specified protocols used for the electronic device 8201 to be connected to another electronic device (the electronic device 8202, and the like) in a wired or wireless manner. The interface 8277 may include a high definition multimedia interface (HDMI), a universal serial bus (USB) interface, an SD card interface, and/or an audio interface.

A connection terminal 8278 may include a connector for the electronic device 8201 to be physically connected to another electronic device (the electronic device 8202, and the like). The connection terminal 8278 may include an HDMI connector, a USB connector, an SD card connector, and/or an audio connector (a headphone connector, and the like).

The haptic module 8279 may convert electrical signals into mechanical stimuli (vibrations, movements, and the like) or electrical stimuli that are perceivable by a user through tactile or motor sensations. The haptic module 8279 may include a motor, a piezoelectric device, and/or an electrical stimulation device.

The camera module 8280 may capture a still image and a video. The camera module 8280 may include a lens assembly including one or more lenses, image sensors, image signal processors, and/or flashes. The lens assembly included in the camera module 8280 may collect light emitted from a subject for image capturing.

The power management module 8288 may manage power supplied to the electronic device 8201. The power management module 8288 may be implemented as a part of a power management integrated circuit (PMIC).

The battery 8289 may supply power to the constituent elements of the electronic device 8201. The battery 8289 may include non-rechargeable primary cells, rechargeable secondary cells, and/or fuel cells.

The communication module 8290 may establish a wired communication channel and/or a wireless communication channel between the electronic device 8201 and another electronic device (the electronic device 8202, the electronic device 8204, the server 8208, and the like), and support a communication through an established communication channel. The communication module 8290 may be operated independent of the processor 8220 (the application processor, and the like), and may include one or more communication processors supporting a wired communication and/or a wireless communication. The communication module 8290 may include a wireless communication module 8292 (a cellular communication module, a short-range wireless communication module, a global navigation satellite system (GNSS) communication module, and the like), and/or a wired communication module 8294 (a local area network (LAN) communication module, a power line communication module, and the like). Among the above communication modules, a corresponding communication module may communicate with another electronic device through the first network 8298 (a short-range communication network such as Bluetooth, WiFi Direct, or infrared data association (IrDA)) or the second network 8299 (a long-range communication network such as a cellular network, the Internet, or a computer network (LAN, WAN, and the like)). These various types of communication modules may be integrated into one constituent element (a single chip, and the like), or may be implemented as a plurality of separate constituent elements (multiple chips). The wireless communication module 8292 may verify and authenticate the electronic device 8201 in a communication network such as the first network 8298 and/or the second network 8299 by using subscriber information (an international mobile subscriber identifier (IMSI), and the like) stored in the subscriber identification module 8296.

The antenna module 8297 may transmit signals and/or power to the outside (another electronic device, and the like) or receive signals and/or power from the outside. An antenna may include an emitter formed in a conductive pattern on a substrate (a printed circuit board (PCB), and the like). The antenna module 8297 may include one or a plurality of antennas. When the antenna module 8297 includes a plurality of antennas, the communication module 8290 may select, from among the antennas, an appropriate antenna for a communication method used in a communication network such as the first network 8298 and/or the second network 8299. Signals and/or power may be transmitted or received between the communication module 8290 and another electronic device through the selected antenna. Other parts (an RFIC, and the like) than the antenna may be included as a part of the antenna module 8297.

Some of the constituent components of the electronic device 8201 may be connected to each other through a communication method between peripheral devices (a bus, a general purpose input and output (GPIO), a serial peripheral interface (SPI), a mobile industry processor interface (MIPI), and the like) and may mutually exchange signals (commands, data, and the like).

The command or data may be transmitted or received between the electronic device 8201 and the external electronic device 8204 through the server 8208 connected to the second network 8299. The electronic devices 8202 and 8204 may be of a type that is the same as or different from the electronic device 8201. All or a part of operations executed in the electronic device 8201 may be executed in one or more electronic devices (the electronic device 8202, the electronic device 8204, the server 8208, and the like). For example, when the electronic device 8201 needs to perform a function or service, the electronic device 8201 may request one or more electronic devices to perform part of the whole of the function or service, instead of performing the function or service. The one or more electronic devices receiving the request may perform additional function or service related to the request, and transmit a result of the performance to the electronic device 8201. To this end, cloud computing, distributed computing, and/or client-server computing technology may be used.

The electronic device 8201 may be applied to various devices. The electronic device 8201 may be applied to various devices. Various components of the electronic device 8201 may be properly modified according to a function of the device, and other components suitable for performing the function of the device may be further added. Hereinafter, application examples of the electronic device 8201 are described.

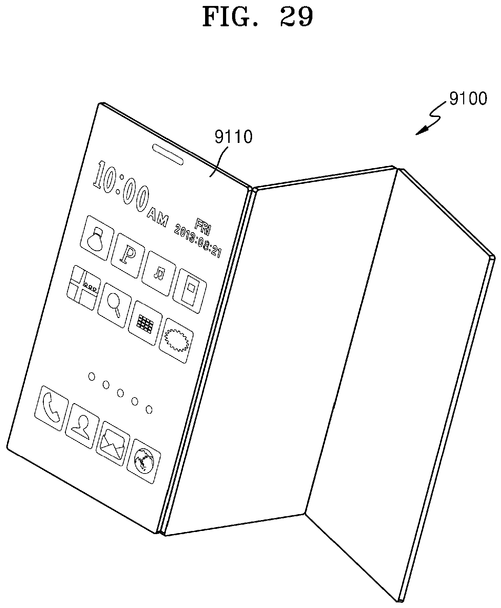

FIG. 29 is a diagram illustrating an example of a mobile device as an application example of an electronic device including a light source or a display device, according to one or more embodiments. A mobile device 9100 may include a display device 9110. The display device 9110 may include at least one of light sources having various structures illustrated in FIGS. 1 to 10 and display devices having various structures illustrated in FIGS. 11 to 23. The display device 9110 may have a foldable structure, for example, a multi-foldable structure.

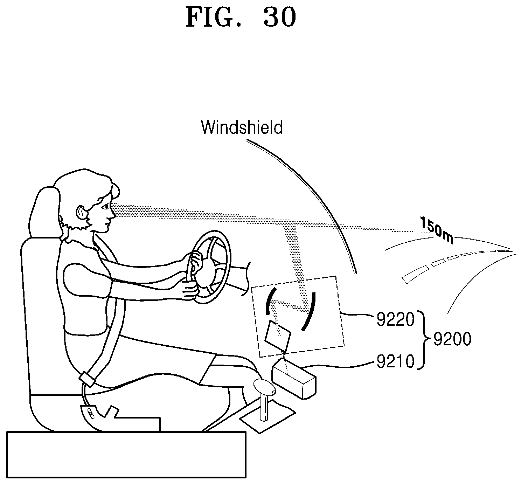

FIG. 30 is a diagram illustrating an example of a head-up display device for vehicles as an application example of an electronic device including a light source or a display device, according to one or more embodiments. The head-up display device 9200 for vehicles may include a display 9210 provided in an area of a vehicle and an optical path change member 9220 configured to change an optical path such that a driver can see an image generated at the display 9210. The display 9210 may include at least one of light sources having various structures illustrated in FIGS. 1 to 10 and display devices having various structures illustrated in FIGS. 11 to 23.

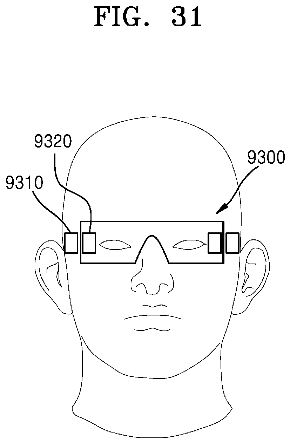

FIG. 31 is a diagram illustrating an example of augmented reality glasses or virtual reality glasses as an application example of an electronic device including a light source or a display device, according to one or more embodiments. Augmented reality glasses (or virtual reality glasses) 9300 may include a projection system 9310 configured to form an image and a guide element 9320 configured to guide the image from the projection system 9310 to user's eyes. The projection system 9310 may include at least one of light sources having various structures illustrated in FIGS. 1 to 10 and display devices having various structures illustrated in FIGS. 11 to 23.

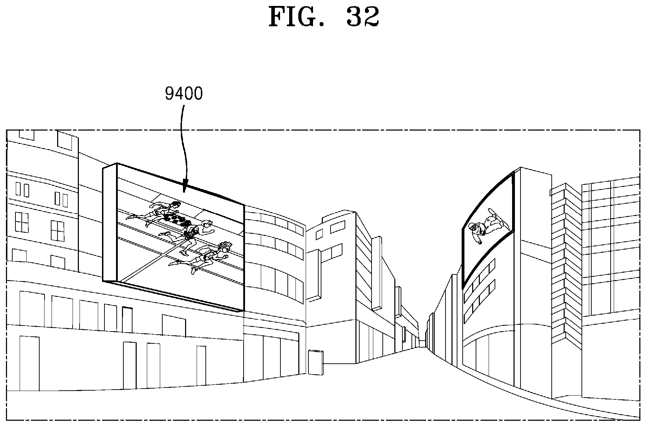

FIG. 32 is a diagram illustrating an example of a large-scale signage as an application example of an electronic device including a light source or a display device, according to one or more embodiments. A signage 9400 may include at least one of light sources having various structures illustrated in FIGS. 1 to 10 and display devices having various structures illustrated in FIGS. 11 to 23. The signage 9400 may be used in outdoor advertising using a digital information display, and may control contents, etc. of an advertisement though a network. The signage 9400 may be implemented by, for example, the electronic device described with reference to FIG. 28.

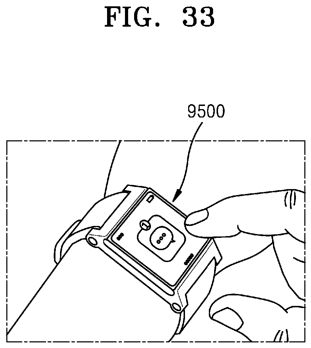

FIG. 33 is a diagram illustrating an example of a wearable display as an application example of an electronic device including a light source or a display device, according to one or more embodiments. A wearable display 9500 may include at least one of light sources having various structures illustrated in FIGS. 1 to 10 and display devices having various structures illustrated in FIGS. 11 to 23. The wearable display 9500 may be implemented through the electronic device described in relation to FIG. 28.

The light sources having various structures illustrated in FIGS. 1 to 10 and the display devices having various structures illustrated in FIGS. 11 to 23 may be applied to various products, such as a rollable television, a stretchable display, etc., in addition to the electronic devices described above.

As used herein, the terms "substantially," "about," and similar terms are used as terms of approximation and not as terms of degree, and are intended to account for the inherent variations in measured or calculated values that would be recognized by those of ordinary skill in the art. Parameters and/or ends of ranges that are quoted as being "about" a certain value (e.g. "about X") may be considered equal to that value (e.g. "equal to X"). Nevertheless, any values quoted herein may include variations of that value within commonly accepted errors, margins and/or tolerances (e.g. manufacturing tolerances). For instance, any values quoted herein may also cover variations within ±5% or ±10%.

Embodiments are set out in the following Clauses:
Clause 1. A light source comprising:
   a pixel region comprising a plurality of pixels; and
   a plurality of lenses respectively on the plurality of pixels,
   wherein each pixel of the plurality of pixels comprises:
      a first conductivity type base semiconductor layer; and
      a semiconductor light-emitting structure, the semiconductor light-emitting structure comprising a first conductivity type semiconductor layer, an active layer, and a second conductivity type semiconductor layer sequentially stacked on the first conductivity type base semiconductor layer in a first direction,
   wherein each lens of the plurality of lenses is apart from the semiconductor light-emitting structure of a corresponding one of the plurality of pixels in the first direction, with the first conductivity type base semiconductor layer of the corresponding pixel therebetween,
   wherein the plurality of pixels comprises a first pixel and a second pixel, and the plurality of lenses comprises a first lens facing the first pixel and a second lens facing the second pixel,
   wherein the first conductivity type base semiconductor layer of the first pixel comprises a first optical path guide surface facing the first lens,
   wherein the first conductivity type base semiconductor layer of the second pixel comprises a second optical path guide surface facing the second lens, and
   wherein the first optical path guide surface and the second optical path guide surface comprise non-flat surfaces having different shapes.
Clause 2. The light source of Clause 1, wherein the first optical path guide surface and the second optical path guide surface comprise different portions, which are selected from: a convex portion that is convex toward one of the plurality of lenses; and a concave portion that is concave toward one of the plurality of lenses.
Clause 3. The light source of Clause 1, wherein the first optical path guide surface comprises a first convex portion that is convex toward the first lens,
   wherein the second optical path guide surface comprises a second convex portion that is convex toward the second lens, and
   wherein a first maximum length of the first convex portion in the first direction is different from a second maximum length of the second convex portion in the first direction.
Clause 4. The light source of Clause 1, wherein the first optical path guide surface comprises a first concave portion that is concave toward the first lens,
   wherein the second optical path guide surface comprises a second concave portion that is concave toward the second lens, and
   wherein a first maximum length of the first concave portion in the first direction is different from a second maximum length of the second concave portion in the first direction.
Clause 5. The light source of Clause 1, wherein the plurality of pixels further comprises a third pixel,
   wherein the plurality of lenses further comprises a third lens facing the third pixel,
   wherein the first conductivity type base semiconductor layer of the third pixel comprises a third optical path guide surface facing the third lens, and
   wherein the third optical path guide surface comprises a flat surface.
Clause 6. The light source of Clause 1, wherein the first pixel is in a center portion of the pixel region, and
   wherein the second pixel is in an edge portion of the pixel region.
Clause 7. The light source of Clause 1, wherein each of the first pixel and the second pixel is in an edge portion of the pixel region, and the first pixel and the second pixel are apart in a second direction, wherein the second direction is perpendicular to the first direction.
Clause 8. The light source of Clause 1, wherein the plurality of pixels are configured to emit light having a same color.
Clause 9. The light source of Clause 1, wherein the first pixel and the second pixel are configured to emit light having different colors.
Clause 10. The light source of Clause 1, further comprising:
   a first transparent layer between the first lens and the first optical path guide surface; and
   a second transparent layer between the second lens and the second optical path guide surface.
Clause 11. The light source of Clause 1, wherein the first optical path guide surface comprises a first convex portion that is convex toward the first lens,
   wherein the second optical path guide surface comprises a second convex portion that is convex toward the second lens, a concave portion that is concave toward the second lens, or a flat surface facing the second lens,
   wherein the first pixel is configured to emit blue light, and
   wherein the second pixel is configured to emit red light, green light, or blue light.
Clause 12. The light source of Clause 1, wherein the first lens comprises a first lens surface facing the first optical path guide surface,
   wherein the second lens comprises a second lens surface facing the second optical path guide surface,
   wherein the first lens surface comprises a first non-flat surface corresponding to a shape of the first optical path guide surface, and
   wherein the second lens surface comprises a second non-flat surface corresponding to a shape of the second optical path guide surface, the second non-flat surface having a different shape from a shape of the first non-flat surface.
Clause 13. The light source of Clause 1, wherein the first optical path guide surface comprises a first convex portion that is convex toward the first lens, the first convex portion having a first maximum length in the first direction,
   wherein the second optical path guide surface comprises a second convex portion that is convex toward the second lens, the second convex portion having a second maximum length in the first direction, wherein the second maximum length is different from the first maximum length,
   wherein the first lens comprises a first lens surface that faces the first convex portion and is concave toward the first convex portion, and
   wherein the second lens comprises a second lens surface that faces the second convex portion and is concave toward the second convex portion.
Clause 14. The light source of Clause 1, wherein the first optical path guide surface comprises a first concave portion that is concave toward the first lens, the first concave portion having a first maximum length in the first direction,
   wherein the second optical path guide surface comprises a second concave portion that is concave toward the second lens, the second concave portion having a second maximum length in the first direction, wherein the second maximum length is different from the first maximum length,
   wherein the first lens comprises a first lens surface facing the first concave portion, the first lens surface being convex toward the first concave portion, and
   wherein the second lens comprises a second lens surface facing the second concave portion, the second lens surface being convex toward the second concave portion.
Clause 15. The light source of Clause 1, wherein the first optical path guide surface comprises a convex portion that is convex toward the first lens,
   wherein the second optical path guide surface comprises a concave portion that is concave toward the second lens or comprises a flat surface facing the second lens, and
   wherein a surface of the first lens, which faces the first optical path guide surface, and a surface of the second lens, which faces the second optical path guide surface, each have a flat shape.

While certain embodiments of the disclosure have been particularly shown and described, it will be understood that various changes in form and details may be made therein without departing from the scope of the following claims.

## Claims

1. A light source comprising:
a pixel region (PXR) comprising a plurality of pixels (PX); and
a plurality of lenses (190) respectively on the plurality of pixels (PX),
wherein each pixel (PX) of the plurality of pixels (PX) comprises:
a first conductivity type base semiconductor layer (102); and
a semiconductor light-emitting structure (110), the semiconductor light-emitting structure (110) comprising a first conductivity type semiconductor layer (112), an active layer (114), and a second conductivity type semiconductor layer (116) sequentially stacked on the first conductivity type base semiconductor layer (102) in a first direction,
wherein each lens (190) of the plurality of lenses (190) is apart from the semiconductor light-emitting structure (110) of a corresponding one of the plurality of pixels (PX) in the first direction, with the first conductivity type base semiconductor layer (102) of the corresponding pixel (PX) therebetween,
wherein the plurality of pixels (PX) comprises a first pixel and a second pixel, and the plurality of lenses (190) comprises a first lens facing the first pixel and a second lens facing the second pixel,
wherein the first conductivity type base semiconductor layer (102) of the first pixel comprises a first optical path guide surface facing the first lens,
wherein the first conductivity type base semiconductor layer (102) of the second pixel comprises a second optical path guide surface facing the second lens, and
wherein the first optical path guide surface and the second optical path guide surface comprise non-flat surfaces having different shapes.

2. The light source of claim 1, wherein the first optical path guide surface and the second optical path guide surface comprise different portions, which are selected from: a convex portion that is convex toward one of the plurality of lenses (190); and a concave portion that is concave toward one of the plurality of lenses.

3. The light source of claim 1 or claim 2, wherein the first optical path guide surface (CV1A) comprises a first convex portion that is convex toward the first lens,
wherein the second optical path guide surface (CV1B) comprises a second convex portion that is convex toward the second lens, and
wherein a first maximum length of the first convex portion in the first direction is different from a second maximum length of the second convex portion in the first direction.

4. The light source of claim 3, wherein the first lens comprises a first lens surface that faces the first convex portion and is concave toward the first convex portion, and
wherein the second lens comprises a second lens surface that faces the second convex portion and is concave toward the second convex portion.

5. The light source of claim 1 or claim 2, wherein the first optical path guide surface comprises (CC1A) a first concave portion that is concave toward the first lens,
wherein the second optical path guide surface comprises (CC1B) a second concave portion that is concave toward the second lens, and
wherein a first maximum length of the first concave portion in the first direction is different from a second maximum length of the second concave portion in the first direction.

6. The light source of claim 5, wherein the first lens comprises a first lens surface facing the first concave portion, the first lens surface being convex toward the first concave portion, and
wherein the second lens comprises a second lens surface facing the second concave portion, the second lens surface being convex toward the second concave portion.

7. The light source of claim 1, wherein the first optical path guide surface (CV) comprises a convex portion that is convex toward the first lens,
wherein the second optical path guide surface (CC, FTS) comprises a concave portion that is concave toward the second lens or comprises a flat surface facing the second lens, and
wherein a surface of the first lens, which faces the first optical path guide surface, and a surface of the second lens, which faces the second optical path guide surface, each have a flat shape.

8. The light source of claim 1, wherein the first optical path guide surface (CV, CV1A) comprises a first convex portion that is convex toward the first lens,
wherein the second optical path guide surface (CV1A, CC, FTS) comprises a second convex portion that is convex toward the second lens, a concave portion that is concave toward the second lens, or a flat surface facing the second lens,
wherein the first pixel is configured to emit blue light, and
wherein the second pixel is configured to emit red light, green light, or blue light.

9. The light source of any preceding claim, wherein the plurality of pixels are configured to emit light having a same color.

10. The light source of any of claims 1-8, wherein the first pixel and the second pixel are configured to emit light having different colors.

11. The light source of any preceding claim, wherein the plurality of pixels further comprises a third pixel (PXM1),
wherein the plurality of lenses (190) further comprises a third lens facing the third pixel (PXM1),
wherein the first conductivity type base semiconductor layer (102) of the third pixel (PXM1) comprises a third optical path guide surface (FTS) facing the third lens, and
wherein the third optical path guide surface (FTS) comprises a flat surface.

12. The light source of any preceding claim, wherein the first pixel is in a center portion of the pixel region (PXR), and
wherein the second pixel is in an edge portion of the pixel region (PXR).

13. The light source of any of claims 1-11, wherein each of the first pixel and the second pixel is in an edge portion of the pixel region (PXR), and the first pixel and the second pixel are apart in a second direction, wherein the second direction is perpendicular to the first direction.

14. The light source of any preceding claim, further comprising:
a first transparent layer between the first lens and the first optical path guide surface; and
a second transparent layer between the second lens and the second optical path guide surface.

15. The light source of any preceding claim, wherein the first lens comprises a first lens surface facing the first optical path guide surface,
wherein the second lens comprises a second lens surface facing the second optical path guide surface,
wherein the first lens surface comprises a first non-flat surface corresponding to a shape of the first optical path guide surface, and
wherein the second lens surface comprises a second non-flat surface corresponding to a shape of the second optical path guide surface, the second non-flat surface having a different shape from a shape of the first non-flat surface.
